# EUROPEAN PATENT SPECIFICATION

(11) **EP 3 133 078 B1**
(45) Date of publication and mention of the grant of the patent: **30.01.2019**
(21) Application number: 16184075.6
(22) Date of filing: 12.08.2016
(51) Int. Cl.: C07F 15/00, C09K 11/06, H01L 51/00, H05B 33/10

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 18.08.2015 KR 20150116207; 10.08.2016 KR 20160101888
(43) Date of publication of application: 22.02.2017
(73) Proprietor: Samsung Electronics Co., Ltd., Suwon-si, Gyeonggi-do 16677 (KR)
(72) Inventor: CHOI, Jongwon, 16678 Gyeonggi-do (KR); KWAK, Yoonhyun, 16678 Gyeonggi-do (KR); LEE, Kum Hee, 16678 Gyeonggi-do (KR); LEE, Banglin, 16678 Gyeonggi-do (KR); LEE, Jungin, 16678 Gyeonggi-do (KR); KOO, Hyun, 16678 Gyeonggi-do (KR); KIM, Sangdong, 16678 Gyeonggi-do (KR)
(74) Representative: Elkington & Fife LLP

(56) References cited:
- EP-A1- 2 551 274
- EP-A2- 1 683 804
- WO-A1-2014/031977
- WO-A2-2014/109814
- US-A1- 2013 341 600
- M. YANG ET AL: "New oligo-aplha-pyridylamino ligands and their metal complexes", CHEMICAL COMMUNICATIONS, 1997, pages 2279-2280, XP002764073, SEINSTITUTE OF INORGANIC AND PHYSICAL CHEMISTRY, STOCKHOLM, ISSN: 0366-5607

## Description

### FIELD OF THE INVENTION

Embodiments relate to an organometallic compound and an organic light-emitting device including the same.

### BACKGROUND OF THE INVENTION

Organic light-emitting devices (OLEDs) are self-emission devices that have wide viewing angles, high contrast ratios, and short response times. In addition, the OLEDs display excellent brightness, driving voltage, and response speed characteristics, and produce full-color images.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light.

Various types of organic light emitting devices are known. However, there still remains a need in OLEDs having low driving voltage, high efficiency, high brightness, and long lifespan.

US 2013/034160 0 proposes a range of compounds for use in organic light emitting devices.

EP 1 683 804 teaches a platinum complex also for a light emitting device.

### SUMMARY OF THE INVENTION

Provided are an organometallic compound and an organic light-emitting device including the same.

Additional aspects will be set forth in part in the description which follows and, in part, will be apparent from the description, or may be learned by practice of the presented embodiments.

According to an aspect, an organometallic compound is provided according to claim 1.

In embodiments, the organometallic compound is represented by one of Formulae 1-1 to 1-3: 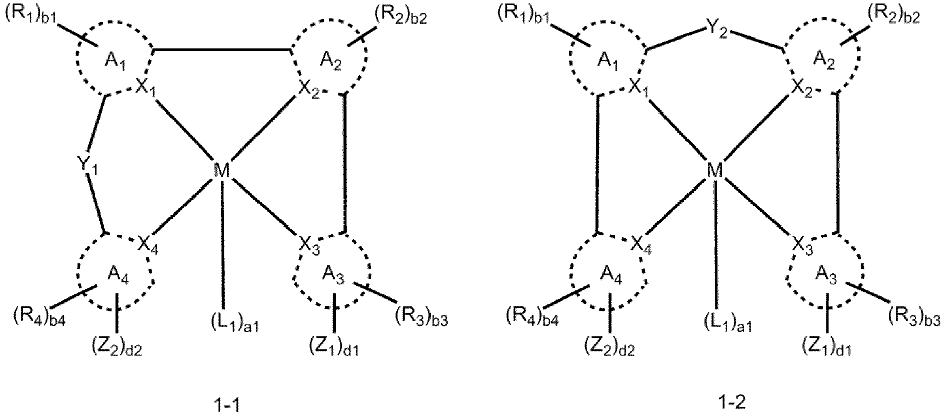 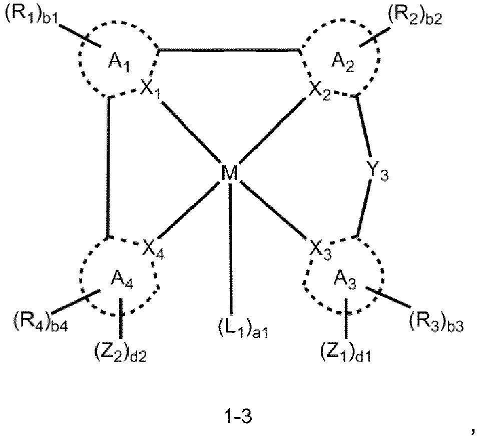 wherein, in Formulae 1-1 to 1-3,
Y₁ to Y₃ are each independently a divalent linking group.
wherein,
M is selected from a Period 1 transition metal, a Period 2 transition metal, and a Period 3 transition metal, preferably selected from iridium (Ir), platinum (Pt), osmium (Os), ruthenium (Ru), rhodium (Rh), palladium (Pd), copper (Cu), silver (Ag), gold (Au), titanium (Ti), zirconium (Zr), hafnium (Hf), europium (Eu), terbium (Tb), and thulium (Tm) and more preferably selected from Ir, Pt, and Os;
A₁ to A₄ are each independently selected from a benzene group, a naphthalene group, a pyridine group, a pyrimidine group, a pyrazine group, a quinoline group, an isoquinoline group, a dibenzofuran group, and a dibenzothiophene group; and
at least one selected from A₃ and A₄ is selected from a pyridine group, a pyrimidine group, a pyrazine group, a quinoline group, and an isoquinoline group.
X₁ to X₄ are each independently selected from a carbon atom (C) and a nitrogen atom (N), provided that at least one selected from X₃ and X₄ is N;
Z₁ and Z₂ are each independently represented by one of Formulae 2-21 to 2-34: 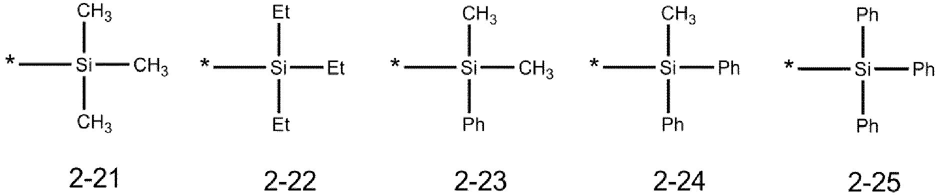 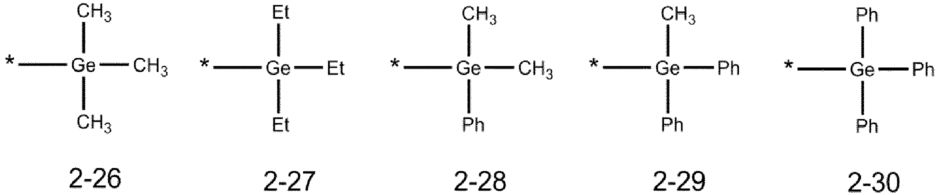 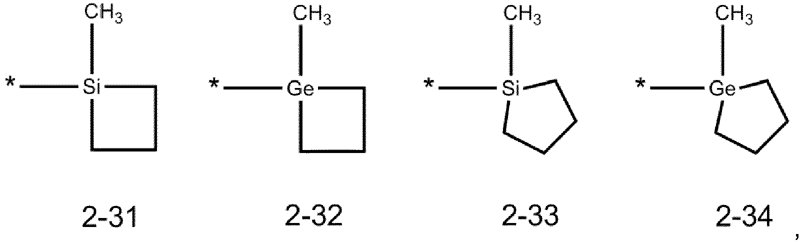
wherein, in Formulae 2-21 to 2-34,
Et refers to an ethyl group;
Ph refers to a phenyl group; and
* indicates a binding site to a neighboring atom.
d1 and d2 are each independently selected from 0, 1, 2, 3, and 4;
when d1 is 2 or more, groups Z₁ are identical to or different from each other; when d2 is 2 or more, groups Z₂ are identical to or different from each other;
when X₃ is N, d1 is selected from 1, 2, 3, and 4; or when X₄ is N, d2 is selected from 1, 2, 3, and 4;
R₁ to R₄ are each independently selected 7. The organometallic compound of any of claims 1 to 6, wherein
R₁ to R₄ are each independently selected from hydrogen, deuterium, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, and a tert-pentyl group;
a phenyl group and a carbazolyl group; and
a phenyl group, a naphthyl group, and a carbazolyl group, each substituted with at least one selected from a C₁-C₂₀ alkyl group and a phenyl group.
b1 to b4 are each independently selected from 1, 2, 3, and 4;
L₁ is selected from a monodentate ligand and a bidentate ligand;
a1 is selected from 0, 1, and 2; and
* indicates a binding site to a neighboring atom.

Another aspect provides an organic light-emitting device including:
a first electrode;
a second electrode; and
an organic layer disposed between the first electrode and the second electrode,
wherein the organic layer includes an emission layer and at least one organometallic compound represented by one of Formulae 1-1 to 1-3.

### BRIEF DESCRIPTION OF THE DRAWING

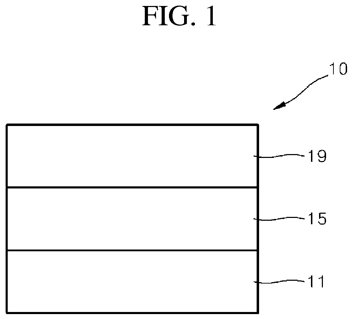

These and/or other aspects will become apparent and more readily appreciated from the following description of the embodiments, taken in conjunction with FIG. 1 which is a schematic cross-sectional view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The present disclosure will now be described more fully with reference to exemplary embodiments. The disclosure may, however, be embodied in many different forms and should not be construed as being limited to the embodiments set forth herein; rather, these embodiments are provided so that this disclosure will be thorough and complete, and will fully convey the concept of the disclosure to those skilled in the art. Advantages, features, and how to achieve them of the present inventive concept will become apparent by reference to the embodiment that will be described later in detail, together with the accompanying drawings. This inventive concept may, however, be embodied in many different forms and should not be limited to the exemplary embodiments.

Hereinafter, embodiments are described in detail by referring to the attached drawings, and in the drawings, like reference numerals denote like elements, and a redundant explanation thereof will not be provided herein.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

As used herein, the singular forms "a," "an" and "the" are intended to include the plural forms as well, unless the context clearly indicates otherwise.

The term "or" means "and/or." It will be further understood that the terms "comprises" and/or "comprising" or "includes" and/or "including" used herein specify the presence of stated features, regions, integers, steps, operations, elements, and/or components, but do not preclude the presence or addition of one or more other features, regions, integers, steps, operations, elements, and/or components.

It will be understood that when a layer, region, or component is referred to as being "on" or "onto" another layer, region, or component, it may be directly or indirectly formed on the other layer, region, or component. That is, for example, intervening layers, regions, or components may be present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Sizes of components in the drawings may be exaggerated for convenience of explanation. In other words, since sizes and thicknesses of components in the drawings are arbitrarily illustrated for convenience of explanation, the following embodiments are not limited thereto.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

The term "organic layer" as used herein refers to a single layer and/or a plurality of layers between the first electrode and the second electrode of the organic light-emitting device. A material included in the "organic layer" is not limited to an organic material.

An organometallic compound according to an embodiment is represented by one of Formulae 1-1 to 1-3:

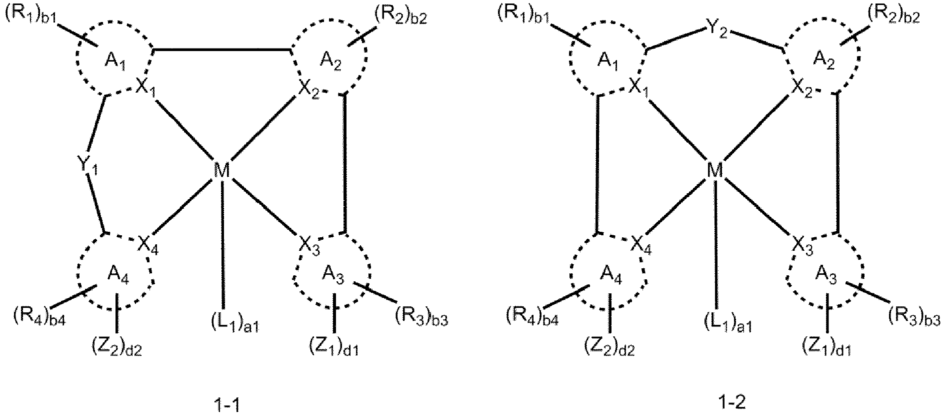

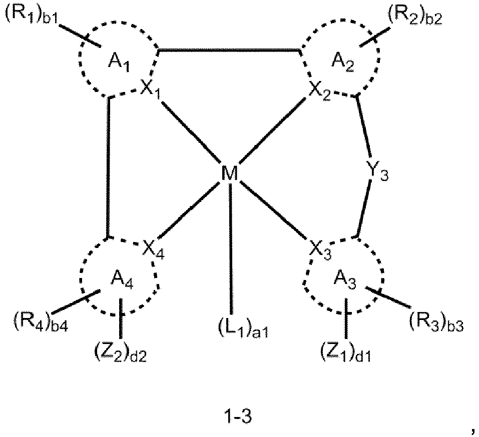

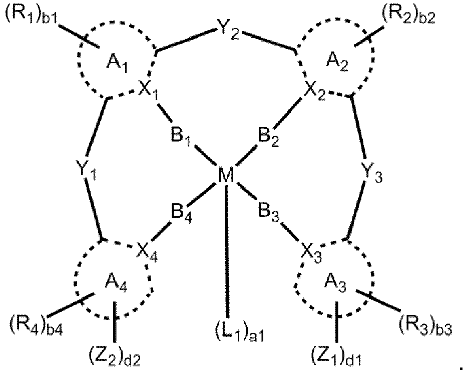

In Formulae 1-1 to 1-3, M is selected from a Period 1 transition metal, a Period 2 transition metal, and a Period 3 transition metal.

For example, M in Formulae 1-1 to 1-3 may be selected from iridium (Ir), platinum (Pt), osmium (Os), ruthenium (Ru), rhodium (Rh), palladium (Pd), copper (Cu), silver (Ag), gold (Au), titanium (Ti), zirconium (Zr), hafnium (Hf), europium (Eu), terbium (Tb), and thulium (Tm), but is not limited thereto.

In an embodiment, M in Formulae 1-1 to 1-3 may be selected from Ir, Pt, Os, Ti, Zr, Hf, Eu, Tb, and Tm, but is not limited thereto.

In an embodiment, M in Formulae 1-1 to 1-3 may be selected from Ir, Pt, and Os, but is not limited thereto.

In an embodiment, M in Formulae 1-1 to 1-3 may be Pt, but is not limited thereto.

A₁ to A₄ in Formulae 1-1 to 1-3 are each independently be selected from a benzene group, a naphthalene group, a pyridine group, a pyrimidine group, a pyrazine group, a quinoline group, an isoquinoline group, a dibenzofuran group, and a dibenzothiophene group; and
at least one selected from A₃ and A₄ may be selected from a pyridine group, a pyrimidine group, a pyrazine group, a quinoline group, and an isoquinoline group.

In an embodiment, A₁ to A₄ in Formulae 1-1 to 1-3 may each independently be selected from a benzene group, a naphthalene group, a pyridine group, a pyrimidine group, a quinoline group, an isoquinoline group, and a dibenzofuran group; and
at least one selected from A₃ and A₄ may be selected from a pyridine group, a pyrimidine group, a quinoline group, and an isoquinoline group, but they are not limited thereto.

X₁ to X₄ in Formulae 1-1 to 1-3 are each independently be selected from a carbon atom (C) and a nitrogen atom (N), provided that at least one selected from X₃ and X₄ is N.

For example, X₁ and X₂ in Formulae 1-1 to 1-3 may be C;

X₃ and X₄ may each independently be selected from C and N, and at least one selected from X₃ and X₄ may be N, but they are not limited thereto.

In an embodiment, X₁ and X₂ in Formulae 1-1 to 1-3 may be C; and
X₃ and X₄ may be N, but they are not limited thereto.
Y₁ to Y₃ in Formulae 1-1 to 1-3 are each independently a divalent linking group.

The divalent linking group may be selected from *-O-*', *-S-*', *-{B(R₈₁)}-*', *-{N(R₈₁)}-*', *-{C(R₈₁)(R₈₂)}ₙ₈₁-*', *-{Si(R₈₁)(R₈₂)}ₙ₈₁-*', a substituted or unsubstituted C₂-C₂₀ alkenylene group, a substituted or unsubstituted C₂-C₂₀ alkynylene group, a substituted or unsubstituted C₆-C₂₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group;

R₈₁ and R₈₂ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group; and
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and -Si(Q₁)(Q₂)(Q₃); and R₈₁ and R₈₂ may optionally be linked to form a saturated or unsaturated ring;
Q₁ to Q₃ may each independently be selected from hydrogen, deuterium, a C₁-C₂₀ alkyl group, and a phenyl group;
n81 may be selected from 1, 2, 3, 4, and 5; and
* and *' each independently indicate a binding site to a neighboring atom, but they are not limited thereto.

The divalent linking group may be selected from *-O-*', *-S-*', *-{B(R₈₁)}-*', *-{N(R₈₁)}-*', *-{C(R₈₁)(R₈₂)}ₙ₈₁-*', *-{Si(R₈₁)(R₈₂)}ₙ₈₁-*', a substituted or unsubstituted ethenylene group, a substituted or unsubstituted propenylene group, a substituted or unsubstituted butenylene group, a substituted or unsubstituted pentenylene group, a substituted or unsubstituted phenylene group, a substituted or unsubstituted naphthylene group, a substituted or unsubstituted fluorenylene group, a substituted or unsubstituted pyridinylene group, a substituted or unsubstituted pyrazinylene group, a substituted or unsubstituted pyrimidinylene group, a substituted or unsubstituted quinolinylene group, a substituted or unsubstituted isoquinolinylene group, a substituted or unsubstituted naphthyridinylene group, a substituted or unsubstituted quinoxalinylene group, a substituted or unsubstituted quinazolinylene group, a substituted or unsubstituted dibenzofuranylene group, and a substituted or unsubstituted dibenzothiophenylene group;
R₈₁ and R₈₂ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group; and
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, each substituted with at least one selected from deuterium, -F, -CI, -Br, -I, -CD₃, -CD₂H, -CDH₂, -CF₃, -CF₂H, -CFH₂, -Si(CH₃)₃, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group; and R₈₁ and R₈₂ may optionally be linked to form a saturated or unsaturated ring;
n81 may be selected from 1, 2, 3, 4, and 5; and
* and *' each independently indicate a binding site to a neighboring atom, but they are not limited thereto.

The divalent linking group may be represented by one selected from *-O-*', *-S-*', and one of Formulae 8-1 to 8-18, but they are not limited thereto:

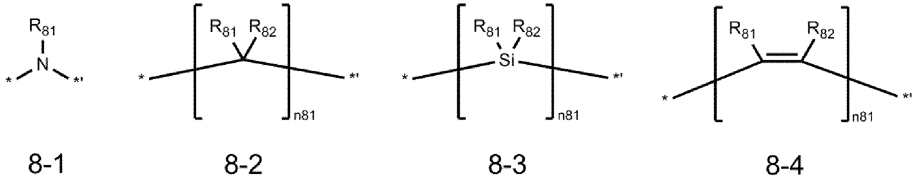

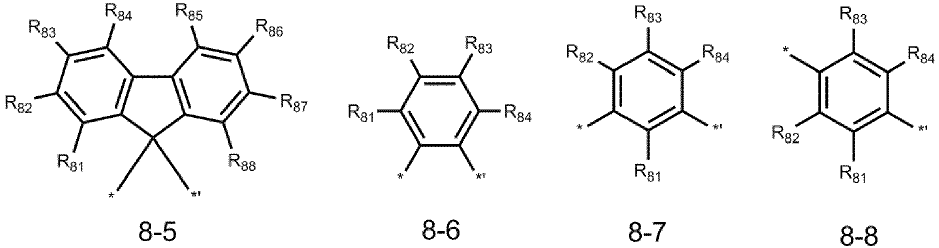

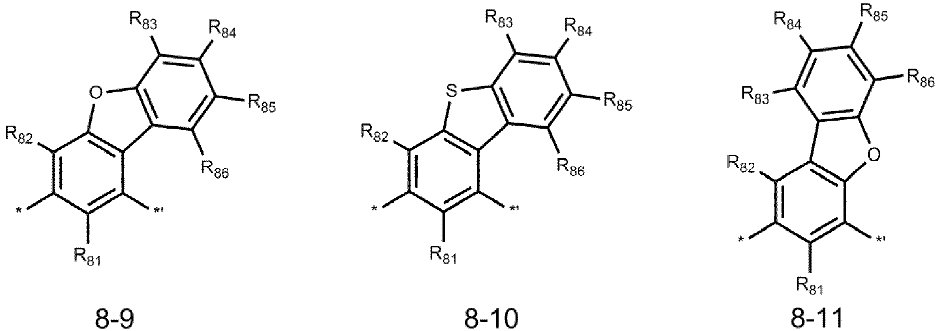

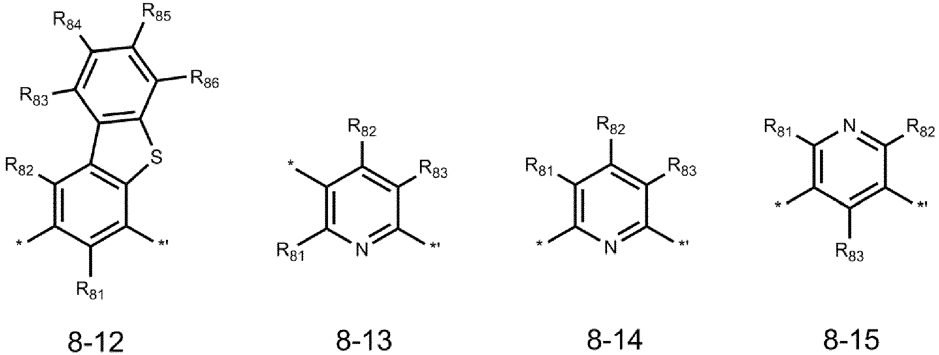

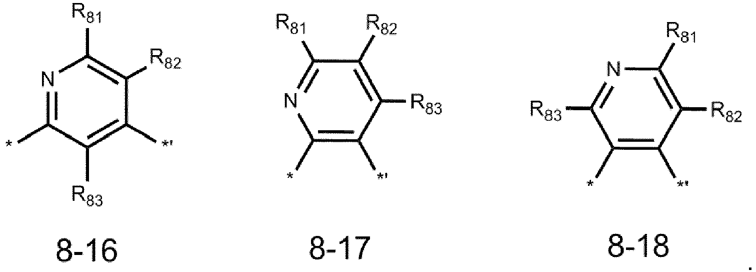

In Formulae 8-1 to 8-18,
R₈₁ to R₈₈ may each independently be selected from hydrogen, deuterium, -F, -CI, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group; and
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, each substituted with at least one selected from deuterium, -F, -CI, -Br, -I, -CD₃, -CD₂H, -CDH₂, -CF₃, -CF₂H, -CFH₂, -Si(CH₃)₃, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group;
n81 may be selected from 1, 2, 3, 4, and 5; and
* and *' each independently indicate a binding site to a neighboring atom.

In an embodiment, R₈₁ to R₈₈ in Formulae 8-1 to 8-18 may each independently be selected from hydrogen, deuterium, -F, -CI, -Br, -I, a cyano group, a methyl group, an ethyl group, an n-propyl group, an iso-propyl group, an n-butyl group, an iso-butyl group, a sec-butyl group, a tert-butyl group, a methoxy group, an ethoxy group, an n-propoxy group, an iso-propoxy group, an n-butoxy group, and a tert-butoxy group;
a C₁-C₂₀ alkyl group and a C₁-C₂₀ alkoxy group, each substituted with at least one selected from deuterium, -F, -CI, -Br, -I, a cyano group, a phenyl group, and a naphthyl group;
a phenyl group, a naphthyl group, a pyridinyl group, and a dibenzofuranyl group; and
a phenyl group, a naphthyl group, a pyridinyl group and a dibenzofuranyl group, each substituted with at least one selected from deuterium, -F, -CI, -Br, -I, -CD₃, -CD₂H, - CDH₂, -CF₃, -CF₂H, -CFH₂, -Si(CH₃)₃, a cyano group, a methyl group, an ethyl group, an n-propyl group, an iso-propyl group, an n-butyl group, an iso-butyl group, a sec-butyl group, a tert-butyl group, a methoxy group, an ethoxy group, an n-propoxy group, an iso-propoxy group, n-butoxy group, tert-butoxy group, a phenyl group, a naphthyl group, and a pyridinyl group; and
n81 may be selected from 1 and 2, but they are not limited thereto.

The divalent linking group may be represented by one selected from *-O-*', *-S-*', and one of Formulae 9-1 to 9-70, but they are not limited thereto: 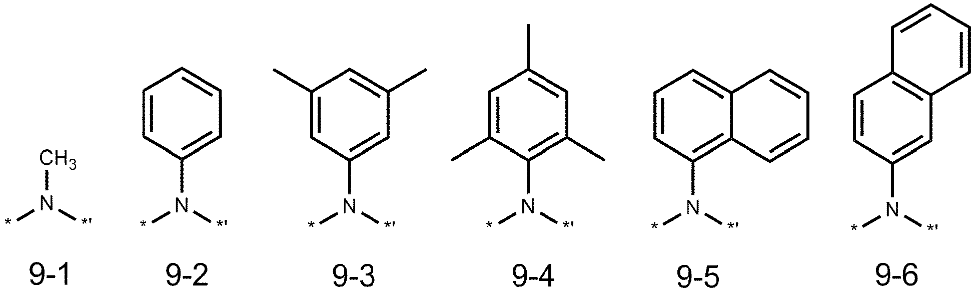 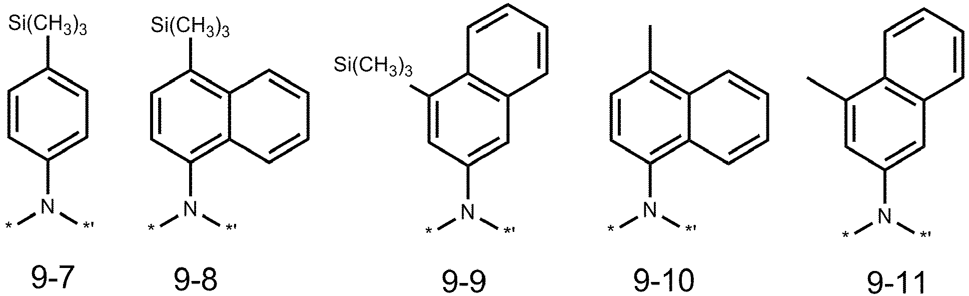 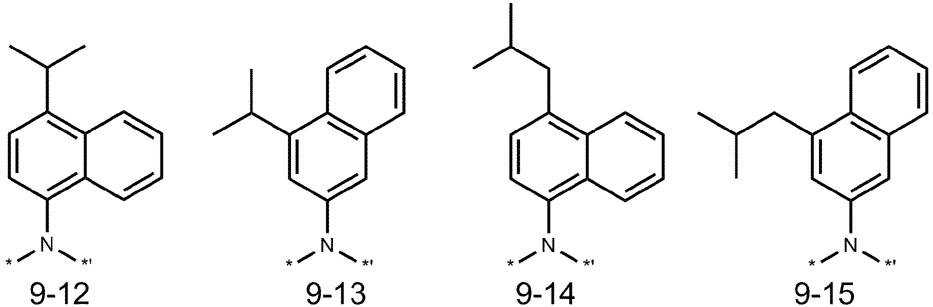 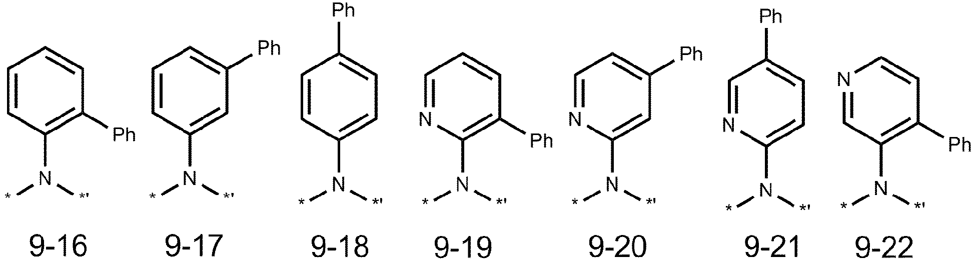 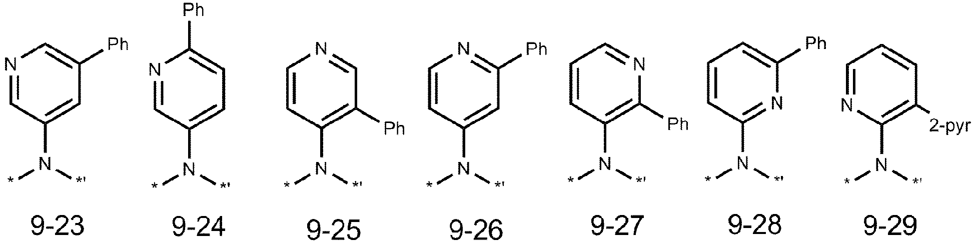 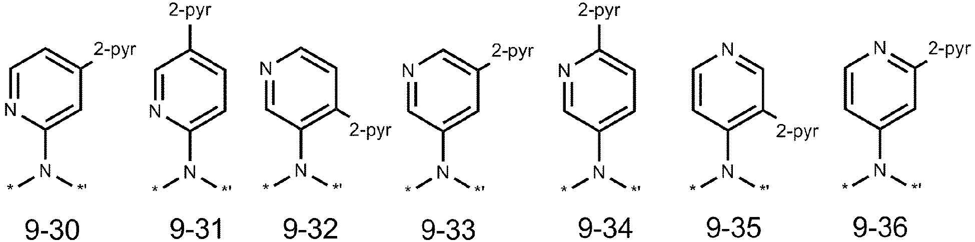 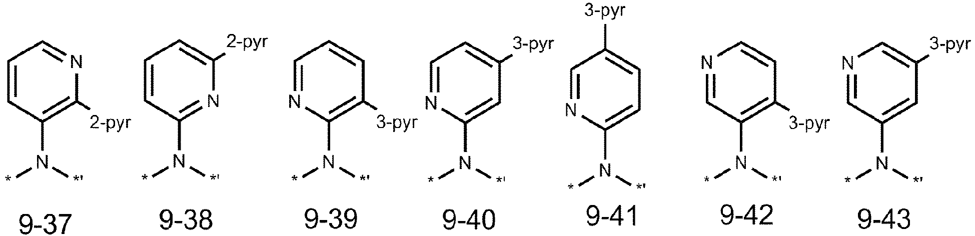 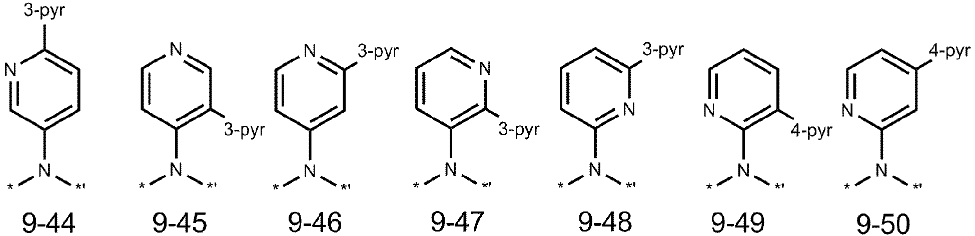 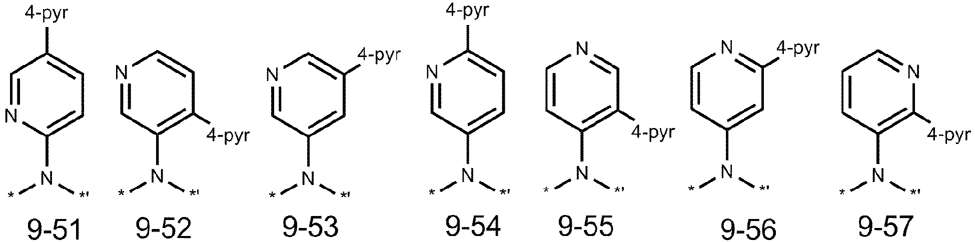 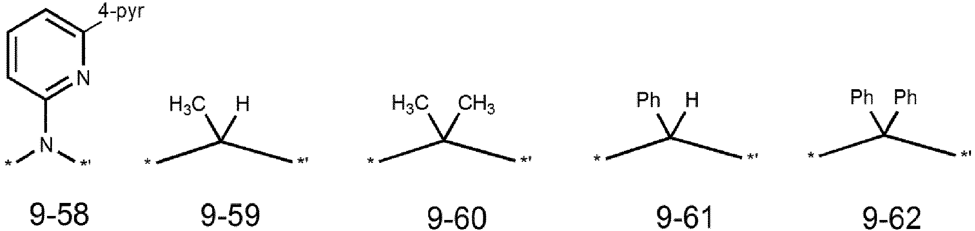 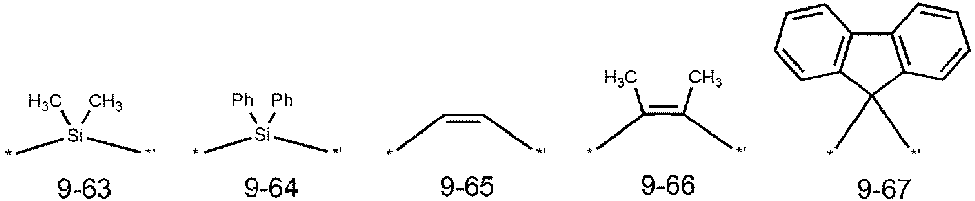 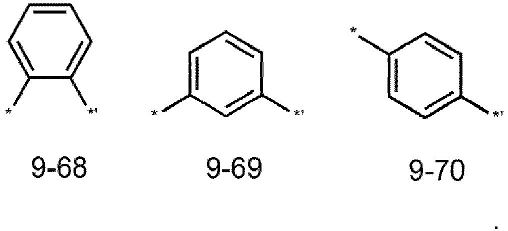 In Formulae 9-1 to 9-70,
Ph refers to a phenyl group;
2-pyr refers to a 2-pyridinyl group, 3-pyr refers to a 3-pyridinyl group, 4-pyr refers to a 4-pyridinyl group; and
* and *' each independently indicates a binding site to a neighboring atom.
Z₁ and Z₂ in Formulae 1-1 to 1-3 are each independently be represented by one of Formulae 2-21 to 2-34: 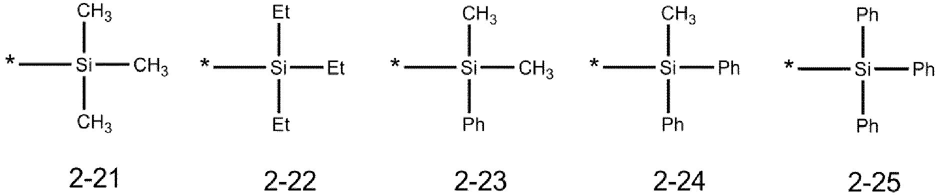 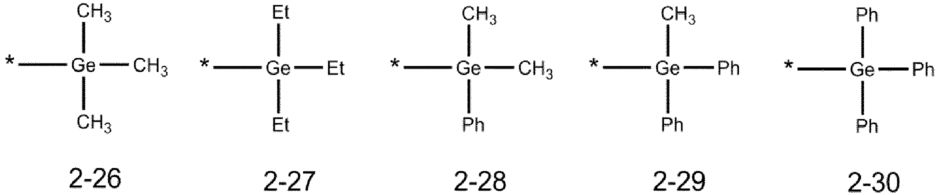 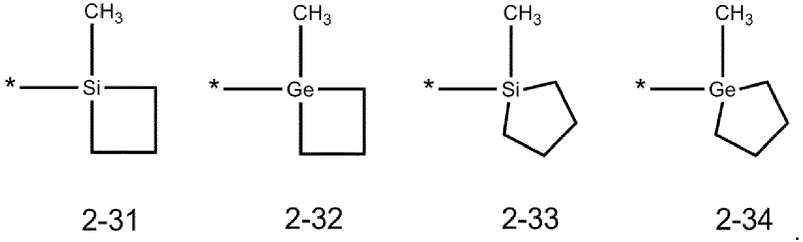
In Formulae 2-21 to 2-34,
Et refers to an ethyl group;
Ph refers to a phenyl group; and
* indicates a binding site to a neighboring atom.

In an embodiment, Z₁ and Z₂ in Formulae 1-1 to 1-3 may each independently be represented by one of Formulae 2-26 to 2-34, but they are not limited thereto: 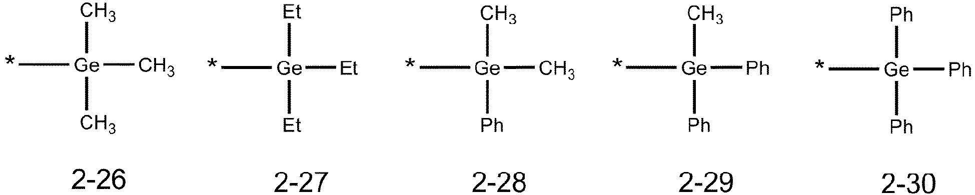 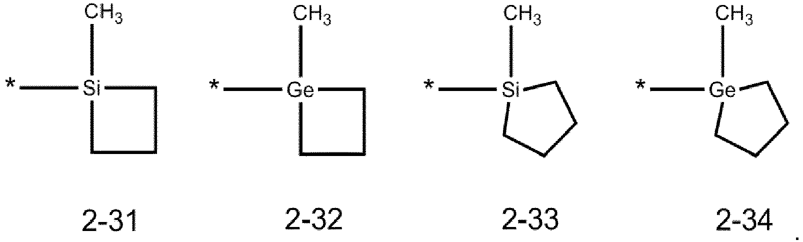 In Formulae 2-26 to 2-34,
Et refers to an ethyl group;
Ph refers to a phenyl group; and
* indicates a binding site to a neighboring atom.

d1 in Formulae 1-1 to 1-3 indicates the number of groups Z₁, and is selected from 0, 1, 2, 3, and 4. When d1 is 2 or more, groups Z₁ may be identical to or different from each other.

d2 in Formulae 1-1 to 1-3 indicates the number of groups Z₂, and is selected from 0, 1, 2, 3, and 4. When d2 is 2 or more, groups Z₂ may be identical to or different from each other.

Regarding Formulae 1-1 to 1-3, when X₃ is N, d1 may be selected from 1, 2, 3, and 4; or when X₄ is N, d2 may be selected from 1, 2, 3, and 4.

For example, d1 and d2 in Formulae 1-1 to 1-3 may each independently be selected from 0, 1, and 2; and
at least one selected from d1 and d2 may be selected from 1 and 2, but they are not limited thereto.

In an embodiment, d1 and d2 in Formulae 1-1 to 1-3 may be 1, but they are not limited thereto.

R₁ to R₄ in Formulae 1-1 to 1-3 are each independently be selected from hydrogen, deuterium, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, and a tert-pentyl group; and
a phenyl group and a carbazolyl group; and
a phenyl group, a naphthyl group, and a carbazolyl group, each substituted with at least one selected from a C₁-C₂₀ alkyl group and a phenyl group.

b1 in Formulae 1-1 to 1-3 indicates the number of groups R₁, and b1 is selected from 1, 2, 3, and 4. When b1 is 2 or more, groups R₁ may be identical to or different from each other.

b2 in Formulae 1-1 to 1-3 indicates the number of groups R₂, and b2 is selected from 1, 2, 3, and 4. When b2 is 2 or more, groups R₂ may be identical to or different from each other.

b3 in Formulae 1-1 to 1-3 indicates the number of groups R₃, and b3 is selected from 1, 2, 3, and 4. When b3 is 2 or more, groups R₃ may be identical to or different from each other.

b4 in Formulae 1-1 to 1-3 indicates the number of R₁, and b4 is selected from 1, 2, 3, and 4. When b4 is 2 or more, groups R₁ may be identical to or different from each other.

L₁ in Formulae 1-1 to 1-3 is selected from a monodentate ligand and a bidentate ligand.

Examples of the monodentate ligand include an iodide ion, a bromide ion, a chloride ion, a sulfide, a thiocyanate ion, a nitrate ion, an azide ion, a hydroxide ion, a cyanide ion, an isocyanide ion, water, an acetonitrile, a pyridine, an ammonia, a carbon monooxide, PPh₃, PPh₂CH₃, PPh(CH₃)₂, and P(CH₃)₃, but they are not limited thereto.

Examples of the bidentate ligand include an oxalate ion, acetylacetonate, a picolinic acid, 2-(2-hydroxyphenyl)-pyridine, 2-phenylpyridine, 1,2-bis(diphenylphosphino)ethane (dppe), 1,1-bis(diphenylphosphino)methane (dppm), glycinate, ethylenediamine, 2,2'-bipyridine, and 1,10-phenanthroline, but they are not limited thereto.

For example, L₁ in Formulae 1-1 to 1-3 may be represented by one of Formulae 3-1 to 3-6, but they are not limited thereto: 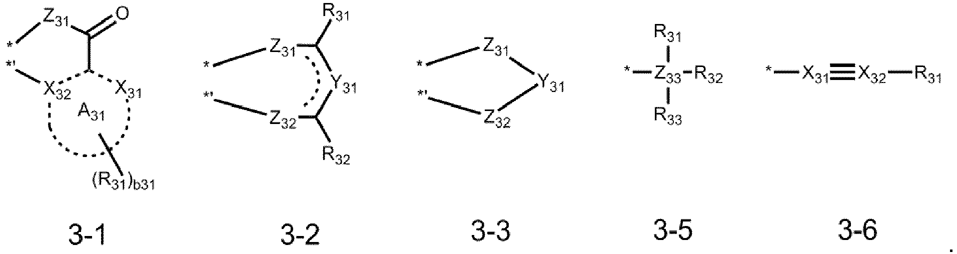 In Formulae 3-1 to 3-6,
A₃₁ may be selected from a C₅-C₂₀ carbocyclic group and a C₁-C₂₀ heterocyclic group;
X₃₁ and X₃₂ may each independently be selected from C and N;
Y₃₁ may be selected from a single bond, a carbon-carbon double bond, a substituted or unsubstituted C₁-C₅ alkylene group, a substituted or unsubstituted C₂-C₅ alkenylene group, and a substituted or unsubstituted C₆-C₁₀ arylene group;
Z₃₁ and Z₃₂ may each independently be selected from N, O, N(R₃₄), P(R₃₄)(R₃₅), and As(R₃₄)(R₃₅);
Z₃₃ may be selected from P and As;
R₃₁ to R₃₅ may each independently be selected from hydrogen, deuterium, -F, -Cl,-Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, and a substituted or unsubstituted monovalent non-aromatic condensed heteropolycyclic group;
b31 may be selected from 1, 2, and 3; and
* and *' may each independently indicate a binding site to a neighboring atom.

For example, A₃₁ in Formulae 3-1 to 3-6 may be selected from a benzene group, a naphthalene group, a pyridine group, a pyrimidine group, a triazine group, a quinoline group, and an isoquinoline group, but is not limited thereto.

For example, Y₃₁ in Formulae 3-1 to 3-6 may be selected from a substituted or unsubstituted methylene group and a substituted or unsubstituted phenylene group, but is not limited thereto.

For example, Z₃₃ in Formulae 3-1 to 3-6 may be P, but is not limited thereto.

For example, R₃₁ to R₃₅ in Formulae 3-1 to 3-6 may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group; and
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, but they are not limited thereto.

In an embodiment, L₁ in Formulae 1-1 to 1-3 may be represented by one of Formulae 4-1 to 4-5, but is not limited thereto: 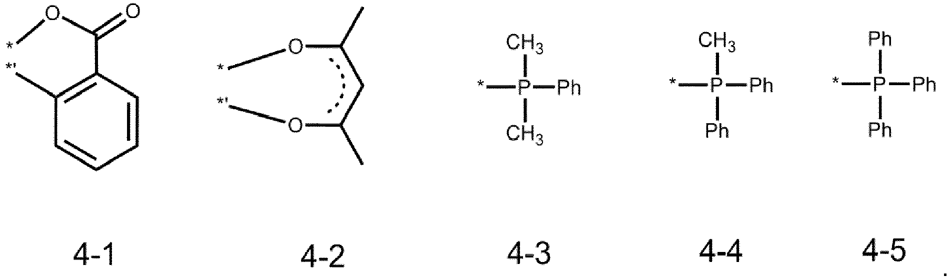 In Formulae 4-1 to 4-5,
Ph refers to a phenyl group; and
* and *' may each indicate a binding site to a neighboring atom.
a1 in Formulae 1-1 to 1-3 indicates the number of groups L₁, and a1 is selected from 0, 1, and 2. When a1 is 2 or more, groups L₁ may be identical to or different from each other.

For example, a1 in Formulae 1-1 to 1-3 may be 0, but is not limited thereto.

In an embodiment, in Formulae 1-1 to 1-3, M may be Pt, and a1 may be 0, but they are not limited thereto.

In an embodiment, in Formulae 1-1 to 1-3, M may be Os, and a1 may be 2, but they are not limited thereto.

The organometallic compound represented by Formulae 1-1 to 1-3 may be represented by one of Formulae 1-11 to 1-13, but the formulae representing the organometallic compound are not limited thereto: 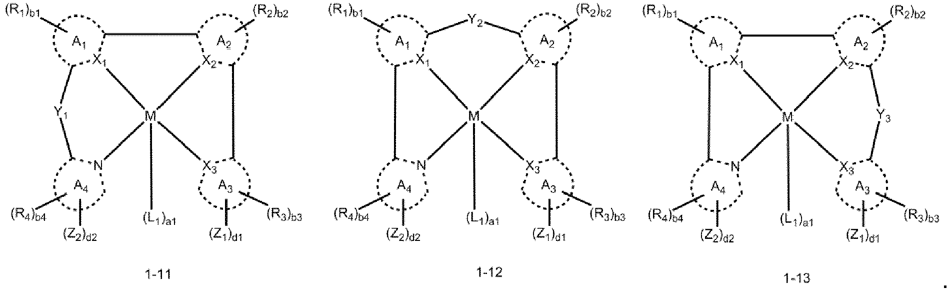 In Formulae 1-11 to 1-13,
M, A₁ to A₄, X₁ to X₃, Z₁, Z₂, R₁ to R₄, b1 to b4, L₁, and a1 are the same as described above in connection with Formulae 1-1 to 1-3;
Y₁ to Y₃ may each independently be a divalent linking group;
d1 may be selected from 0, 1, 2, 3, and 4; and
d2 may be selected from 1, 2, 3, and 4.

For example, Z₁ and Z₂ in Formulae 1-11 to 1-13 may each independently be represented by one of Formulae 2-21 to 2-34, but they are not limited thereto.

In an embodiment, in Formulae 1-11 to 1-13, M is Pt, and a1 is 0, but they are not limited thereto.

The organometallic compound represented by Formulae 1-1 to 1-3 may be represented by one of Formulae 1-14 to 1-16, but the formulae representing the organometallic compound are not limited thereto: 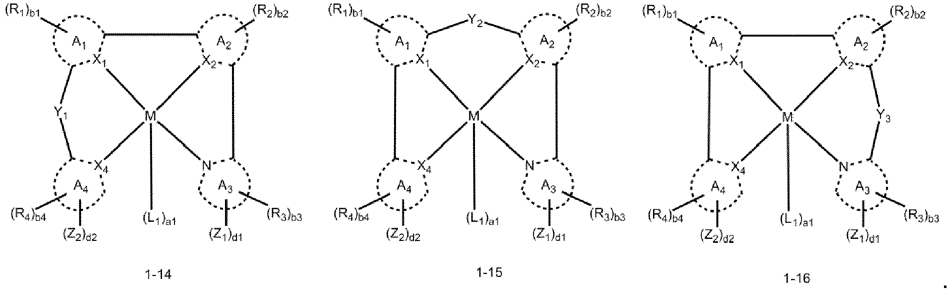 In Formulae 1-14 to 1-16,
M, A₁ to A₄, X₁, X₂, X₄, Z₁, Z₂, R₁ to R₄, b1 to b4, L₁, and a1 are the same as described above in connection with Formulae 1-1 to 1-3;
Y₁ to Y₃ may each independently be a divalent linking group;
d1 may be selected from 1, 2, 3, and 4; and
d2 may be selected from 0, 1, 2, 3, and 4.

For example, Z₁ and Z₂ in Formulae 1-14 to 1-16 may each independently be represented by one of Formulae 2-21 to 2-34, but they are not limited thereto.

In an embodiment, in Formulae 1-14 to 1-16, M is Pt, and a1 is 0, but they are not limited thereto.

The organometallic compound represented by Formulae 1-1 to 1-3 may be represented by one of Formulae 1-17 to 1-19, but the formulae representing the organometallic compound are not limited thereto: 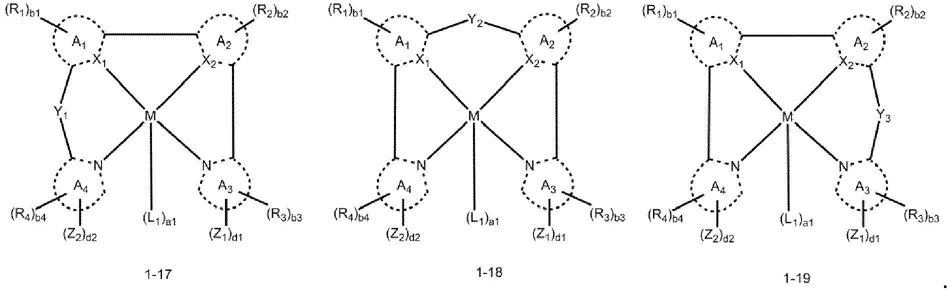 In Formulae 1-17 to 1-19,
M, A₁ to A₄, X₁, X₂, Z₁, Z₂, R₁ to R₄, b1 to b4, L₁, and a1 are the same as described above in connection with Formulae 1-1 to 1-3;
Y₁ to Y₃ may each independently be a divalent linking group;
d1 may be selected from 1, 2, 3, and 4; and
d2 may be selected from 1, 2, 3, and 4.

For example, Z₁ and Z₂ in Formulae 1-17 to 1-19 may each independently be represented by one of Formulae 2-21 to 2-34, but they are not limited thereto.

In an embodiment, in Formulae 1-17 to 1-19, M is Pt, and a1 is 0, but they are not limited thereto.

The organometallic compound represented by Formulae 1-1 to 1-3 may be selected from Compounds 1 to 18 and 20 to 37, but the formula representing the organometallic compound is not limited thereto:

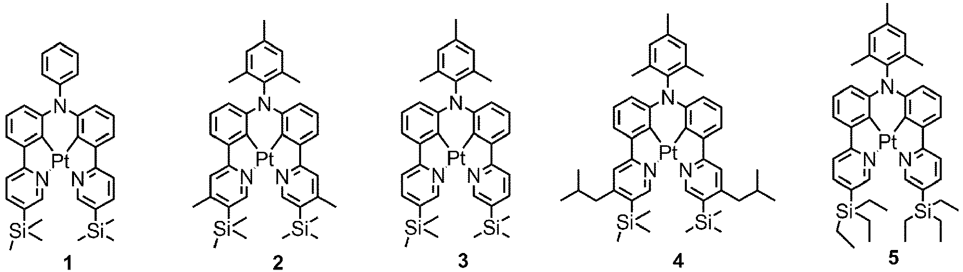

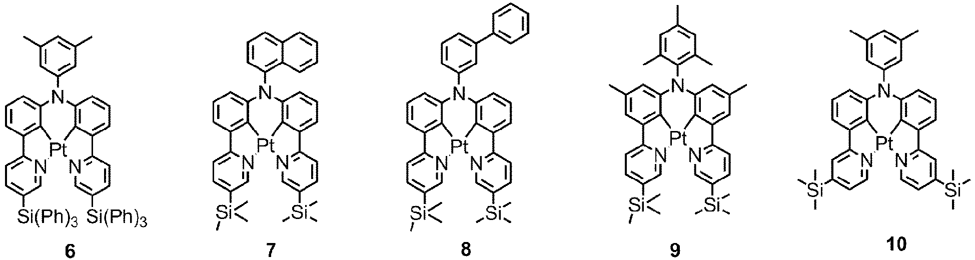

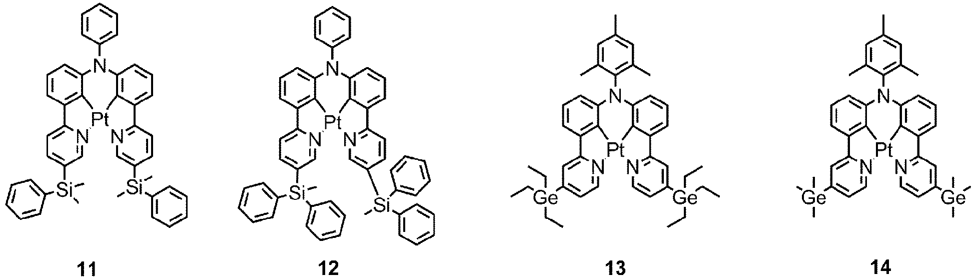

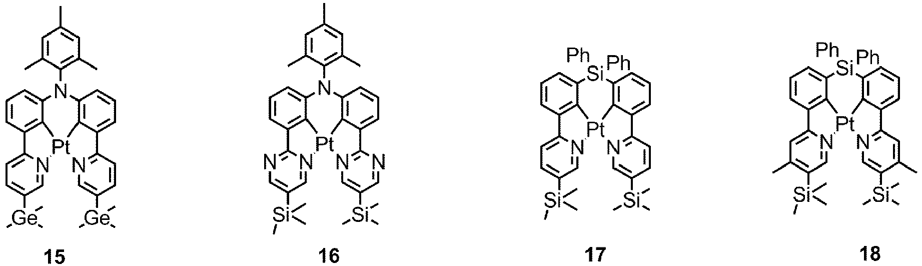

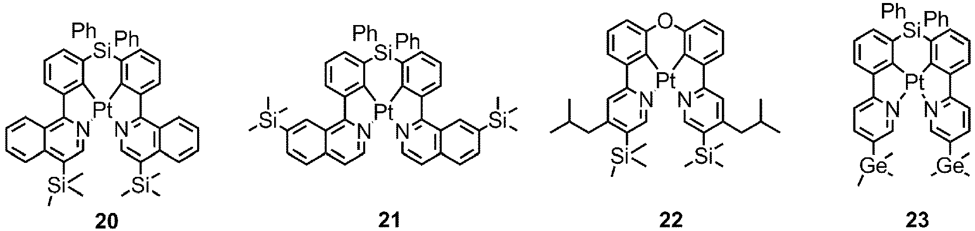

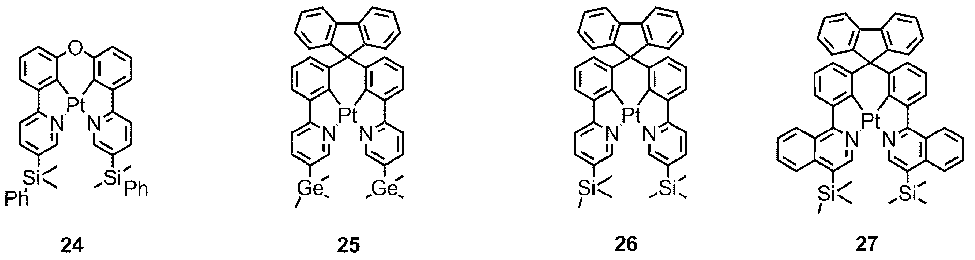

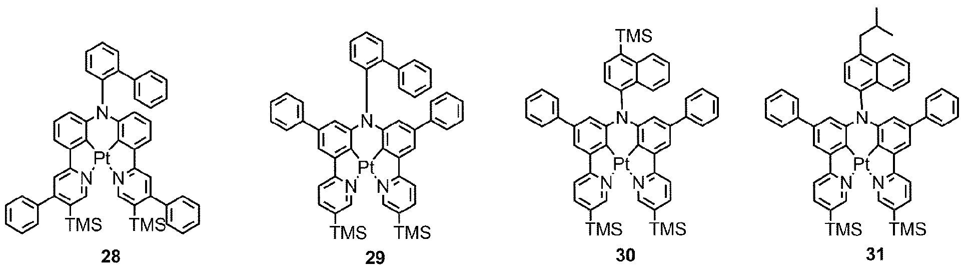

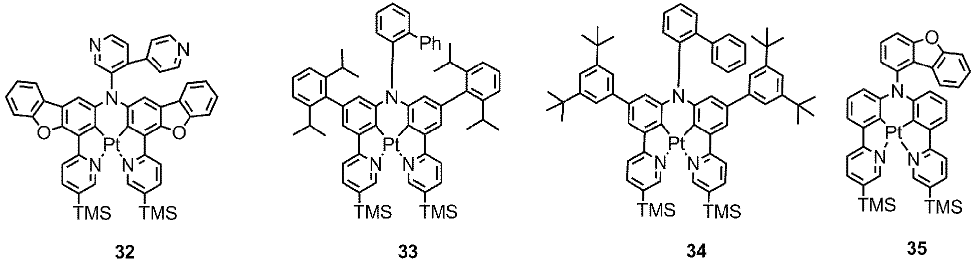

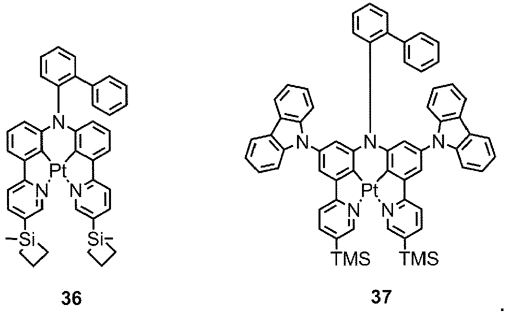

In Compounds 1 to 18 and 20 to 37,
TMS refers to a trimethylsilyl group.

In the organometallic compound represented by Formula 1, as illustrated in Formula 1', an N-containing ring may be necessarily substituted with a group represented by one of Formulae 2-1 to 2-4.

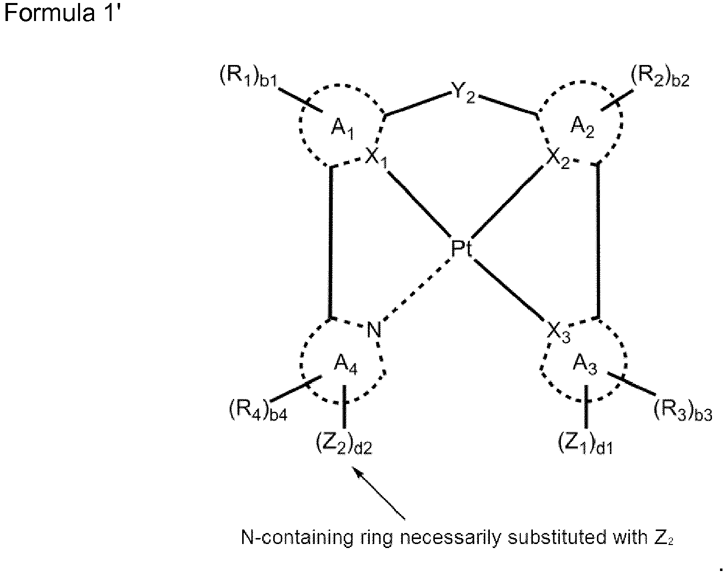

When the N-containing ring is substituted with the group represented by one of Formulae 2-1 to 2-4, an empty d-orbital of Si or Ge can be filled with electrons. Accordingly, since the N-containing ring is substituted with the group represented by one of Formulae 2-1 to 2-4, when electrons and/or energy flow or are applied to the organometallic compound represented by Formula 1, the chemical, physical, and/or electric stability of the organometallic compound represented by Formula 1 may be improved. Thus, the lifespan of an organic light-emitting device including the organometallic compound represented by Formula 1 may be increased.

Due to the introduction of the group represented by one of Formulae 2-1 to 2-4 in the organometallic compound represented by Formula 1, steric hindrance may be increased, and the organometallic compound represented by Formula 1 may have a non-planar structure. Since the organometallic compound represented by Formula 1 has a non-planar structure, less aggregation may occur, and the efficiency of an organic light-emitting device including the organometallic compound represented by Formula 1 may be improved.

Synthesis methods of the organometallic compound represented by one of Formulae 1-1 to 1-3 may be recognizable by one of ordinary skill in the art by referring to Synthesis Examples provided below.

The organometallic compound represented by one of Formulae 1-1 to 1-3 is suitable for use in an organic layer of an organic light-emitting device, for example, for use as a dopant in an emission layer of the organic layer. Thus, another aspect provides an organic light-emitting device that includes:
a first electrode;
a second electrode; and
an organic layer that is disposed between the first electrode and the second electrode,
wherein the organic layer includes an emission layer and at least one organometallic compound represented by one of Formulae 1-1 to 1-3.

The organometallic compound of Formulae 1-1 to 1-3 may be used between a pair of electrodes of an organic light-emitting device. For example, the organometallic compound represented by one of Formulae 1-1 to 1-3 may be included in the emission layer. In this regard, the organometallic compound may act as a dopant, and the emission layer may further include a host (that is, an amount of the organometallic compound represented by one of Formulae 1-1 to 1-3 is smaller than an amount of the host).

The expression that "(an organic layer) includes at least one of organometallic compounds" as used herein may include an embodiment in which "(an organic layer) includes identical organometallic compounds represented by one of Formulae 1-1 to 1-3" and an embodiment in which "(an organic layer) includes two or more different organometallic compounds represented by one of Formulae 1-1 to 1-3."

For example, the organic layer may include only Compound 1 as the organometallic compound. In this regard, Compound 1 may be included only in the emission layer of the organic light-emitting device. In other embodiments, the organic layer may include, as the organometallic compound, Compound 1 and Compound 2. In those embodiments, Compound 1 and Compound 2 may be included in an identical layer (for example, Compound 1 and Compound 2 all may be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, the first electrode may be an anode, and the second electrode may be a cathode, and the organic layer may include:
i) a hole transport region disposed between the first electrode and the emission layer, wherein the hole transport region includes at least one selected from a hole injection layer, a hole transport layer, and an electron blocking layer, and
ii) an electron transport region disposed between the emission layer and the second electrode, wherein the electron transport region includes at least one selected from a hole blocking layer, an electron transport layer, and an electron injection layer.

FIG. 1 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 1. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used here, and the substrate may be a glass substrate or a transparent plastic substrate, each having excellent mechanical strength, thermal stability, transparency, surface smoothness, ease of handling, and water-resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide (SnO₂), and zinc oxide (ZnO). In some embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer.

The hole transport region may include only either a hole injection layer or a hole transport layer. In some embodiments, the hole transport region may have a structure of hole injection layer/hole transport layer or hole injection layer/hole transport layer/electron blocking layer, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 to about 500°C, a vacuum pressure of about 10⁻⁸ to about 10⁻³ torr, and a deposition rate of about 0/001 nm/sec to about 10 nm/sec (about 0.01 to about 100 Å/sec). However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (Pani/PSS), a compound represented by Formula 201 below, and a compound represented by Formula 202 below:

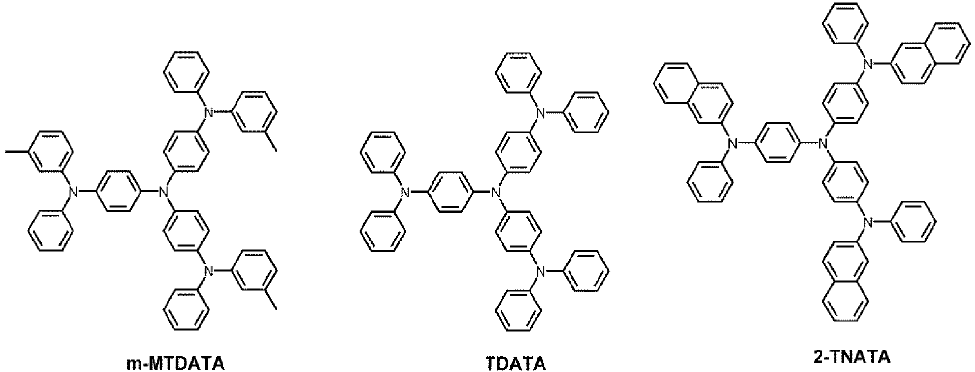

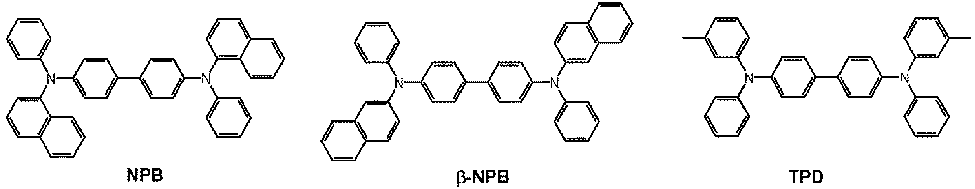

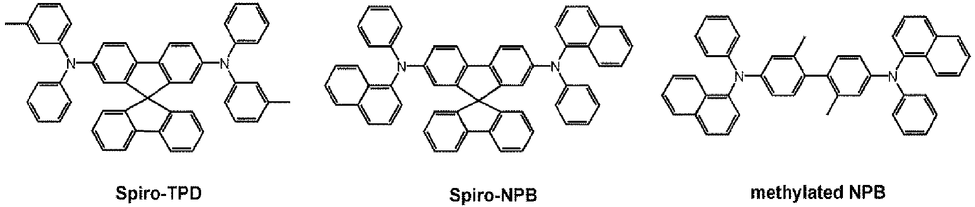

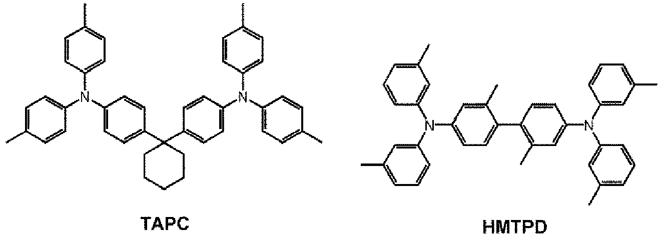

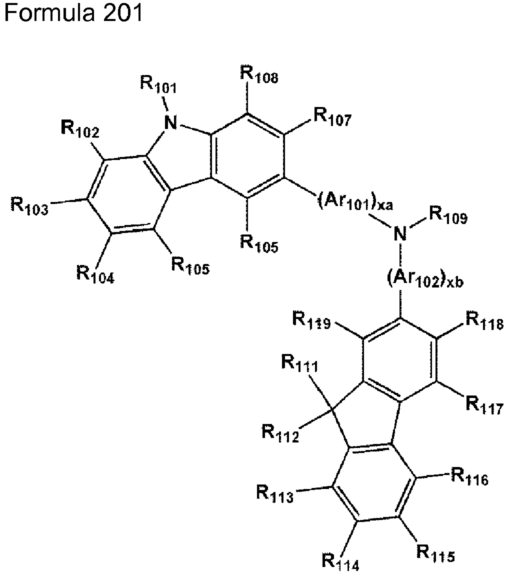

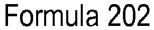

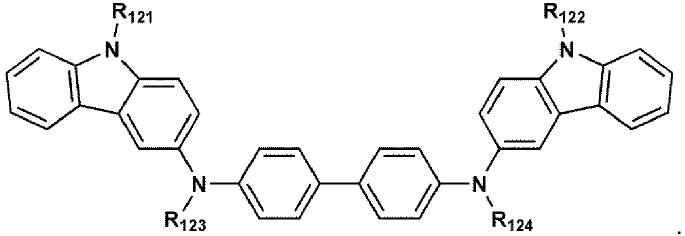

Ar₁₀₁ and Ar₁₀₂ in Formula 201 may each independently be selected from:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.
xa and xb in Formula 201 may each independently be an integer selected from 0 to 5, or 0, 1, or 2. For example, xa is 1 and xb is 0, but xa and xb are not limited thereto.

R₁₀₁ to R₁₀₈, R₁₁₁ to R₁₁₉, and R₁₂₁ to R₁₂₄ in Formulae 201 and 202 may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, etc.), and a C₁-C₁₀ alkoxy group (for example, a methoxy group, an ethoxy group, a propoxy group, butoxy group, a pentoxy group, etc.);
a C₁-C₁₀ alkyl group and a C₁-C₁₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group, but they are not limited thereto.

R₁₀₉ in Formula 201 may be selected from:
a phenyl group, a naphthyl group, an anthracenyl group, and a pyridinyl group; and
a phenyl group, a naphthyl group, an anthracenyl group, and a pyridinyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, and a pyridinyl group.

In an embodiment, the compound represented by Formula 201 may be represented by Formula 201A, but the formula representing the compound is not limited thereto: 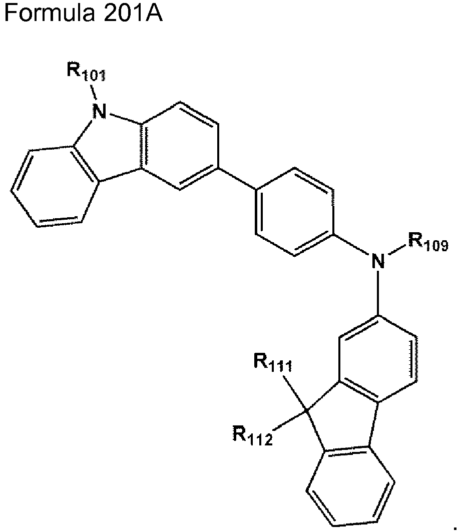 R₁₀₁, R₁₁₁, R₁₁₂, and R₁₀₉ in Formula 201A may be understood by referring to the description provided herein.

For example, the compound represented by Formula 201, and the compound represented by Formula 202 may include compounds HT1 to HT20 illustrated below, but are not limited thereto:

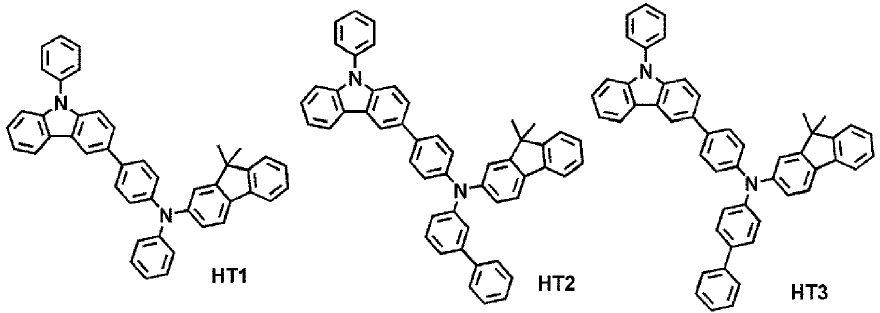

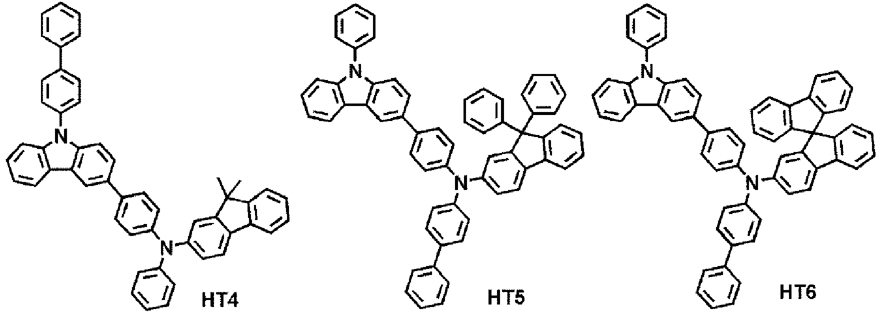

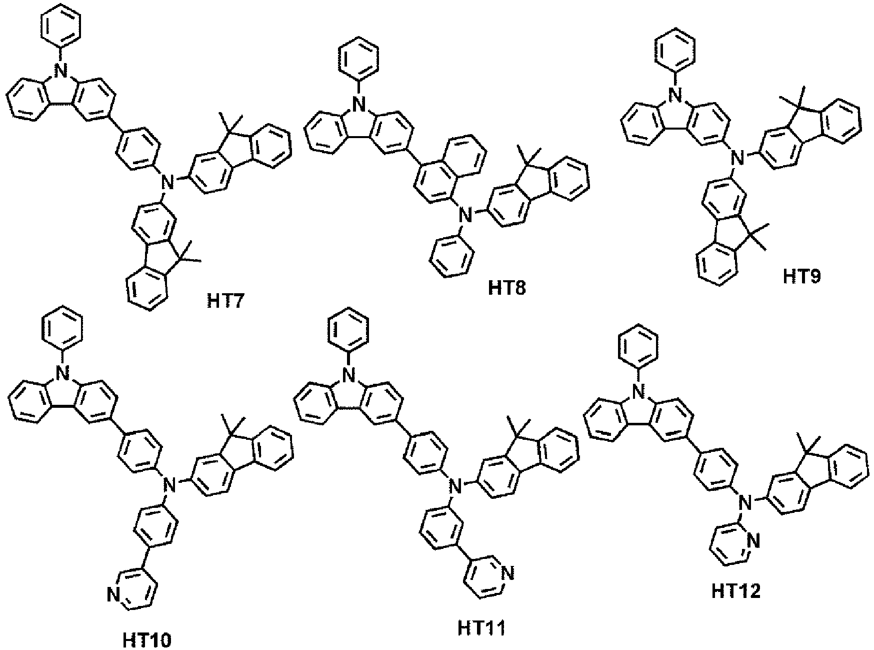

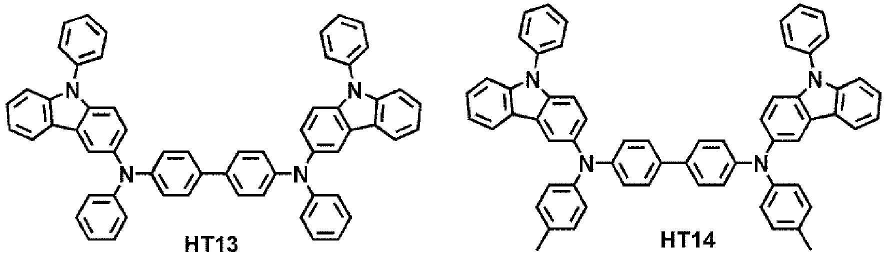

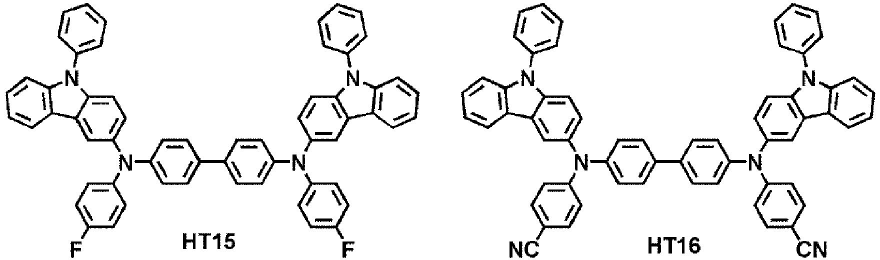

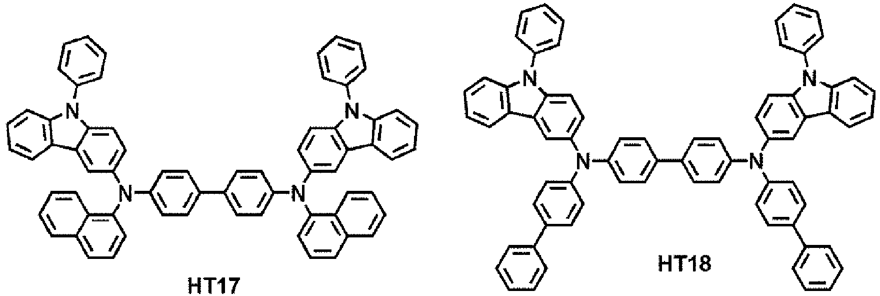

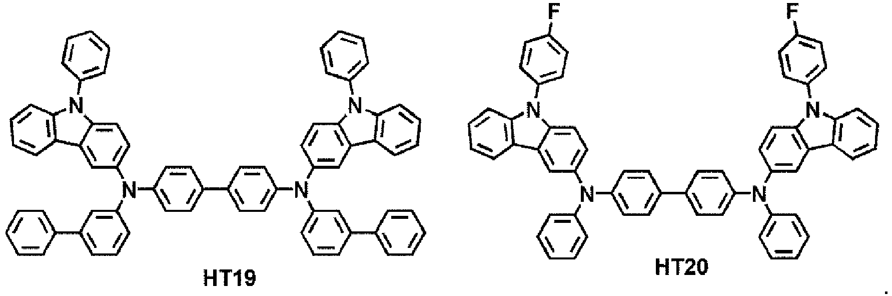

A thickness of the hole transport region may be in a range of about 10 nm to about 1,000 nm (about 100 Å to about 10,000 Å), for example, about 10 nm to about 100 nm (about 100 Å to about 1,000 Å). When the hole transport region includes a hole injection layer and a hole transport layer, the thickness of the hole injection layer may be in a range of about 10 nm to about 1,000 nm (about 100 Å to about 10,000 Å), and for example, about 10 nm to about 100 nm (about 100 Å to about 1,000 Å), and the thickness of the hole transport layer may be in a range of about 5 nm to about 200 nm (about 50 Å to about 2,000 Å), and for example, about 10 nm to about 150 nm (about 100 Å to about 1,500 Å). While not wishing to be bound by theory, it is understood that when the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments are not limited thereto. Non-limiting examples of the p-dopant include a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto.

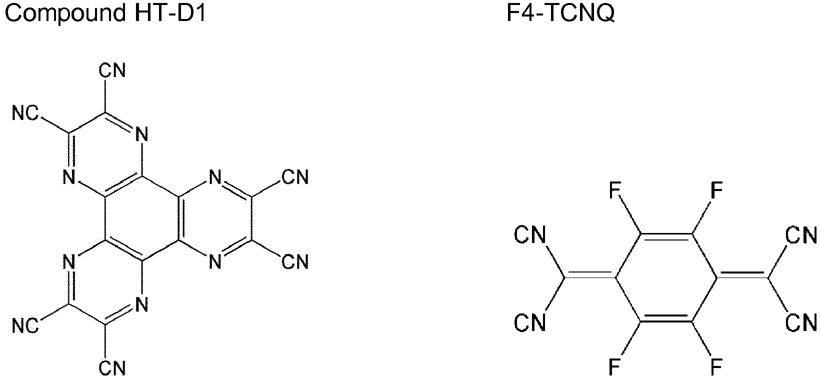

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied to form the hole injection layer although the deposition or coating conditions may vary according to the material that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by one of Formulae 1-1 to 1-3.

The host may include at least one selected from TPBi, TBADN, ADN (also referred to as "DNA"), CBP, CDBP, TCP, mCP, Compound H50, and Compound H51:

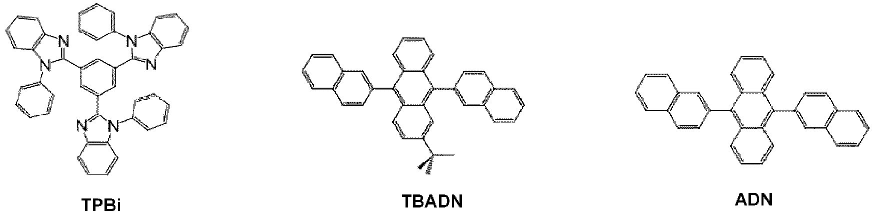

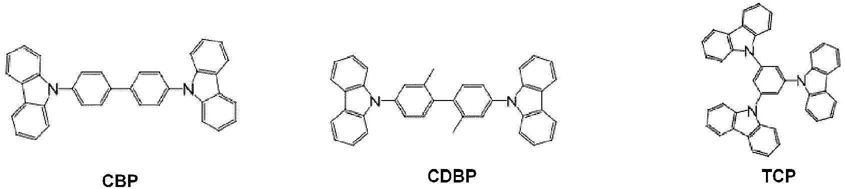

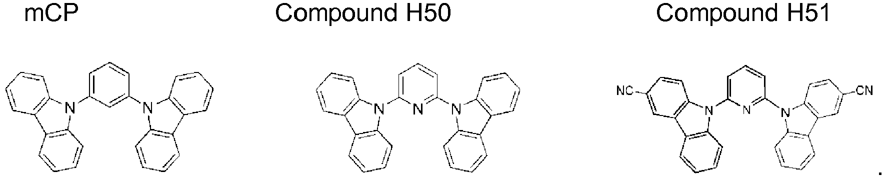

In some embodiments, the host may further include a compound represented by Formula 301 below. 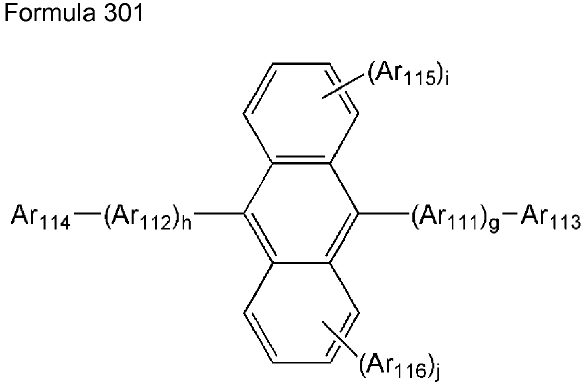 Ar₁₁₁ and Ar₁₁₂ in Formula 301 may each independently be selected from:
a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

Ar₁₁₃ to Ar₁₁₆ in Formula 301 may each independently be selected from:
a C₁-C₁₀ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

g, h, i, and j in Formula 301 may each independently be an integer selected from 0 to 4, and may be, for example, 0, 1, or 2.

Ar₁₁₃ to Ar₁₁₆ in Formula 301 may each independently be selected from:
a C₁-C₁₀ alkyl group, substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a phenyl group, a naphthyl group, an anthracenyl group, a pyrenyl group, a phenanthrenyl group, and a fluorenyl group; and 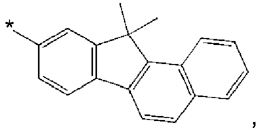
but embodiments are not limited thereto.

In some embodiments, the host may include a compound represented by Formula 302:

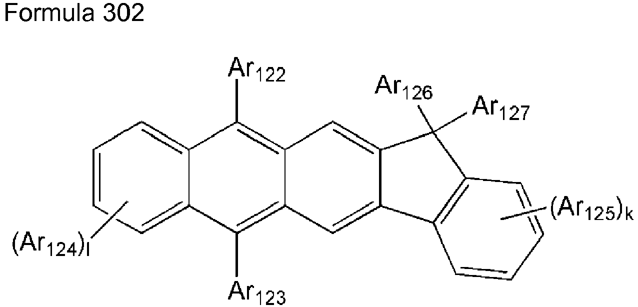

Ar₁₂₂ to Ar₁₂₅ in Formula 302 are the same as described in detail in connection with Ar₁₁₃ in Formula 301.

Ar₁₂₆ and Ar₁₂₇ in Formula 302 may each independently be a C₁-C₁₀ alkyl group (for example, a methyl group, an ethyl group, or a propyl group).

k and I in Formula 302 may each independently be an integer selected from 0 to 4. For example, k and I may each be 0, 1, or 2.

The compound represented by Formula 301 and the compound represented by Formula 302 may include Compounds H1 to H42 illustrated below, but are not limited thereto:

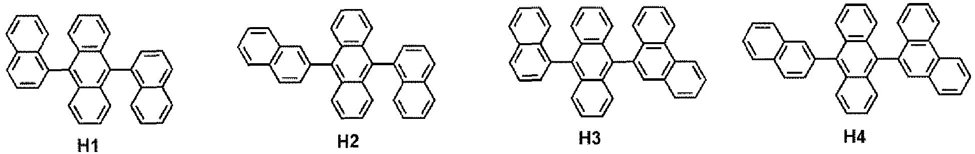

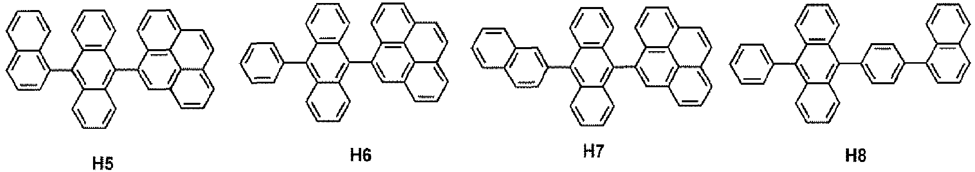

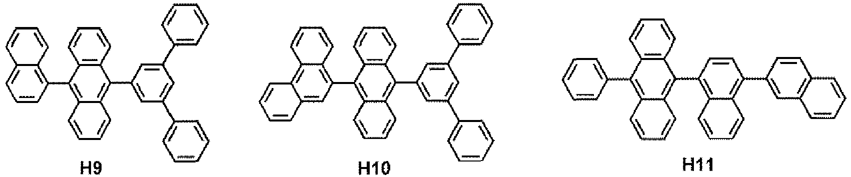

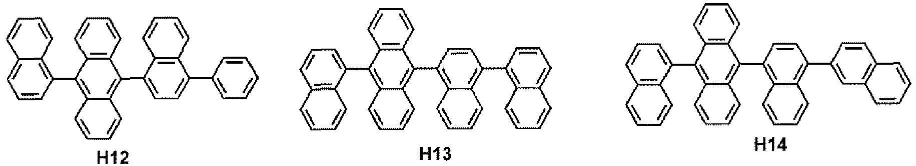

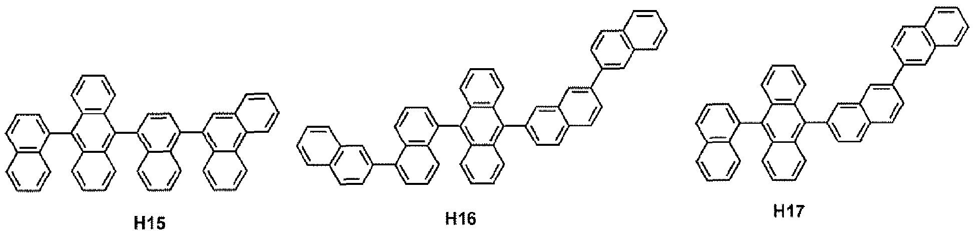

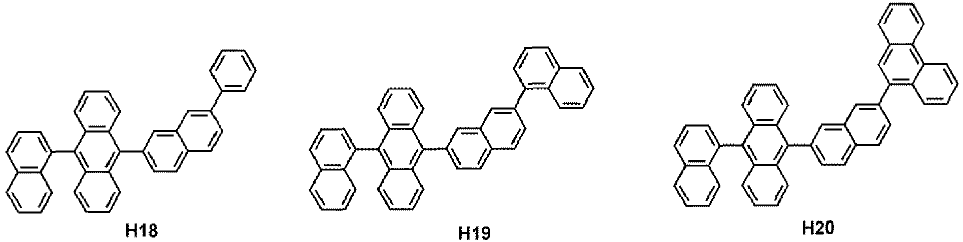

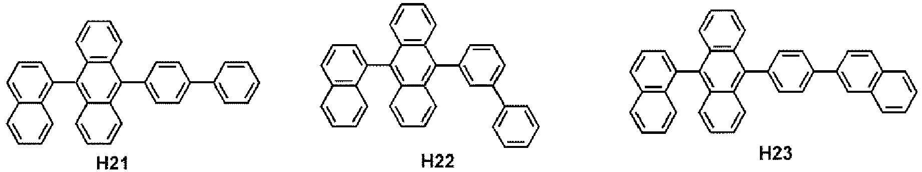

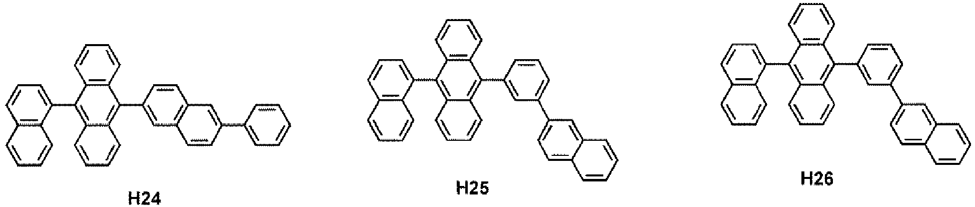

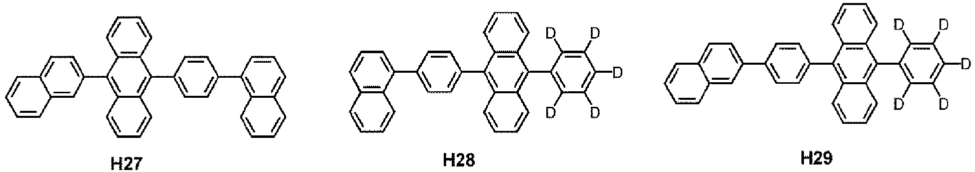

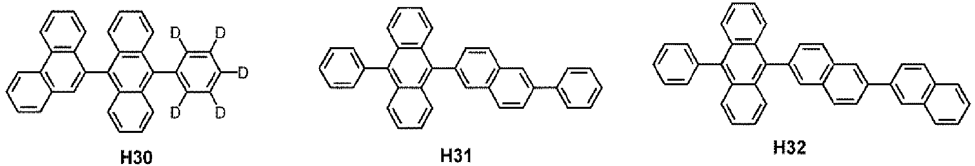

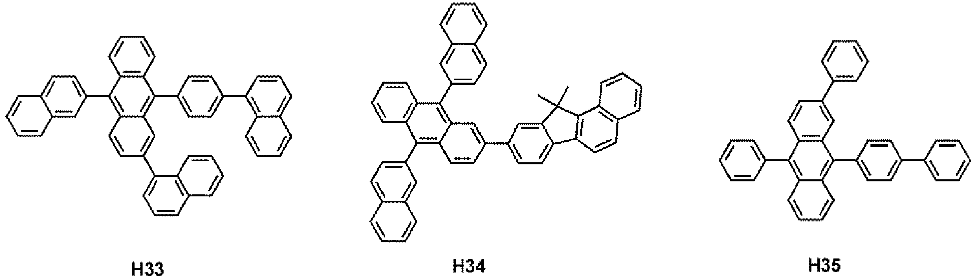

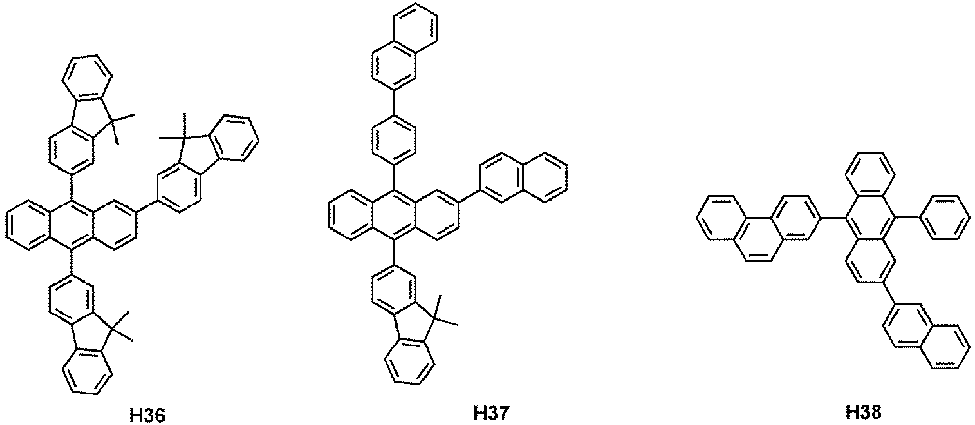

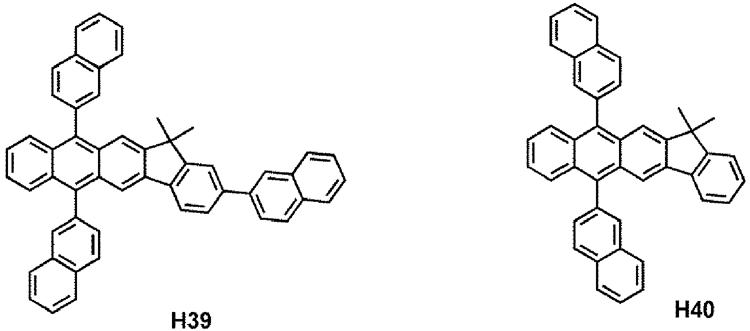

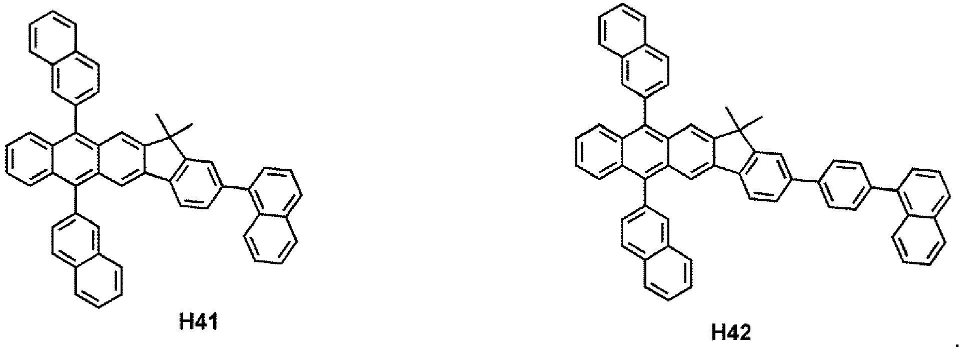

When the organic light-emitting device is a full color organic light-emitting device, the emission layer may be patterned into a red emission layer, a green emission layer, and a blue emission layer. In some embodiments, due to a stack structure including a red emission layer, a green emission layer, and/or a blue emission layer, the emission layer may emit white light.

When the emission layer includes a host and a dopant, an amount of the dopant may be in a range of about 0.01 to about 15 parts by weight based on 100 parts by weight of the host, but is not limited thereto.

A thickness of the emission layer may be in a range of about 10 nm to about 100 nm (about 100 Å to about 1,000 Å), for example, about 20 nm to about 60 nm (about 200 Å to about 600 Å). While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include at least one selected from a hole blocking layer, an electron transport layer, and an electron injection layer.

For example, the electron transport region may have a structure of hole blocking layer/electron transport layer/electron injection layer or a structure of electron transport layer/electron injection layer, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but is not limited thereto:

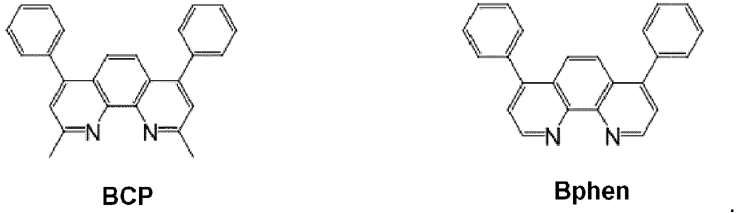

A thickness of the hole blocking layer may be in a range of about 2 nm to about 100 nm (about 20 Å to about 1,000 Å), for example, about about 3 nm to about 30 nm (about 30 Å to about 300 Å). While not wishing to be bound by theory, it is understood that when the thickness of the hole blocking layer is within these ranges, the hole blocking layer may have improved hole blocking ability without a substantial increase in driving voltage.

The electron transport layer may further include at least one selected from BCP, Bphen, Alq₃, BAlq, TAZ, and NTAZ:

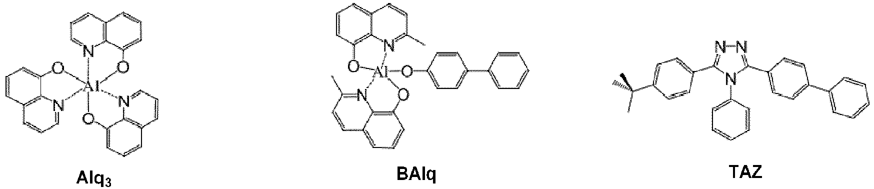

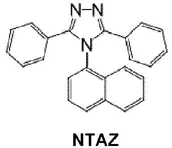

In some embodiments, the electron transport layer may include at least one of ET1 and ET2, but are not limited thereto:

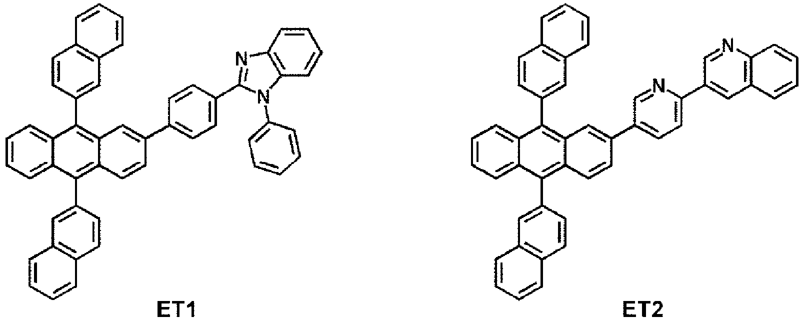

A thickness of the electron transport layer may be in a range of about about 10 nm to about 100 nm (about 100 Å to about 1,000 Å), for example, about about 15 nm to about 50 nm (about 150 Å to about 500 Å). While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium quinolate, LiQ) or ET-D2.

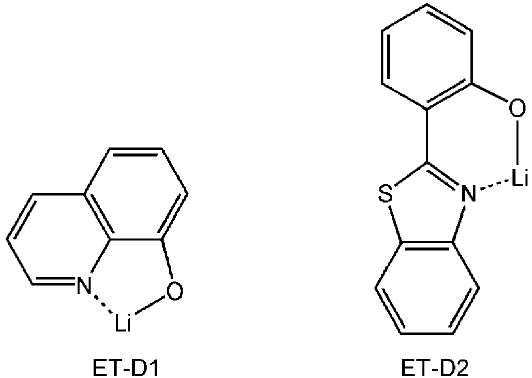

The electron transport region may include an electron injection layer (EIL) that promotes flow of electrons from the second electrode 19 thereinto.

The electron injection layer may include at least one selected from, LiF, NaCl, CsF, Li₂O, BaO, and LiQ.

A thickness of the electron injection layer may be in a range of about about 0.1 nm to about 10 nm (about 1 Å to about 100 Å), for example, about about 0.3 nm to about 9 nm (about 3 Å to about 90 Å). While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In some embodiments, to manufacture a top emission type light-emitting device, a transmissive electrode formed using ITO or IZO may be used as the second electrode 19.

Hereinbefore, the organic light-emitting device has been described with reference to FIG. 1, but is not limited thereto.

The term "C₁-C₆₀ alkyl group" as used herein refers to a linear or branched aliphatic saturated hydrocarbon monovalent group having 1 to 60 carbon atoms, and examples thereof include a methyl group, an ethyl group, a propyl group, an iso-butyl group, a sec-butyl group, a tert-butyl group, a pentyl group, an iso-amyl group, and a hexyl group. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and non-limiting examples thereof include a methoxy group, an ethoxy group, and an iso-propyloxy group.

The term "C₂-C₆₀ alkenyl group" as used herein refers to a hydrocarbon group formed by including at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by including at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent monocyclic group having at least one heteroatom selected from N, O, P, and S as a ring-forming atom and 1 to 10 carbon atoms, and examples thereof include a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof, and which is not aromatic, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, and S as a ring-forming atom, 1 to 10 carbon atoms, and at least one carbon-carbon double bond in its ring. Non-limiting examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and a C₆-C₆₀ arylene group as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group having an aromatic system that has at least one heteroatom selected from N, O, P, and S as a ring-forming atom, and 1 to 60 carbon atoms. A C₁-C₆₀ heteroarylene group as used herein refers to a divalent group having a carbocyclic aromatic system that has at least one heteroatom selected from N, O, P, and S as a ring-forming atom, and 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), the term "C₆-C₆₀ arylthio group" as used herein indicates -SA₁₀₃ (wherein A₁₀₃ is the C₆-C₆₀ aryl group), and the term "C₇-C₆₀ arylalkyl group" as used herein indicates -A₁₀₄A₁₀₅ (wherein A₁₀₄ is the C₁-C₅₄ alkylene group and A₁₀₅ is the C₆-C₅₉ aryl group).

The term "C₂-C₆₀ heteroaryloxy group" as used herein indicates -OA₁₀₆ (wherein A₁₀₆ is the C₂-C₆₀ heteroaryl group), the term "C₂-C₆₀ heteroarylthio group" as used herein indicates -SA₁₀₇ (wherein A₁₀₇ is the C₂-C₆₀ heteroaryl group), and the term "C₃-C₆₀ heteroarylalkyl group" as used herein indicates -A₁₀₈A₁₀₉ (wherein A₁₀₈ is the C₁-C₅₉ alkylene group and A₁₀₉ is the C₁-C₅₉ heteroaryl group).

The term "monovalent non-aromatic condensed polycyclic group" as used herein refers to a monovalent group (for example, having 8 to 60 carbon atoms) that has two or more rings condensed to each other, only carbon atoms as a ring-forming atom, and which is non-aromatic in the entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) that has two or more rings condensed to each other, has a heteroatom selected from N, O, P, and S, other than carbon atoms, as a ring-forming atom, and which is non-aromatic in the entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

As used herein, at least one substituent selected from the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₇-C₆₀ arylalkyl group, substituted C₁-C₆₀ heteroaryl group, substituted C₁-C₆₀ heteroaryloxy group, substituted C₁-C₆₀ heteroarylthio group, substituted C₂-C₆₀ heteroarylalkyl group, substituted monovalent non-aromatic condensed polycyclic group, and substituted monovalent non-aromatic condensed heteropolycyclic group may be selected from:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I,-CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group; and
-C(=O)(Q₁₁), -Si(Q₁₁)(Q₁₂)(Q₁₃), and -N(Q₁₁)(Q₁₂),
wherein Q₁₁ to Q₁₃ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, and a substituted or unsubstituted monovalent non-aromatic condensed heteropolycyclic group.

When a group containing a specified number of carbon atoms is substituted with any of the groups listed in the preceding paragraphs, the number of carbon atoms in the resulting "substituted" group is defined as the sum of the carbon atoms contained in the original (unsubstituted) group and the carbon atoms (if any) contained in the substituent. For example, when the term "substituted C₁-C₆₀ alkyl" refers to a C₁-C₆₀ alkyl group substituted with C₆-C₆₀ aryl group, the total number of carbon atoms in the resulting aryl substituted alkyl group is C₇-C₁₂₀.

Hereinafter, a compound and an organic light-emitting device according to embodiments are described in detail with reference to Synthesis Example and Examples. However, the organic light-emitting device is not limited thereto. Referring to Synthesis Examples, the expression "'B' is used instead of 'A''' means that the amount of 'B' is identical to the amount of 'A' in terms of a molar equivalent.

### EXAMPLES

### Synthesis Example 1: Synthesis of Compound 3

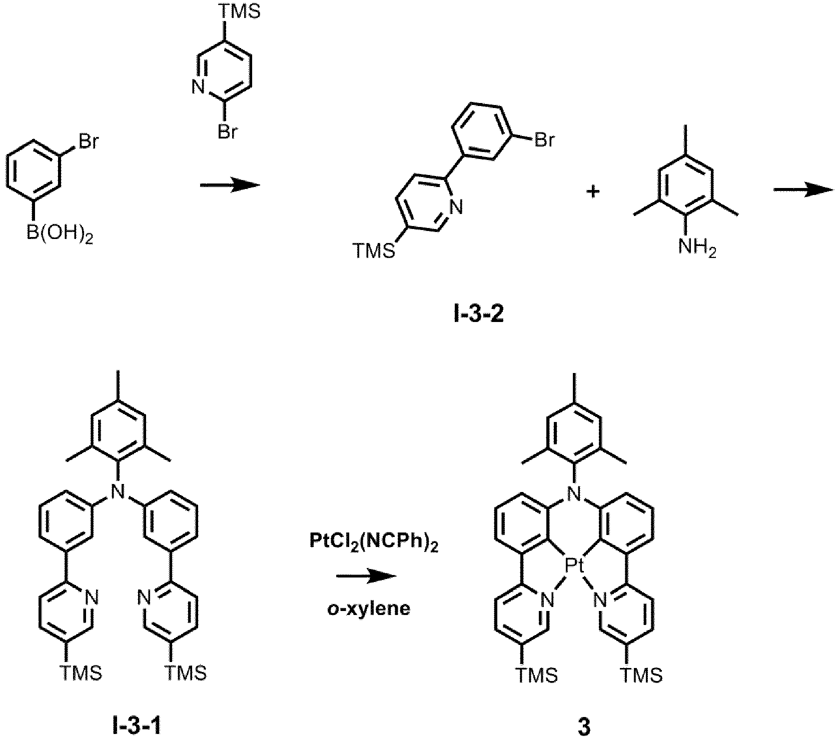

### Synthesis of Intermediate I-3-2

15.0 grams (g) (74.7 millimoles, mmol) of 3-bromophenylboronic acid, 165 milliliters (ml) of toluene, and 60 ml of ethanol were added to a reactor. Then, 13.2 g (57.5 mmol) of 2-bromo-5-(trimethylsilyl) pyridine, 4.6 g (4.02 mmol) of Pd(PPh₃)₄, and 60 ml of 2.0 molar (M) sodium carbonate solution were added thereto, and the mixture was heated under reflux at a temperature of 110°C for 18 hours. Once the reaction was completed, the mixture was concentrated under reduced pressure, and the resulting residue dissolved in 400 ml of dichloromethane. The resulting solution was filtered through diatomite. The organic layer obtained therefrom was dried by using magnesium sulfate and distilled under reduced pressure, followed by purification by liquid chromatography, to obtain 14.2 g (46 mmol, yield of 80%) of Intermediate I-3-2.
LC-MS m/z = 306 (M+H)⁺

### 2) Synthesis of Intermediate 1-3-1

8.5 g (27.6 mmol) of Intermediate I-3-2 and 250 ml of toluene were added to a reactor. 1.56 ml (11.1 mmol) of 2,4,6-trimethylaniline, 1.0 g (1.7 mmol) of Pd(dba)₂, and 1.3 g (3.3 mmol) of P(t-Bu)₃, and 3.2 g (33.1 mmol) of sodium butoxide were added thereto, and the mixture was heated under reflux at a temperature of 120°C for 24 hours. Once the reaction was completed, the mixture was concentrated under reduced pressure, and dissolved in 400 ml of dichloromethane. The resulting solution was filtered through diatomite. The organic layer obtained therefrom was distilled under reduced pressure by using magnesium sulfate, followed by purification by liquid chromatography, to obtain 6.4 g (11 mmol, yield of 99%) of Intermediate I-3-1.
LC-MS m/z = 586 (M+H)⁺

### 3) Synthesis of Compound 3

1.5 g (2.5 mmol) of Intermediate I-3-1, 100 ml of o-xylene, and 20 ml of benzonitrile were added to a reactor at a temperature of 25°C. Then, 1.2 g (2.5 mmol) of PtCl₂(NCPh)₂ was added thereto, and the resulting mixture was heated under reflux for 26 hours. Once the reaction was completed, the mixture was concentrated under reduced pressure, and purified by liquid chromatography, to obtain 0.7 g (0.8 mmol, yield of 30%) of Compound 3. The obtained compound was confirmed by LCMS and ¹H NMR.
LC-MS m/z = 779 (M+H)⁺
¹H NMR (300 MHz, CDCl₃) δ = 8.96(s, 2H), 7.94-7.92(m, 4H), 7.38(d, 2H), 7.10(s, 2H), 7.03(t, 2H), 6.28-6.26(m, 2H), 2.43(s, 3H), 1.89(s, 6H), 0.41 (s, 18H).

### Synthesis Example 2: Synthesis of Compound 1

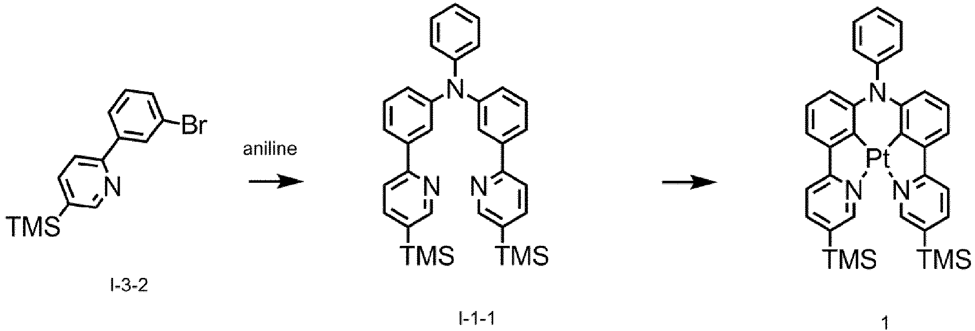

### 1) Synthesis of Intermediate I-1-1

Intermediate I-1-1 (yield of 76%) was synthesized in the same manner as Intermediate 1-3-1 in Synthesis Example 1, except that aniline was used instead of 2,4,6-trimethylaniline. The obtained compound was confirmed by LC-MS.
LC-MS m/z = 544 (M+H)⁺

### 2) Synthesis of Compound 1

Compound 1 (yield of 32%) was synthesized in the same manner as Compound 3 in Synthesis Example 1, except that Intermediate I-1-1 was used instead of Intermediate I-3-1. The obtained compound was confirmed by LCMS and ¹H NMR.
LC-MS m/z = 737 (M+H)⁺

¹H NMR (300 MHz, CDCl₃) δ = 8.92(s, 2H), 7.90-7.86(m, 4H), 7.42(d, 2H), 7.31-7.22(m, 4H), 7.18-7.09(m, 3H), 6.25-6.23(m, 2H), 0.44(s, 18H).

### Synthesis Example 3: Synthesis of Compound 2

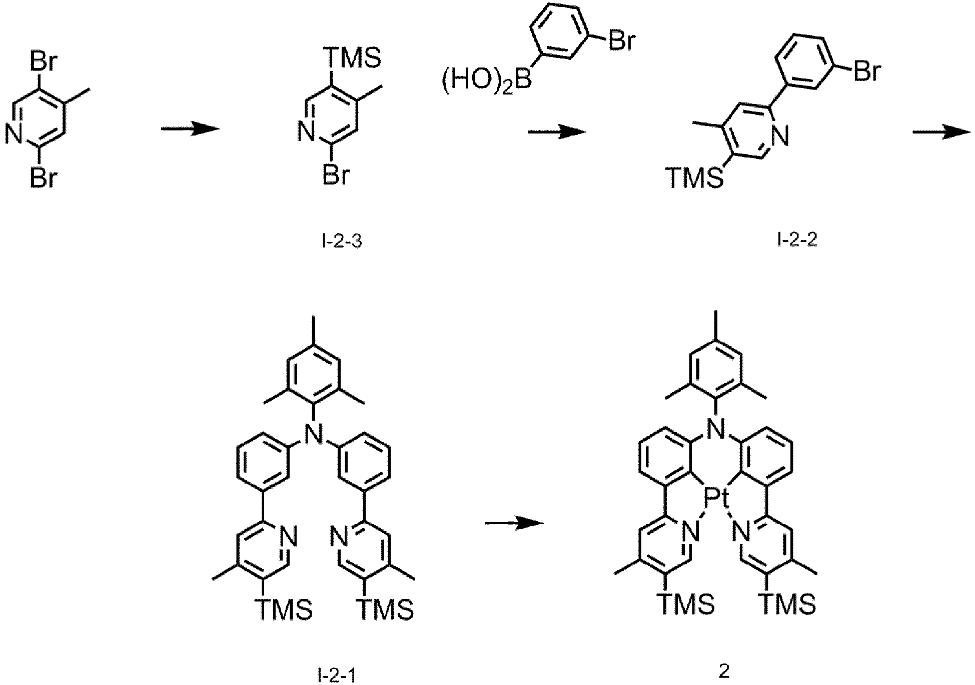

### 1) Synthesis of Intermediate I-2-3

10.6 g (42.2 mmol) of 2,5-dibromo-3-methylpyridine was dissolved in 200 ml of diethyl ether. Then, at a temperature of -78°C, 27.0 ml of n-BuLi (1.6 M solution in hexane) was slowly added thereto and the resulting mixture was stirred for about 2 hours. Thereafter, 6.5 ml (50.6 mmol) of chlorotrimethylsilane was slowly added thereto, and the mixture was stirred at a temperature of -78°C for 1 hour, and at room temperature for 16 hours. Once the reaction was completed, the mixture was extracted using 200 ml of ethyl acetate and 300 ml of distilled water, the organic layer was collected, dried using magnesium sulfate and distilled under reduced pressure. The ressidue obtained therefrom was purified by column chromatography, to obtain about 8.7 g (35.9 mmol, yield of 85%) of Intermediate I-2-3. The obtained compound was confirmed by LC-MS.
LC-MS m/z = 244 (M+H)⁺

### 2) Synthesis of Intermediate I-2-2

Intermediate I-2-2 (yield of 80%) was synthesized in the same manner as Intermediate I-3-2 in Synthesis Example 1, except that Intermediate I-2-3 was used instead of 2-bromo-5-(trimethylsilyl)pyridine. The obtained compound was confirmed by LC-MS.
LC-MS m/z = 320 (M+H)⁺

### 3) Synthesis of Intermediate 1-2-1

Intermediate 1-2-1 (yield of 70%) was synthesized in the same manner as Intermediate 1-3-1 in Synthesis Example 1, except that Intermediate I-2-2 was used instead of Intermediate I-3-2. The obtained compound was confirmed by LC-MS.
LC-MS m/z = 320 (M+H)⁺

### 4) Synthesis of Compound 2

Compound 2 (yield of 45%) was synthesized in the same manner as Compound 3 in Synthesis Example 1, except that Intermediate 1-2-1 was used instead of Intermediate I-3-1. The obtained compound was confirmed by LCMS and ¹H NMR.
LC-MS m/z = 807 (M+H)⁺
¹H NMR (300 MHz, CDCl₃) δ = 8.88(s, 2H), 7.86-7.82(m, 4H), 7.47-7.41(m, 2H), 7.16-7.11 (m, 2H), 6.78 (br s, 2H), 2.36(s, 6H), 2.22(s, 3H), 2.09(s, 6H).

### Synthesis Example 4: Synthesis of Compound 4

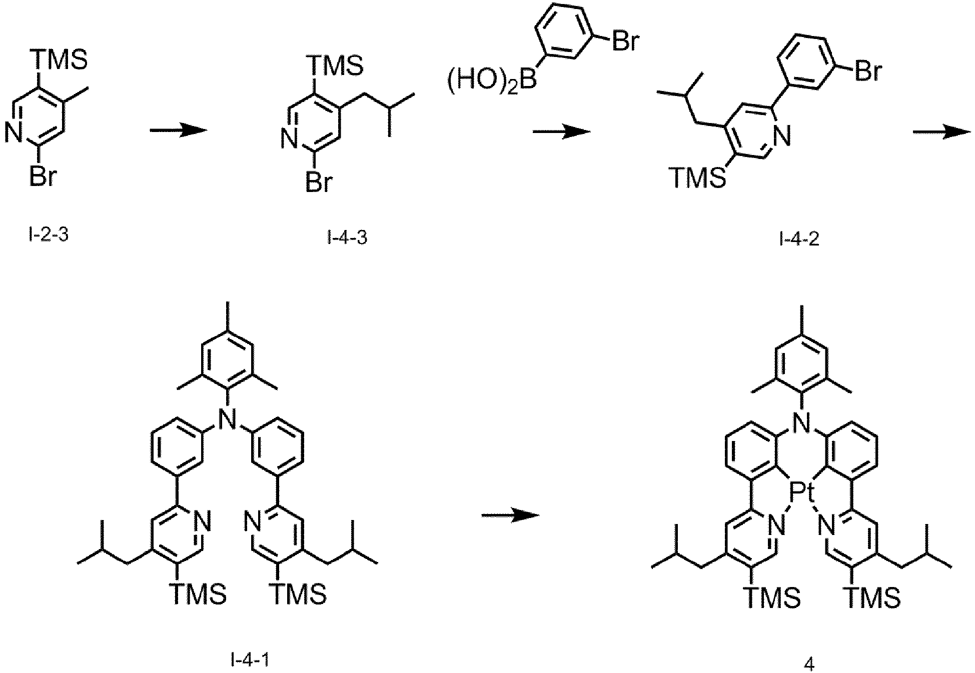

### Synthesis of Intermediate I-4-3

5.0 g (20.5 mmol) of Intermediate I-2-3 was dissolved in 300 ml of tetrahydrofuran. Then, at a temperature of -78°C, 18.0 ml of lithium diisopropylamide (LDA) (2.0 M solution in THF) was slowly added thereto and stirred for about 1 hour. Thereafter, the mixture was stirred at room temperature for about 2 hours, and then, cooled to a temperature of - 78°C. 2-bromopropane 3.8 ml (41.0 mmol) was slowly added thereto, and the resulting mixture stirred at a temperature of -78°C for 1 hour, and then at room temperature for about 18 hours. Once the reaction was completed, the mixture was extracted using 200 ml of ethyl acetate and 300 ml of distilled water, and the organic layer was collected, dried using magnesium sulfate and distilled under reduced pressure. The residue obtained therefrom was purified by column chromatography to obtain about 2.9 g (10.4 mmol, yield of 50%) of Intermediate I-4-3. The obtained compound was confirmed by LC-MS.
LC-MS m/z = 286 (M+H)⁺

### 2) Synthesis of Intermediate I-4-2

Intermediate I-4-2 (yield of 65%) was synthesized in the same manner as Intermediate I-3-2 in Synthesis Example 1, except that Intermediate I-4-3 was used instead of 2-bromo-5-(trimethylsilyl)pyridine. The obtained compound was confirmed by LC-MS.
LC-MS m/z = 362 (M+H)⁺

### 3) Synthesis of Intermediate 1-4-1

Intermediate 1-4-1 (yield of 67%) was synthesized in the same manner as Intermediate 1-3-1 in Synthesis Example 1, except that Intermediate I-4-2 was used instead of Intermediate I-3-2. The obtained compound was confirmed by LC-MS.
LC-MS m/z = 698 (M+H)⁺

### 4) Synthesis of Compound 4

Compound 4 (yield of 28%) was synthesized in the same manner as Compound 3 in Synthesis Example 1, except that Intermediate 1-4-1 was used instead of Intermediate I-3-1. The obtained compound was confirmed by LCMS and ¹H NMR.
LC-MS m/z = 891 (M+H)⁺
¹H NMR (300 MHz, CDCl₃) δ = 8.91(s, 2H), 7.88-7.84(m, 4H), 7.50-7.45(m, 2H), 7.27-7.22(m, 2H), 6.74 (br s, 2H), 3.15-3.11 (m, 4H), 2.28(s, 3H), 2.11(s, 6H), 1.88-1.85 (m, 2H), 0.91 (d, 12H).

### Synthesis Example 5: Synthesis of Compound 5

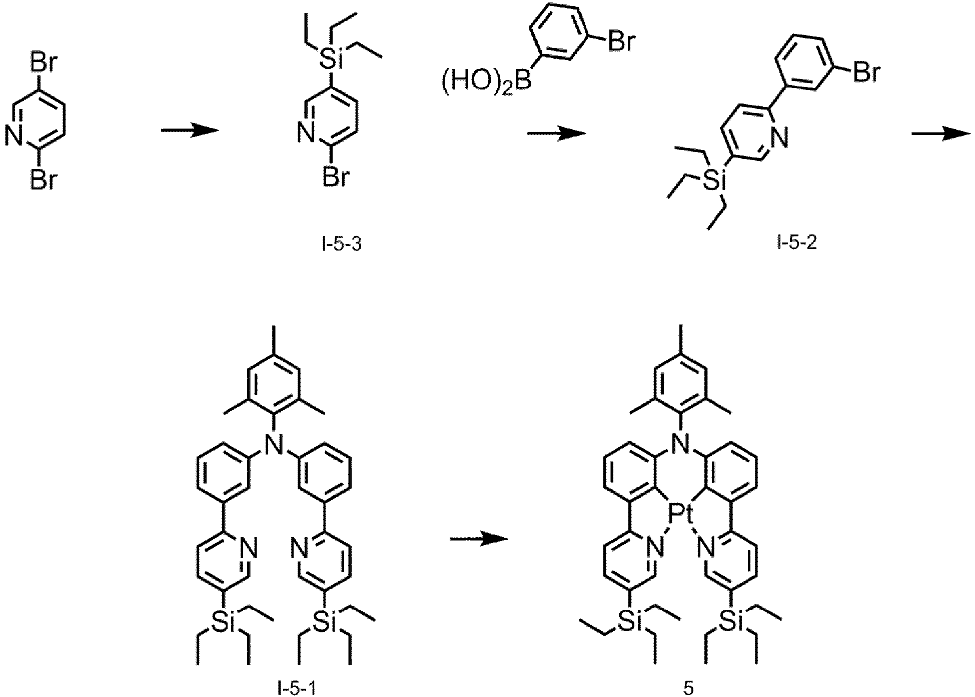

### Synthesis of Intermediate I-5-3

Intermediate I-5-3 (yield of 60%) was synthesized in the same manner as Intermediate I-2-3 in Synthesis Example 3, except that chlorotriethylsilane was used instead of chlorotrimethylsilane and 2,5-dibromopyridine was used instead of 2,5-dibromo-3-methylpyridine. The obtained compound was confirmed by LC-MS.
LC-MS m/z = 272 (M+H)⁺

### 2) Synthesis of Intermediate I-5-2

Intermediate I-5-2 (yield of 80%) was synthesized in the same manner as Intermediate I-2-2 in Synthesis Example 3, except that Intermediate I-5-3 was used instead of Intermediate I-2-3. The obtained compound was confirmed by LC-MS.
LC-MS m/z = 348 (M+H)⁺

### 3) Synthesis of Intermediate 1-5-1

Intermediate 1-5-1 (yield of 57%) was synthesized in the same manner as Intermediate 1-2-1 in Synthesis Example 3, except that Intermediate I-5-2 was used instead of Intermediate I-2-2. The obtained compound was confirmed by LC-MS.
LC-MS m/z = 628 (M+H)⁺

### 4) Synthesis of Compound 5

Compound 5 (yield of 35%) was synthesized in the same manner as Compound 3 in Synthesis Example 1, except that Intermediate 1-5-1 was used instead of Intermediate I-3-1. The obtained compound was confirmed by LCMS and ¹H NMR.
LC-MS m/z = 821 (M+H)⁺
¹H NMR (300 MHz, CDCl₃) 8.98(s, 2H), 7.98-7.93(m, 4H), 7.36(d, 2H), 7.12(s, 2H), 7.08-7.04(m, 2H), 6.25-6.23(m, 2H), 2.33(s, 3H), 1.93(s, 6H), 1.01-0.94(m, 18H), 0.76 (br s, 12H).

### Synthesis Example 6: Synthesis of Compound 6

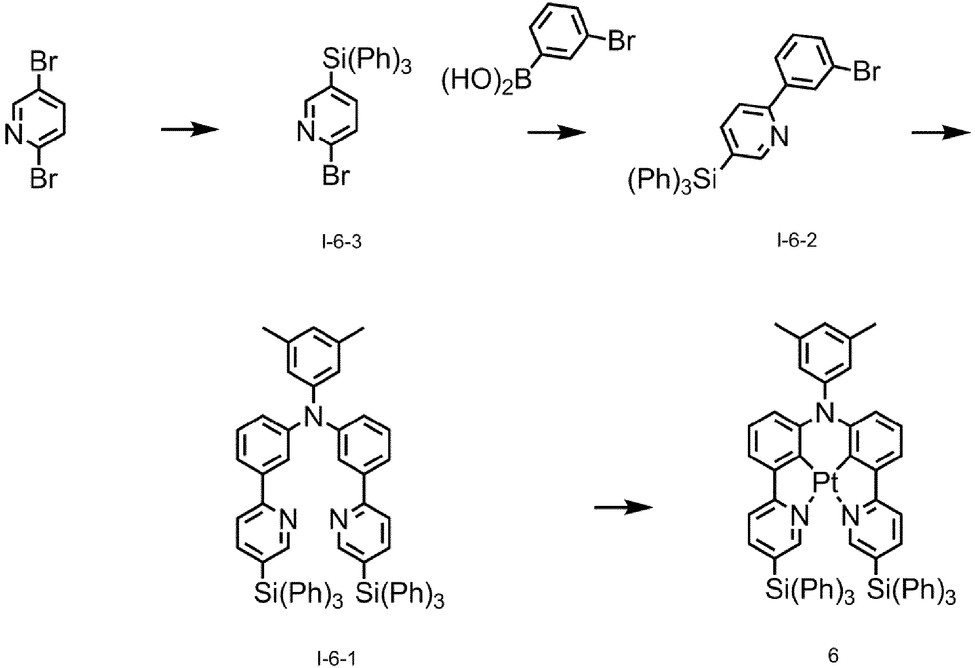

### Synthesis of Intermediate I-6-3

Intermediate I-6-3 (yield of 75%) was synthesized in the same manner as Intermediate I-5-3 in Synthesis Example 5, except that chlorotriphenylsilane was used instead of chlorotriethylsilane. The obtained compound was confirmed by LC-MS.
LC-MS m/z = 416 (M+H)⁺

### 2) Synthesis of Intermediate I-6-2

Intermediate I-6-2 (yield of 73%) was synthesized in the same manner as Intermediate I-5-2 in Synthesis Example 5, except that Intermediate I-6-3 was used instead of Intermediate I-5-3. The obtained compound was confirmed by LC-MS.
LC-MS m/z = 492 (M+H)⁺
3) Synthesis of Intermediate I-6-1

Intermediate I-6-1 (yield of 60%) was synthesized in the same manner as Intermediate 1-5-1 in Synthesis Example 5, except that Intermediate I-6-2 was used instead of Intermediate I-5-2, and 2,5-dimethylaniline was used instead of 2,4,6-trimethylaniline. The obtained compound was confirmed by LC-MS.
LC-MS m/z = 944 (M+H)⁺

### 4) Synthesis of Compound 6

Compound 6 (yield of 30%) was synthesized in the same manner as Compound 3 in Synthesis Example 1, except that Intermediate I-6-1 was used instead of Intermediate I-3-1. The obtained compound was confirmed by LCMS and ¹H NMR.
LC-MS m/z = 1137 (M+H)⁺
¹H NMR (300 MHz, CDCl₃) 8.85(s, 2H), 7.95-7.91 (m, 2H), 7.88-7.73(m, 4H), 7.58-7.22(m, 32H), 7.14(s, 2H), 7.04(s, 1H), 2.31 (s, 6H).

### Synthesis Example 7: Synthesis of Compound 7

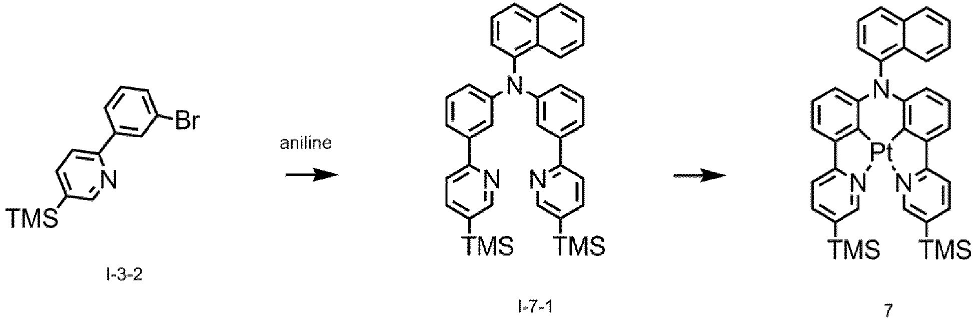

### Synthesis of Intermediate 1-7-1

Intermediate 1-7-1 (yield of 85%) was synthesized in the same manner as Intermediate 1-3-1 in Synthesis Example 1, except that 1-naphthylamine was used instead of 2,4,6-trimethylaniline. The obtained compound was confirmed by LC-MS.
LC-MS m/z = 594 (M+H)⁺

### 2) Synthesis of Compound 7

Compound 7 (yield of 40%) was synthesized in the same manner as Compound 3 in Synthesis Example 1, except that Intermediate I-7-1 was used instead of Intermediate I-3-1. The obtained compound was confirmed by LCMS and ¹H NMR.
LC-MS m/z = 787 (M+H)⁺
¹H NMR (300 MHz, CDCl₃) δ = 8.82(s, 2H), 8.27-8.19(m, 2H), 7.85-7.79(m, 4H), 7.72-7.45 (m, 8H), 6.98-6.94(m, 2H), 0.38(s, 18H).

### Synthesis Example 8: Synthesis of Compound 8

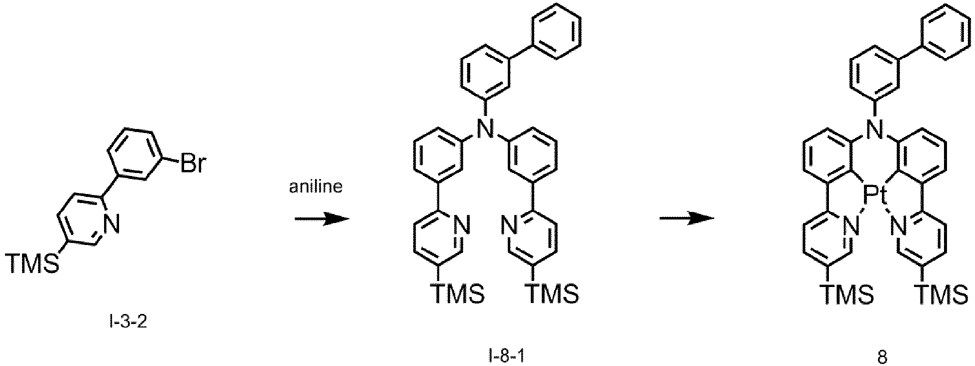

### Synthesis of Intermediate I-8-1

Intermediate I-8-1 (yield of 70%) was synthesized in the same manner as Intermediate I-3-1 in Synthesis Example 1, except that 3-aminobiphenyl was used instead of 2,4,6-trimethylaniline. The obtained compound was confirmed by LC-MS.
LC-MS m/z = 620 (M+H)⁺

### 2) Synthesis of Compound 8

Compound 8 (yield of 25%) was synthesized in the same manner as Compound 3 in Synthesis Example 1, except that Intermediate I-8-1 was used instead of Intermediate I-3-1. The obtained compound was confirmed by LCMS and ¹H NMR.
LC-MS m/z = 813 (M+H)⁺
¹H NMR (300 MHz, CDCl₃) δ = 8.78(s, 2H), 7.82-7.65 (m, 8H), 7.55-7.41 (m, 6H), 7.28-7.22 (m, 3H), 7.17-7.12 (m, 2H), 0.36 (s, 18H).

### Synthesis Example 9: Synthesis of Compound 9

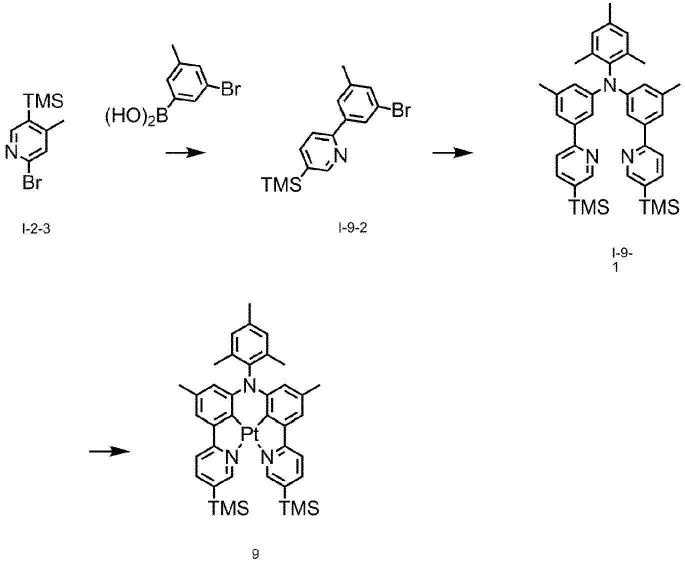

### Synthesis of Intermediate I-9-2

Intermediate I-9-2 (yield of 75%) was synthesized in the same manner as Intermediate I-3-2 in Synthesis Example 1, except that 3-bromo-5-methylphenylboronic acid was used instead of 3-bromophenylboronic acid. The obtained compound was confirmed by LC-MS.
LC-MS m/z = 320 (M+H)⁺

### 2) Synthesis of Intermediate I-9-1

Intermediate I-9-1 (yield of 53%) was synthesized in the same manner as Intermediate I-3-1 in Synthesis Example 1, except that Intermediate I-9-2 was used instead of Intermediate I-3-2. The obtained compound was confirmed by LC-MS.
LC-MS m/z = 614 (M+H)⁺

### 3) Synthesis of Compound 9

Compound 9 (yield of 14%) was synthesized in the same manner as Compound 3 in Synthesis Example 1, except that Intermediate I-9-1 was used instead of Intermediate I-3-1. The obtained compound was confirmed by LCMS and ¹H NMR.
LC-MS m/z = 807 (M+H)⁺
¹H NMR (300 MHz, CDCl₃) δ = 8.85(s, 2H), 7.86-7.60(m, 4H), 7.51(br s, 2), 7.38(br s, 2H), 6.82(s, 2H), 2.28(s, 6H), 2.21(s, 3H), 2.09(s, 6H), 0.35(s, 18H).

### Synthesis Example 10: Synthesis of Compound 10

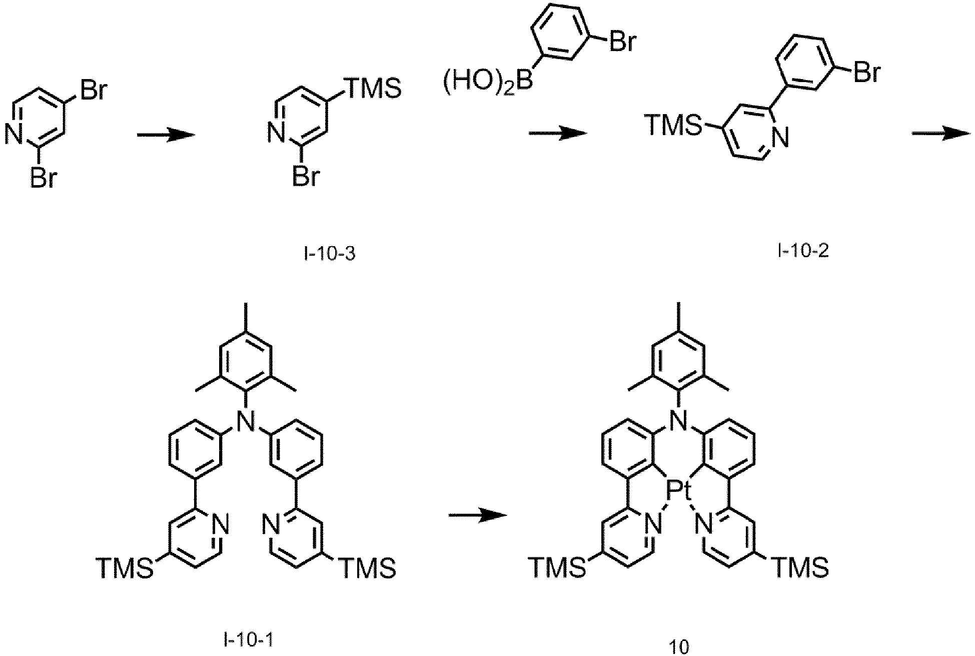

### Synthesis of Intermediate I-10-3

Intermediate I-10-3 (yield of 60%) was synthesized in the same manner as Intermediate I-2-3 in Synthesis Example 3, except that 2,4-dibromopyridine was used instead of 2,5-dibromo-3-methylpyridine. The obtained compound was confirmed by LC-MS.
LC-MS m/z = 230 (M+H)⁺

### 2) Synthesis of Intermediate I-10-2

Intermediate I-10-2 (yield of 70%) was synthesized in the same manner as Intermediate I-9-2 in Synthesis Example 9, except that Intermediate I-10-3 was used instead of Intermediate I-2-3. The obtained compound was confirmed by LC-MS.
LC-MS m/z = 306 (M+H)⁺

### 3) Synthesis of Intermediate I-10-1

Intermediate I-10-1 (yield of 64%) was synthesized in the same manner as Intermediate I-9-1 in Synthesis Example 9, except that Intermediate I-10-2 was used instead of Intermediate I-9-2. The obtained compound was confirmed by LC-MS.
LC-MS m/z = 586 (M+H)⁺

### 4) Synthesis of Compound 10

Compound 10 (yield of 12%) was synthesized in the same manner as Compound 3 in Synthesis Example 1, except that Intermediate I-10-1 was used instead of Intermediate I-3-1. The obtained compound was confirmed by LCMS and ¹H NMR.
LC-MS m/z = 779 (M+H)⁺
¹H NMR (300 MHz, CDCl₃) δ = 8.52(d, 2H), 7.84(d, 2H), 7.75(d, 2H), 7.53-7.50(m, 2), 7.28-7.20 (m, 4H), 6.84(br s, 2H), 2.23(s, 3H), 2.11(s, 6H), 0.33(s, 18H).

### Synthesis Example 11: Synthesis of Compound 11

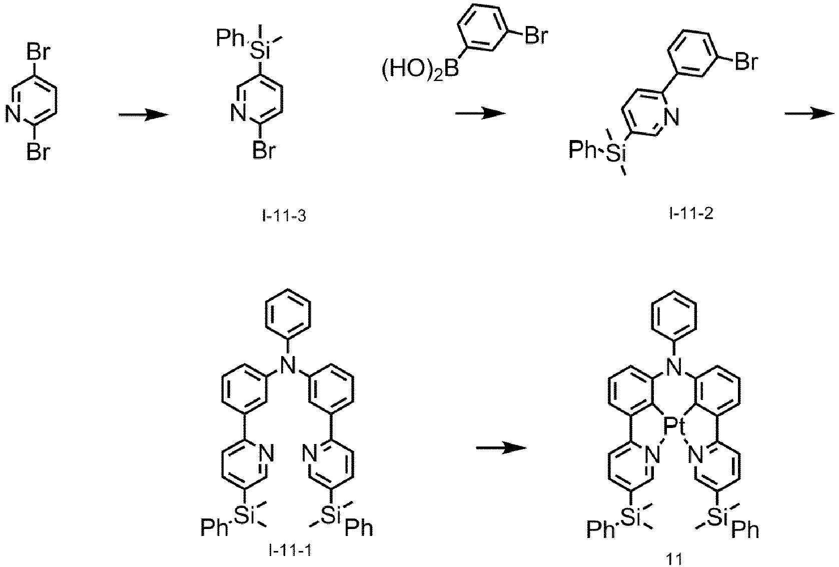

### Synthesis of Intermediate I-11-3

Intermediate I-11-3 (yield of 85%) was synthesized in the same manner as Intermediate I-6-3 in Synthesis Example 6, except that chloro(dimethyl)phenylsilane was used instead of chlorotriphenylsilane. The obtained compound was confirmed by LC-MS.
LC-MS m/z = 292 (M+H)⁺

### 2) Synthesis of Intermediate I-11-2

Intermediate I-11-2 (yield of 75%) was synthesized in the same manner as Intermediate I-6-2 in Synthesis Example 6, except that Intermediate I-11-3 was used instead of Intermediate I-6-3. The obtained compound was confirmed by LC-MS.
LC-MS m/z = 368 (M+H)⁺

### 3) Synthesis of Intermediate I-11-1

Intermediate I-11-1 (yield of 55%) was synthesized in the same manner as Intermediate I-6-1 in Synthesis Example 6, except that Intermediate I-11-2 was used instead of Intermediate I-6-2. The obtained compound was confirmed by LC-MS.
LC-MS m/z = 668 (M+H)⁺

### 4) Synthesis of Compound 11

Compound 11 (yield of 33%) was synthesized in the same manner as Compound 6 in Synthesis Example 6, except that Intermediate I-11-1 was used instead of Intermediate I-6-1. The obtained compound was confirmed by LCMS and ¹H NMR.
LC-MS m/z = 861 (M+H)⁺
¹H NMR (300 MHz, CDCl₃) δ = 8.89(d, 2H), 7.86-7.84(m, 2H), 7.80-7.71(m, 2H), 7.55-7.51 (m, 2), 7.36-7.20 (m, 14H), 7.12-7.05(m, 3H), 0.71(s, 12H).

### Synthesis Example 12: Synthesis of Compound 12

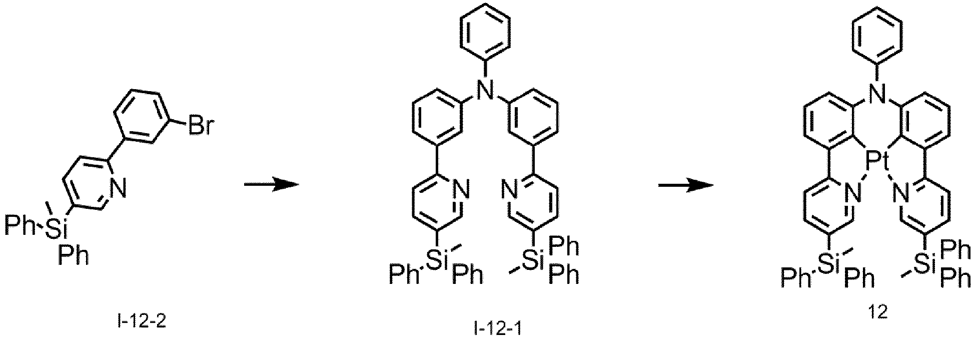

### Synthesis of Intermediate I-12-2

Intermediate I-12-2 was synthesized in the same manner as Intermediate I-11-3 and Intermediate I-11-2 in Synthesis Example 11, except that chloro(methyl)diphenylsilane was used instead of chloro(dimethyl)phenylsilane. The obtained compound was confirmed by LC-MS.
LC-MS m/z = 430 (M+H)⁺

### 2) Synthesis of Intermediate I-12-1

Intermediate I-12-1 (yield of 62%) was synthesized in the same manner as Intermediate 1-11-1 in Synthesis Example 11, except that Intermediate I-12-2 was used instead of Intermediate I-11-2. The obtained compound was confirmed by LC-MS.
LC-MS m/z = 792 (M+H)⁺

### 3) Synthesis of Compound 12

Compound 12 (yield of 20%) was synthesized in the same manner as Compound 11 in Synthesis Example 11, except that Intermediate I-12-1 was used instead of Intermediate I-11-1. The obtained compound was confirmed by LCMS and ¹H NMR.
LC-MS m/z = 985 (M+H)⁺
¹H NMR (300 MHz, CDCl₃) δ = 8.82(br s, 2H), 8.01-7.98(m, 2H), 7.82-7.76(m, 4H), 7.61-7.37(m, 22H), 7.28-7.24(m, 4H), 7.11-7.06(m, 3H), 0.68(s, 6H).

### Synthesis Example 13: Synthesis of Compound 13

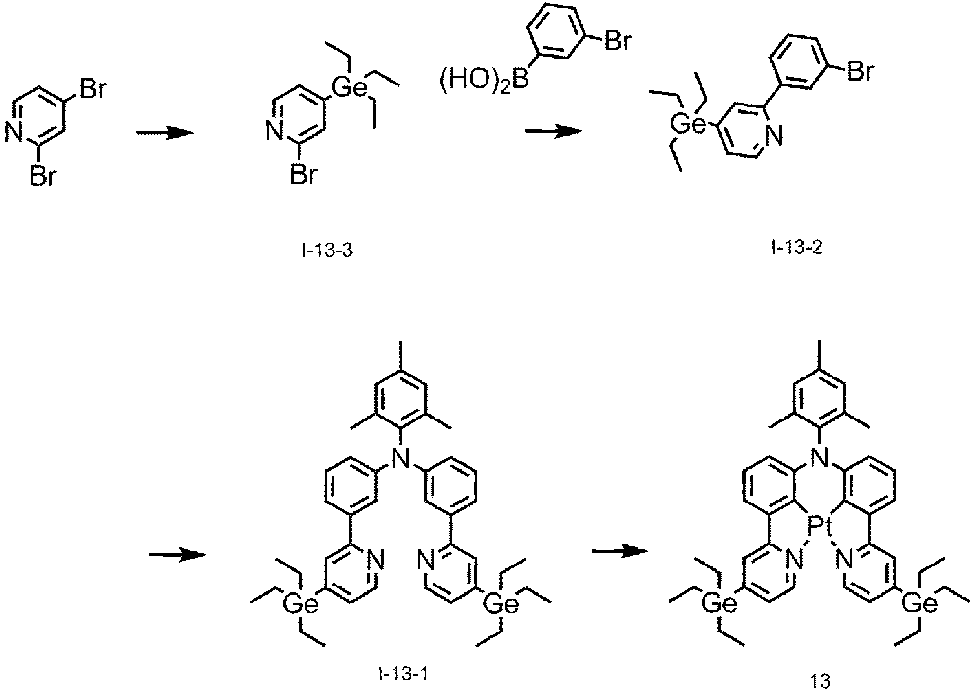

### Synthesis of Intermediate 1-13-3

Intermediate 1-13-3 (yield of 85%) was synthesized in the same manner as Intermediate I-10-3 in Synthesis Example 10, except that chlorotriethylgermane was used instead of chlorotrimethylsilane. The obtained compound was confirmed by LC-MS.
LC-MS m/z = 318 (M+H)⁺

### 2) Synthesis of Intermediate I-13-2

Intermediate I-13-2 (yield of 70%) was synthesized in the same manner as Intermediate I-10-2 in Synthesis Example 10, except that Intermediate 1-13-3 was used instead of Intermediate I-10-3. The obtained compound was confirmed by LC-MS.
LC-MS m/z = 394 (M+H)⁺

### 3) Synthesis of Intermediate I-13-1

Intermediate I-13-1 (yield of 55%) was synthesized in the same manner as Intermediate I-10-1 in Synthesis Example 10, except that Intermediate I-13-2 was used instead of Intermediate I-10-2. The obtained compound was confirmed by LC-MS.
LC-MS m/z = 762 (M+H)⁺

### 4) Synthesis of Compound 13

Compound 13 (yield of 10%) was synthesized in the same manner as Compound 3 in Synthesis Example 1, except that Intermediate I-13-1 was used instead of Intermediate I-3-1. The obtained compound was confirmed by LCMS and ¹H NMR.
LC-MS m/z = 955 (M+H)⁺
¹H NMR (300 MHz, CDCl₃) δ = 8.64(d, 2H), 7.88(d, 2H), 7.82-7.79(m, 2H), 7.52(s, 2H), 7.28-7.22(m, 2H), 6.91(d, 2H), 6.96(br s, 2H), 2.26(s, 3H), 2.08(s, 6H), 1.04(q, 12H), 0.90(t, 18H).

### Synthesis Example 14: Synthesis of Compound 14

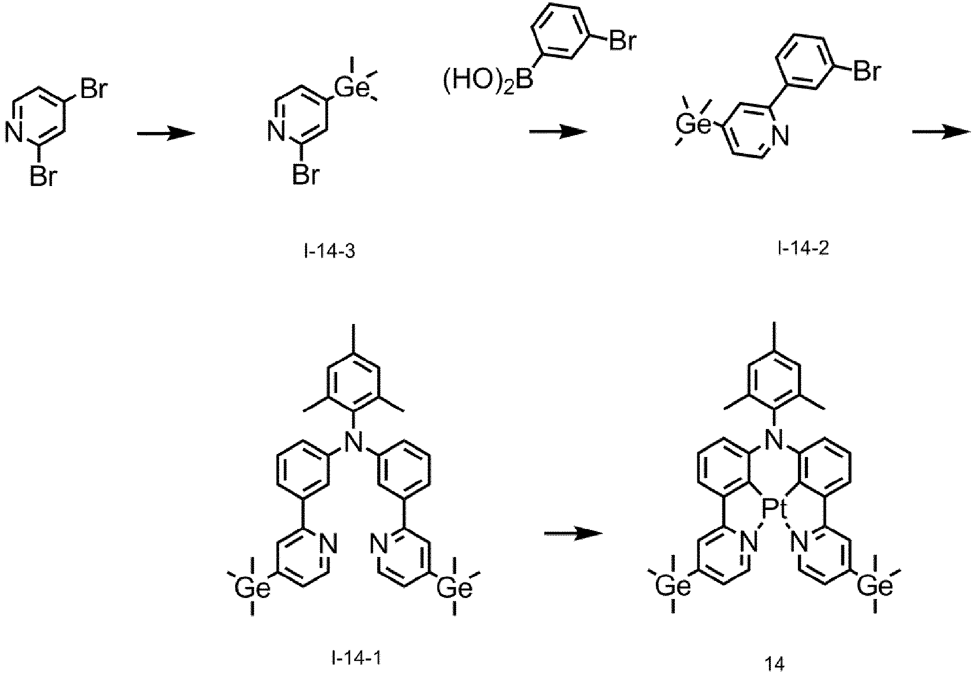

### Synthesis of Intermediate I-14-1

Intermediate I-14-1 was synthesized in the same manner as Intermediates I-13-3, I-13-2, and I-13-1 in Synthesis Example 13, except that chlorotrimethylgermane was used instead of chlorotriethylgermane. The obtained compound was confirmed by LC-MS.
LC-MS m/z = 678 (M+H)⁺

### 2) Synthesis of Compound 14

Compound 14 (yield of 15%) was synthesized in the same manner as Compound 13 in Synthesis Example 13, except that Intermediate I-14-1 was used instead of Intermediate I-13-1. The obtained compound was confirmed by LCMS and ¹H NMR.
LC-MS m/z = 871 (M+H)⁺
¹H NMR (300 MHz, CDCl₃) δ = 8.57(d, 2H), 7.86(d, 2H), 7.80-7.76(m, 2H), 7.51(s, 2H), 7.25(br s, 2H), 6.88(br s, 2H), 6.80(s, 2H), 2.23(s, 3H), 2.11(s, 6H), 0.83(t, 18H).

### Synthesis Example 15: Synthesis of Compound 15

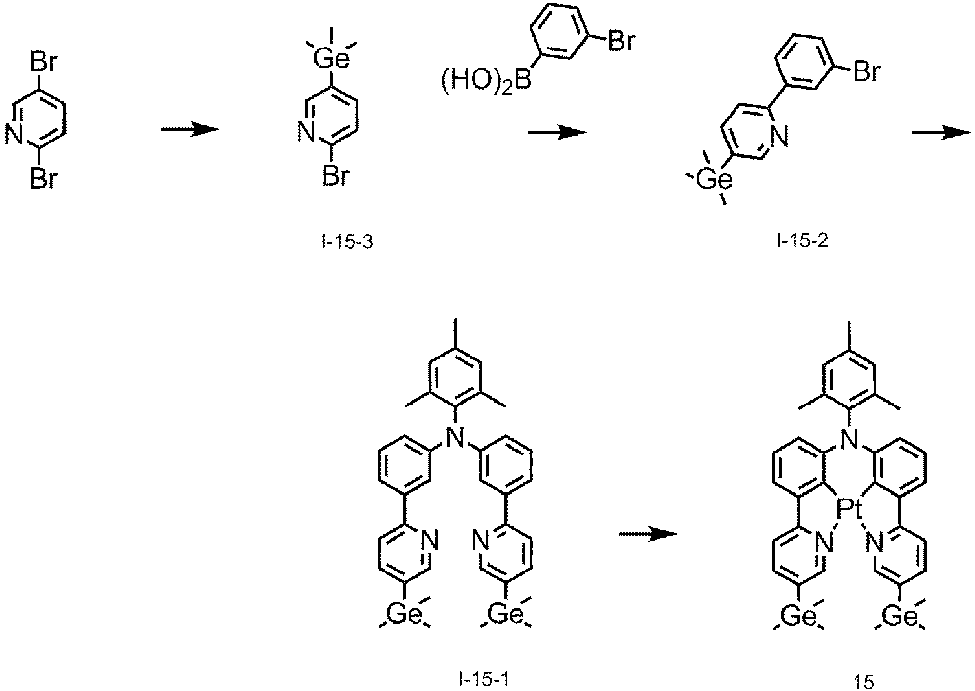

### Synthesis of Intermediate I-15-1

Intermediate I-15-1 was synthesized in the same manner as Intermediates I-5-3, I-5-2, and I-5-1 in Synthesis Example 5, except that chlorotrimethylgermane was used instead of chlorotriethylsilane. The obtained compound was confirmed by LC-MS.
LC-MS m/z = 678 (M+H)⁺

### 2) Synthesis of Compound 15

Compound 15 (yield of 25%) was synthesized in the same manner as Compound 5 in Synthesis Example 5, except that Intermediate I-15-1 was used instead of Intermediate I-5-1. The obtained compound was confirmed by LCMS and ¹H NMR.
LC-MS m/z = 871 (M+H)⁺
¹H NMR (300 MHz, CDCl₃) δ = 8.47(br s, 2H), 7.84-7.78(m, 4H), 7.61(br s, 2H), 7.36-7.21(m, 4H), 6.76(s, 2H), 2.21(s, 3H), 2.09(s, 6H), 0.79(s, 18H).

### Synthesis Example 16: Synthesis of Compound 16

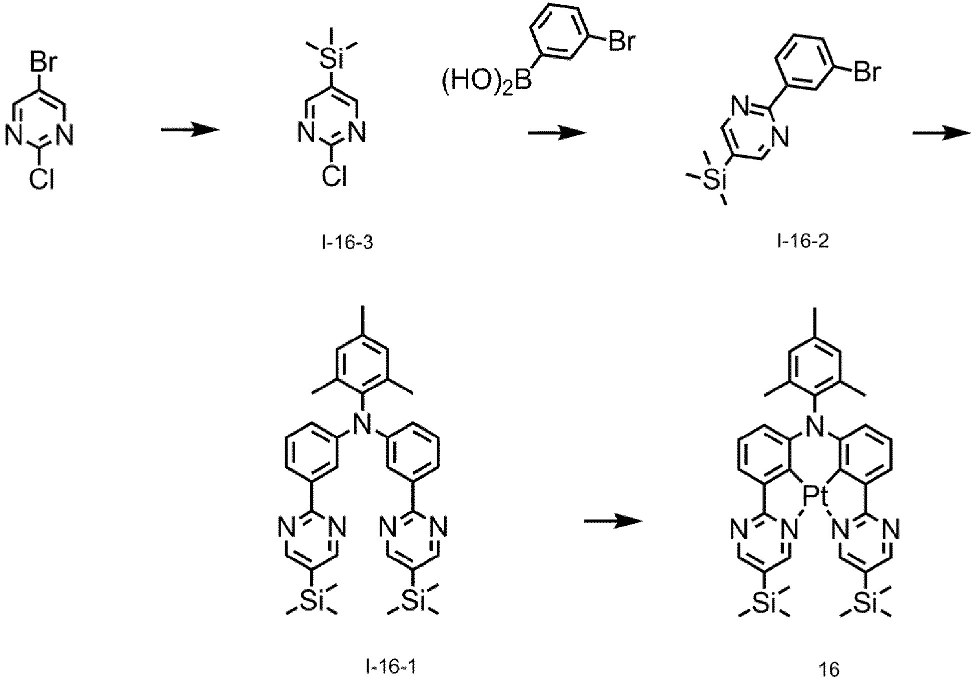

### Synthesis of Intermediate 1-16-3

Intermediate 1-16-3 (yield of 55%) was synthesized in the same manner as Intermediate I-5-3 in Synthesis Example 5, except that 5-bromo-2-chloropyrimidine was used instead of 2,5-dibromopyridine. The obtained compound was confirmed by LC-MS.
LC-MS m/z = 187 (M+H)⁺

### 2) Synthesis of Intermediate I-16-2

Intermediate I-16-2 (yield of 75%) was synthesized in the same manner as Intermediate I-5-2 in Synthesis Example 5, except that Intermediate 1-16-3 was used instead of Intermediate I-5-3. The obtained compound was confirmed by LC-MS.
LC-MS m/z = 307 (M+H)⁺

### 3) Synthesis of Intermediate I-16-1

Intermediate I-16-1 (yield of 80%) was synthesized in the same manner as Intermediate I-5-1 in Synthesis Example 5, except that Intermediate I-16-2 was used instead of Intermediate I-5-2. The obtained compound was confirmed by LC-MS.
LC-MS m/z = 588 (M+H)⁺

### 3) Synthesis of Compound 16

5.0 g (8.5 mmol) of Intermediate I-16-1 and 300 ml of acetic acid were added to a reactor at a temperature of 25°C. Then, 3.5 g (8.5 mmol) of K₂PtCl₄ was added thereto, and the mixture was heated under reflux for 48 hours. Once the reaction was completed, the mixture was concentrated under reduced pressure, and re-crystallized using dichloromethane and methanol to obtain 0.5 g (0.8 mmol, yield of 8%) of Compound 16. The obtained compound was confirmed by LC-MS.
LC-MS m/z = 781 (M+H)⁺

### Synthesis Example 17: Synthesis of Compound 17

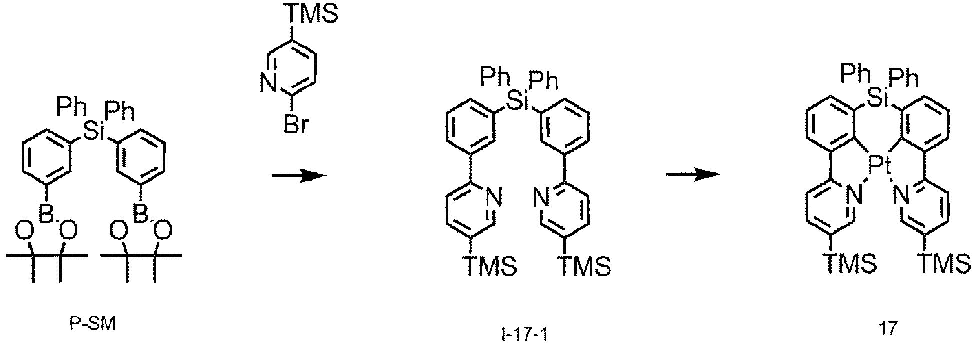

### Synthesis of Intermediate I-17-1

30.0 g (51.0 mmol) of P-SM (a compound prepared in response to an order, Medigen, Inc., www.medi-gen.net), 600 ml of tetrahydrofuran, and 300 ml of distilled water were added to a reactor. 28.1 g (122.4 mmol) of 2-bromo-5-(trimethylsilyl)pyridine, 5.9 g (5.1 mmol) of Pd(PPh₃)₄, and 21.1 g (153.0 mmol) of K₂CO₃ were added thereto, and the mixture was heated under reflux at a temperature of 80°C for 18 hours. Once the reaction was completed, the mixture was extracted using 400 ml of ethyl acetate and 100 ml of distilled water. The organic layer obtained therefrom was dried using magnesium sulfate and distilled under reduced pressure. The residue was purified by liquid chromatography to obtain 24.0 g (38 mmol, yield of 75%) of Intermediate I-17-1.
LC-MS m/z = 635 (M+H)⁺

### 2) Synthesis of Compound 17

Compound 17 (yield of 35%) was synthesized in the same manner as Compound 3 in Synthesis Example 1, except that Intermediate I-17-1 was used instead of Intermediate I-3-1. The obtained compound was confirmed by LCMS and ¹H NMR.
LC-MS m/z = 828 (M+H)⁺
¹H NMR (300 MHz, CDCl₃) δ = 8.81(br s, 2H), 8.37(br s, 2H), 7.85(br s, 2H), 7.72-7.58(m, 4H), 7.46-7.44(m, 2H), 7.42-7.32(m, 10H), 0.42(s, 18H).

### Synthesis Example 18: Synthesis of Compound 18

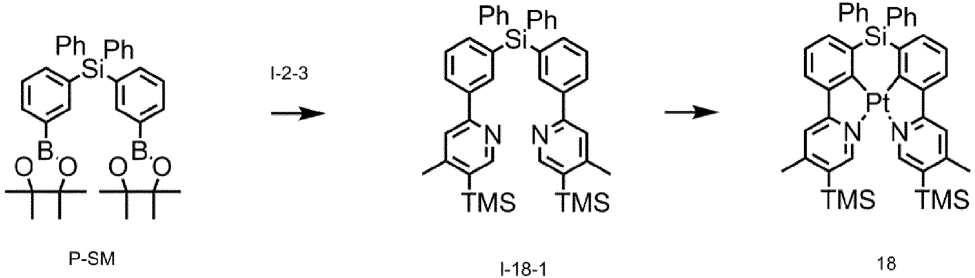

### Synthesis of Intermediate I-18-1

Intermediate I-18-1 (yield of 60%) was synthesized in the same manner as Intermediate I-17-1 in Synthesis Example 17, except that Intermediate I-2-3 was used instead of 2-bromo-5-(trimethylsilyl)pyridine. The obtained compound was confirmed by LC-MS.
LC-MS m/z = 663 (M+H)⁺

### 2) Synthesis of Compound 18

Compound 18 (yield of 20%) was synthesized in the same manner as Compound 17 in Synthesis Example 17, except that Intermediate I-18-1 was used instead of Intermediate I-17-1. The obtained compound was confirmed by LCMS and ¹H NMR.
LC-MS m/z = 856 (M+H)⁺
¹H NMR (300 MHz, CDCl₃) δ = 8.79(br s, 2H), 8.26(br s, 2H), 7.88(s, 2H), 7.64-7.56(m, 4H), 7.46-7.38(m, 10H), 2.36(s, 6H), 0.77(s, 18H).

### Synthesis Example 19: Synthesis of Compound 20

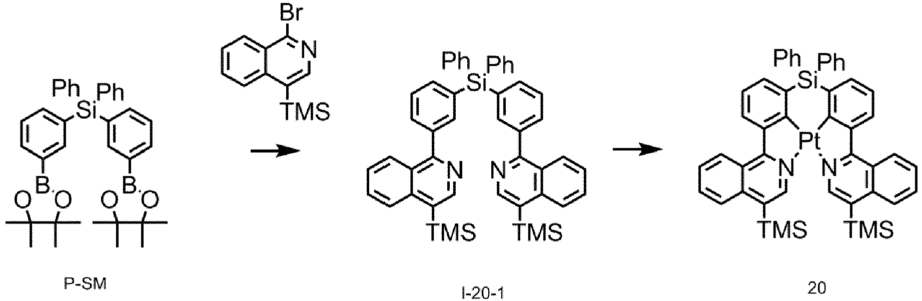

### Synthesis of Intermediate I-20-1

Intermediate I-20-1 (yield of 53%) was synthesized in the same manner as Intermediate I-18-1 in Example 18, except that 1-bromo-4-(trimethylsilyl)isoquinoline (a compound prepared in response to an order, HANCHEM CO., LTD., www.hanchem.co.kr) was used instead of Intermediate I-2-3. The obtained compound was confirmed by LC-MS.
LC-MS m/z = 735 (M+H)⁺

### 2) Synthesis of Compound 20

Compound 20 (yield of 10%) was synthesized in the same manner as Compound 17 in Synthesis Example 17, except that Intermediate I-20-1 was used instead of Intermediate I-17-1. The obtained compound was confirmed by LC-MS.
LC-MS m/z = 927 (M+H)⁺

### Synthesis Example 20: Synthesis of Compound 21

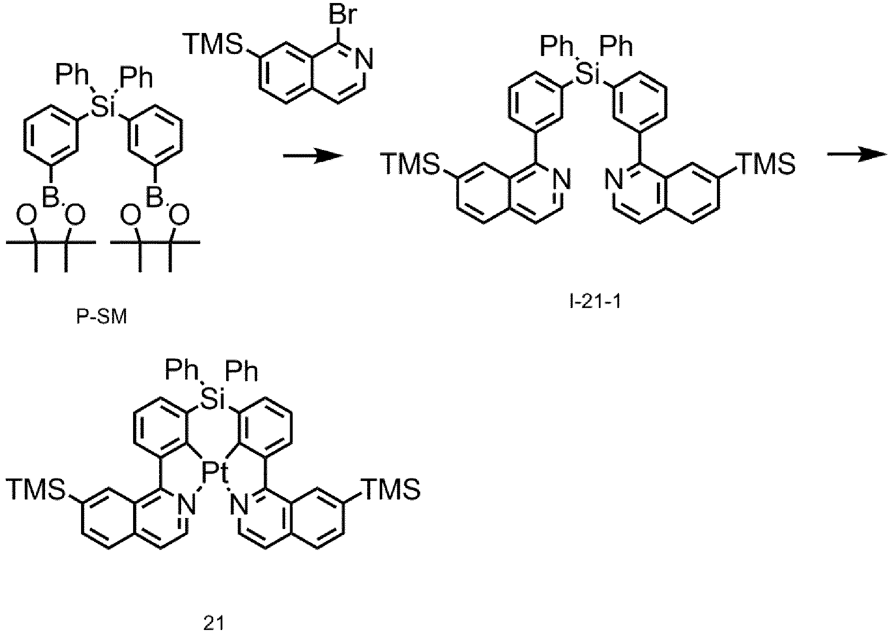

### Synthesis of Intermediate 1-21-1

Intermediate I-21-1 (yield of 50%) was synthesized in the same manner as Intermediate I-18-1 in Example 18, except that 1-bromo-7-(trimethylsilyl)isoquinoline (a compound prepared in response to an order, HANCHEM CO., LTD., www.hanchem.co.kr) was used instead of Intermediate I-2-3. The obtained compound was confirmed by LC-MS.
LC-MS m/z = 735 (M+H)⁺

### 2) Synthesis of Compound 21

Compound 21 (yield of 7%) was synthesized in the same manner as Compound 17 in Synthesis Example 17, except that Intermediate I-20-1 was used instead of Intermediate I-17-1. The obtained compound was confirmed by LC-MS.
LC-MS m/z = 927 (M+H)⁺

### Synthesis Example 21: Synthesis of Compound 22

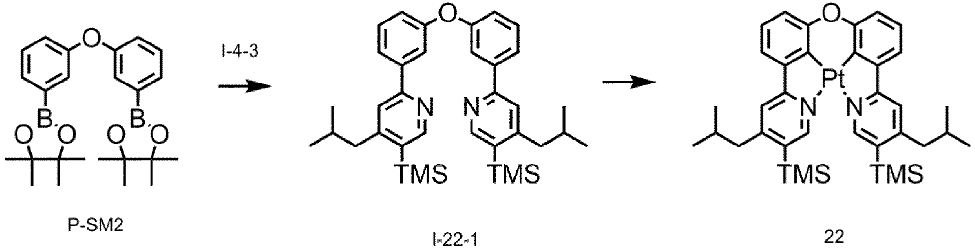

### Synthesis of Intermediate I-22-1

Intermediate I-22-1 (yield of 62%) was synthesized in the same manner as Intermediate I-17-1 in Example 17, except that P-SM2 (a compound prepared in response to an order, Medigen, Inc., www.medi-gen.net) was used instead of P-SM, and Intermediate I-4-3 was used instead of Intermediate I-2-3. The obtained compound was confirmed by LC-MS.
LC-MS m/z = 581 (M+H)⁺

### 2) Synthesis of Compound 22

Compound 22 (yield of 22%) was synthesized in the same manner as Compound 17 in Synthesis Example 17, except that Intermediate I-22-1 was used instead of Intermediate I-17-1. The obtained compound was confirmed by and ¹H NMR.
LC-MS m/z = 774 (M+H)⁺
¹H NMR (300 MHz, CDCl₃) δ = 8.86(br s, 2H), 7.95(d, 2H), 7.83(br s, 2H), 7.52-7.48(m, 2H), 7.33-7.25(m, 2H), 3.16(d, 4H), 1.96-1.93(m, 2H), 1.00(d, 12H), 0.41(s, 18H).

### Synthesis Example 22: Synthesis of Compound 23

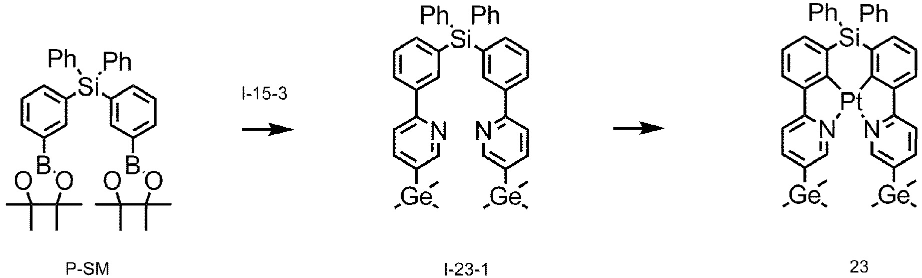

### Synthesis of Intermediate I-23-1

Intermediate I-23-1 (yield of 76%) was synthesized in the same manner as Intermediate I-18-1 in Synthesis Example 18, except that Intermediate 1-15-3 was used instead of Intermediate I-2-3. The obtained compound was confirmed by LC-MS.
LC-MS m/z = 727 (M+H)⁺

### 2) Synthesis of Compound 23

Compound 23 (yield of 21%) was synthesized in the same manner as Compound 17 in Synthesis Example 17, except that Intermediate I-23-1 was used instead of Intermediate I-17-1. The obtained compound was confirmed by LCMS and ¹H NMR.
LC-MS m/z = 920 (M+H)⁺
¹H NMR (300 MHz, CDCl₃) δ = 8.42(s, 2H), 8.15(br s, 2H), 7.78(br s, 2H), 7.68-7.61 (m, 2H), 7.58-7.54(m, 2H), 7.46-7.32(m, 10H), 0.72(s, 18H).

### Synthesis Example 23: Synthesis of Compound 24

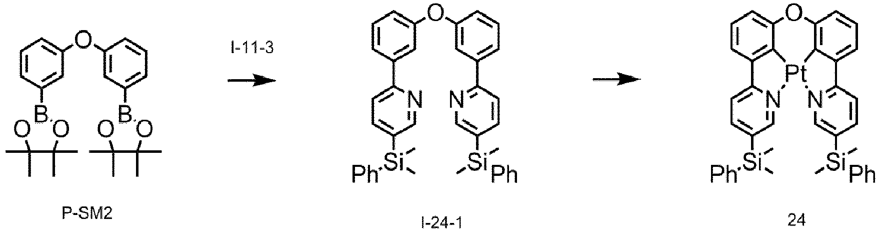

### Synthesis of Intermediate I-24-1

Intermediate I-24-1 (yield of 70%) was synthesized in the same manner as Intermediate I-22-1 in Synthesis Example 21, except that Intermediate I-11-3 was used instead of Intermediate I-4-3. The obtained compound was confirmed by LC-MS.
LC-MS m/z = 593 (M+H)⁺

### 2) Synthesis of Compound 24

Compound 24 (yield of 25%) was synthesized in the same manner as Compound 22 in Synthesis Example 21, except that Intermediate I-24-1 was used instead of Intermediate I-22-1. The obtained compound was confirmed by LCMS and ¹H NMR.
LC-MS m/z = 786 (M+H)⁺
¹H NMR (300 MHz, CDCl₃) δ = 8.82(s, 2H), 7.93-7.77(m, 4H), 7.69-7.64(m, 2H), 7.43-7.34(m, 2H), 7.31-7.21(m, 10H), 7.15-7.10(m, 2H), 0.67(s, 12H).

### Synthesis Example 24: Synthesis of Compound 25

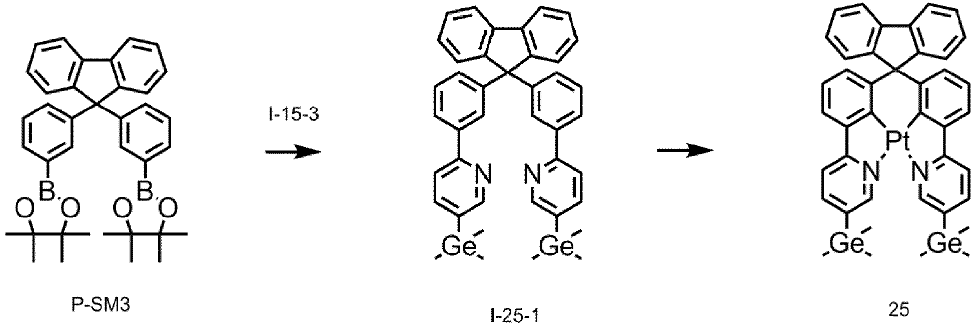

### Synthesis of Intermediate I-25-1

Intermediate I-25-1 (yield of 83%) was synthesized in the same manner as Intermediate I-23-1 in Synthesis Example 22, except that P-SM3 (a compound prepared in response to an order, HANCHEM CO., LTD., www.hanchem.co.kr) was used instead of P-SM. The obtained compound was confirmed by LC-MS.
LC-MS m/z = 709 (M+H)⁺

### 2) Synthesis of Compound 25

Compound 25 (yield of 36%) was synthesized in the same manner as Compound 23 in Synthesis Example 22, except that Intermediate I-25-1 was used instead of Intermediate I-23-1. The obtained compound was confirmed by LCMS and ¹H NMR.
LC-MS m/z = 902 (M+H)⁺
¹H NMR (300 MHz, CDCl₃) δ = 8.41(s, 2H), 8.11 (d, 2H), 8.00-7.97(m, 2H), 7.85-7.82(m, 2H), 7.53-7.38(m, 4H), 7.37-7.32(m, 4H), 7.28-7.22(m, 2H), 0.72(s, 18H).

### Synthesis Example 25: Synthesis of Compound 26

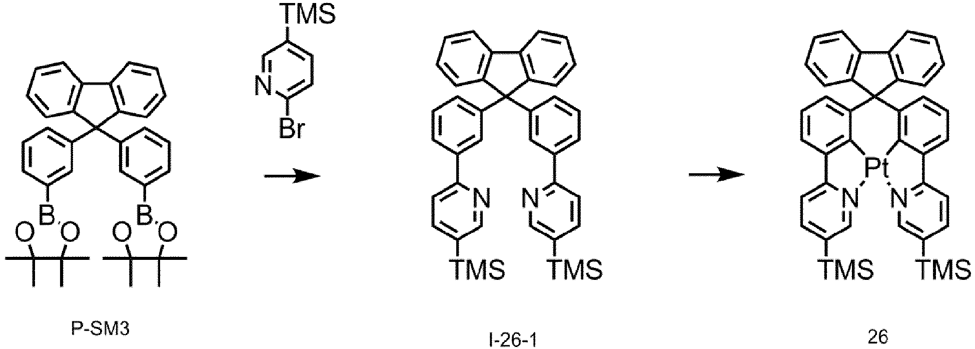

### Synthesis of Intermediate I-26-1

Intermediate I-26-1 (yield of 75%) was synthesized in the same manner as Intermediate I-25-1 in Synthesis Example 24, except that 2-bromo-5-(trimethylsilyl)pyridine was used instead of Intermediate I-15-3. The obtained compound was confirmed by LC-MS.
LC-MS m/z = 617 (M+H)⁺

### 2) Synthesis of Compound 26

Compound 26 (yield of 30%) was synthesized in the same manner as Compound 25 in Synthesis Example 24, except that Intermediate I-26-1 was used instead of Intermediate I-25-1. The obtained compound was confirmed by LCMS and ¹H NMR.
LC-MS m/z = 810 (M+H)⁺
¹H NMR (300 MHz, CDCl₃) δ = 8.75(br s, 2H), 8.08 (d, 2H), 7.94-7.90(m, 2H), 7.84(d, 2H), 7.70-7.64(m, 2H), 7.55-7.51(m, 4H), 7.38-7.35(m, 2H), 7.28-7.24(m, 4H), 0.42(s, 18H).

### Synthesis Example 26: Synthesis of Compound 27

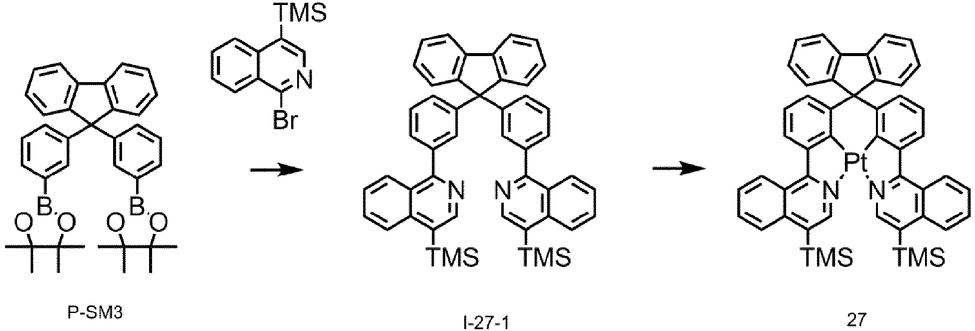

### Synthesis of Intermediate I-27-1

Intermediate I-27-1 (yield of 52%) was synthesized in the same manner as Intermediate I-25-1 in Synthesis Example 24, except that 1-bromo-4-(trimethylsilyl)isoquinoline (a compound prepared in response to an order, HANCHEM CO., LTD., www.hanchem.co.kr) was used instead of Intermediate I-15-3. The obtained compound was confirmed by LC-MS.
LC-MS m/z = 717 (M+H)⁺

### 2) Synthesis of Compound 27

Compound 27 (yield of 8%) was synthesized in the same manner as Compound 25 in Synthesis Example 24, except that Intermediate I-27-1 was used instead of Intermediate I-25-1. The obtained compound was confirmed by LC-MS.
LC-MS m/z = 909 (M+H)⁺

### Synthesis Example 27: Synthesis of Compound 28

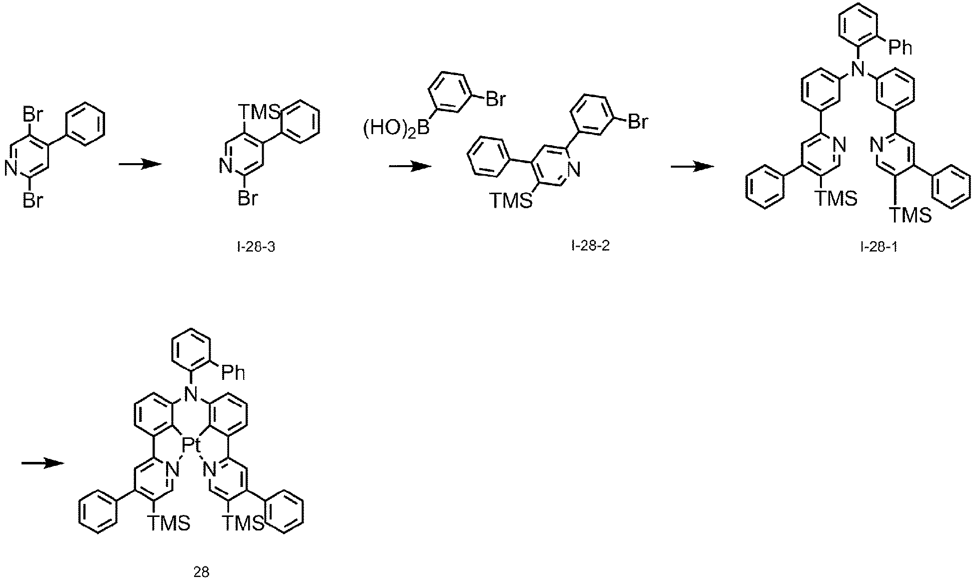

### Synthesis of Intermediate I-28-3

Intermediate I-28-3 (yield of 75%) was synthesized in the same manner as Intermediate I-5-3 in Synthesis Example 5, except that 2,5-dibromo-4-phenylpyridine was used instead of 2,5-dibromopyridine. The obtained compound was confirmed by LC-MS.
LC-MS m/z = 306 (M+H)⁺

### 2) Synthesis of Intermediate I-28-2

Intermediate I-28-2 (yield of 70%) was synthesized in the same manner as Intermediate I-5-2 in Synthesis Example 5, except that Intermediate I-28-3 was used instead of Intermediate I-5-3. The obtained compound was confirmed by LC-MS.
LC-MS m/z = 382 (M+H)⁺

### 3) Synthesis of Intermediate I-28-1

Intermediate I-28-1 (yield of 60%) was synthesized in the same manner as Intermediate I-5-1 in Synthesis Example 5, except that Intermediate I-28-2 was used instead of Intermediate I-5-2, and 2-aminobiphenyl was used instead of 2,4,6-trimethylaniline. The obtained compound was confirmed by LC-MS.
LC-MS m/z = 772 (M+H)⁺

### 3) Synthesis of Compound 28

2.8 g (3.6 mmol) of Intermediate I-28-1 and 100 ml of benzonitrile were added to a reactor at a temperature of 25°C. Then, 1.7 g (3.6 mmol) of PtCl₂(NCPh)₂ was added thereto, and the resulting mixture was stirred for 16 hours at 130°C. Once the reaction was completed, the mixture was concentrated under reduced pressure, and purified by column chromatography to obtain 0.9 g (0.9 mmol, yield of 26%) of Compound 28. The obtained compound was confirmed by LC-MS.
LC-MS m/z = 965 (M+H)⁺

### Synthesis Example 28: Synthesis of Compound 29

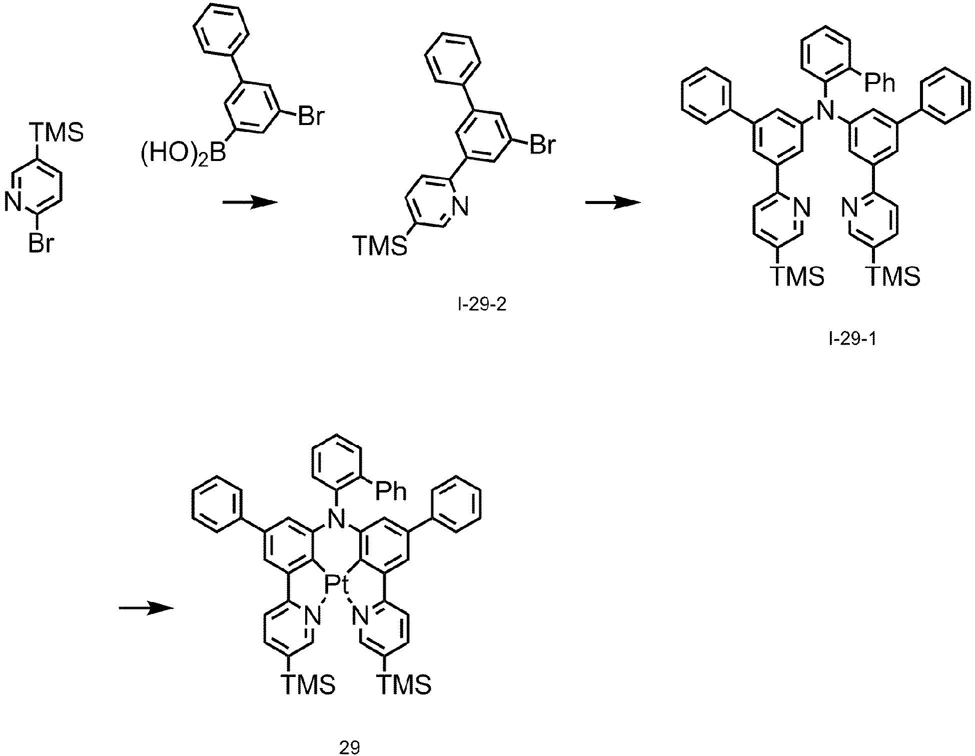

### Synthesis of Intermediate I-29-2

Intermediate I-29-2 (yield of 70%) was synthesized in the same manner as Intermediate I-3-2 in Synthesis Example 1, except that (5-bromo-[1,1'-biphenyl]-3-yl)boronic acid was used instead of 3-bromophenylboronic acid. The obtained compound was confirmed by LC-MS.
LC-MS m/z = 382 (M+H)⁺

### 2) Synthesis of Intermediate I-29-1

Intermediate I-29-1 (yield of 75%) was synthesized in the same manner as Intermediate I-3-1 in Synthesis Example 1, except that Intermediate I-29-2 was used instead of Intermediate I-3-2, and 2-aminobiphenyl was used instead of 2,4,6-trimethylaniline. The obtained compound was confirmed by LC-MS.
LC-MS m/z = 772 (M+H)⁺

### 3) Synthesis of Compound 29

Compound 29 (yield of 25%) was synthesized in the same manner as Compound 28 in Synthesis Example 27, except that Intermediate I-29-1 was used instead of Intermediate I-28-1. The obtained compound was confirmed by LCMS and ¹H NMR.
LC-MS m/z = 965 (M+H)⁺
¹H NMR (300 MHz, CD₂Cl₂) δ = 9.05(s, 2H), 8.07(s, 4H), 7.68-7.65(m, 1H), 7.64-7.62(m, 4H), 7.51-7.48(m, 4H), 7.42-7.31(m, 9H), 7.13-7.11(m, 3H), 6.65(s, 2H), 0.48(s, 18H).

### Synthesis Example 29: Synthesis of Compound 30

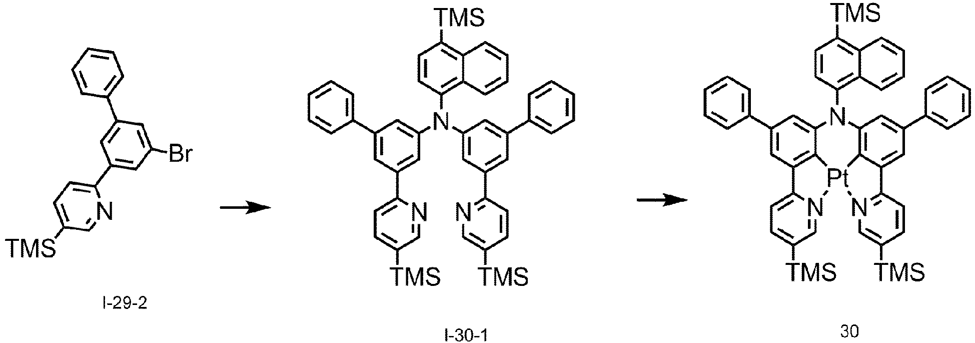

### Synthesis of Intermediate I-30-1

Intermediate I-30-1 (yield of 70%) was synthesized in the same manner as Intermediate I-29-1 in Synthesis Example 28, except that 4-(trimethylsilyl)naphthalene-1-amine was used instead of 2-aminobiphenyl. The obtained compound was confirmed by LC-MS.
LC-MS m/z = 818 (M+H)⁺

### 2) Synthesis of Compound 30

Compound 30 (yield of 17%) was synthesized in the same manner as Compound 28 in Synthesis Example 27, except that Intermediate I-30-1 was used instead of Intermediate I-28-1. The obtained compound was confirmed by LC-MS.
LC-MS m/z = 1011 (M+H)⁺

### Synthesis Example 30: Synthesis of Compound 31

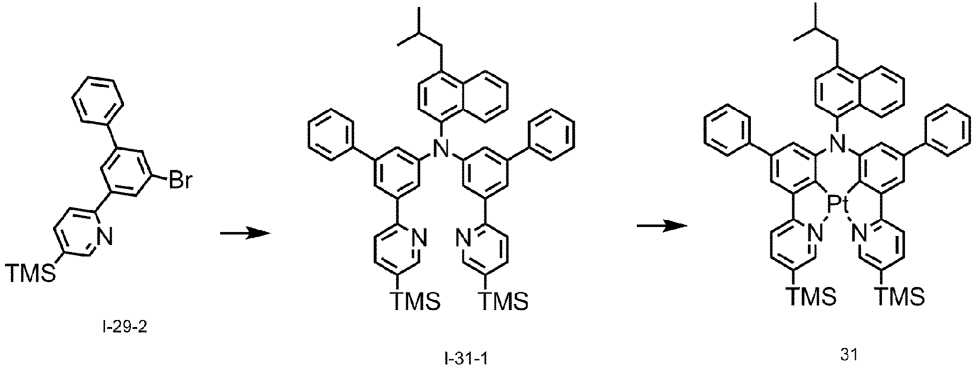

### Synthesis of Intermediate 1-31-1

Intermediate I-31-1 (yield of 75%) was synthesized in the same manner as Intermediate I-29-1 in Synthesis Example 28, except that 4-isobutylnaphthalene-1-amine was used instead of 2-aminobiphenyl. The obtained compound was confirmed by LC-MS.
LC-MS m/z = 802 (M+H)⁺

### 2) Synthesis of Compound 31

Compound 31 (yield of 15%) was synthesized in the same manner as Compound 28 in Synthesis Example 27, except that Intermediate I-31-1 was used instead of Intermediate I-28-1. The obtained compound was confirmed by LCMS and ¹H NMR.
LC-MS m/z = 995 (M+H)⁺
¹H NMR (300 MHz, CD₂Cl₂) δ = 9.04(s, 2H), 8.52(br s, 1H), 8.36-8.34(m, 3H), 7.75-7.69(m, 8H), 7.49-7.41(m, 8H), 7.38-7.36(m, 2H), 7.29(br s, 1H), 6.84(s, 1H), 2.86(d, 2H), 1.86(q, 1H), 0.91(d, 6H).

### Synthesis Example 31: Synthesis of Compound 32

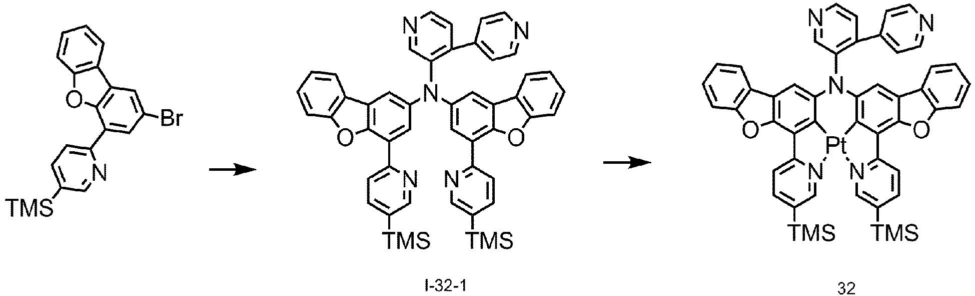

### Synthesis of Intermediate I-32-1

Intermediate I-32-1 (yield of 50%) was synthesized in the same manner as Intermediate I-29-1 in Synthesis Example 28, except that 2-(2-bromodibenzo[b,d]furan-4-yl)-5-(trimethylsilyl)pyridine was used instead of Intermediate I-29-2, and [4,4'-bi pyridine]-3-amine was used instead of 2-aminobiphenyl. The obtained compound was confirmed by LC-MS.
LC-MS m/z = 802 (M+H)⁺

### 2) Synthesis of Compound 32

Compound 32 (yield of 13%) was synthesized in the same manner as Compound 28 in Synthesis Example 27, except that Intermediate I-32-1 was used instead of Intermediate I-28-1. The obtained compound was confirmed by LCMS and ¹H NMR.
LC-MS m/z = 995 (M+H)⁺
¹H NMR (300 MHz, CD₂Cl₂) δ = 9.18(s, 2H), 8.92(d, 2H), 8.65 (d, 1H), 8.42 (s, 2H), 8.23(s, 1H), 8.01-7.97(m, 3H), 7.80-7.77(m, 3H), 7.61(d, 2H), 7.54(d, 2H), 7.39-7.31(m, 4H).

### Synthesis Example 32: Synthesis of Compound 33

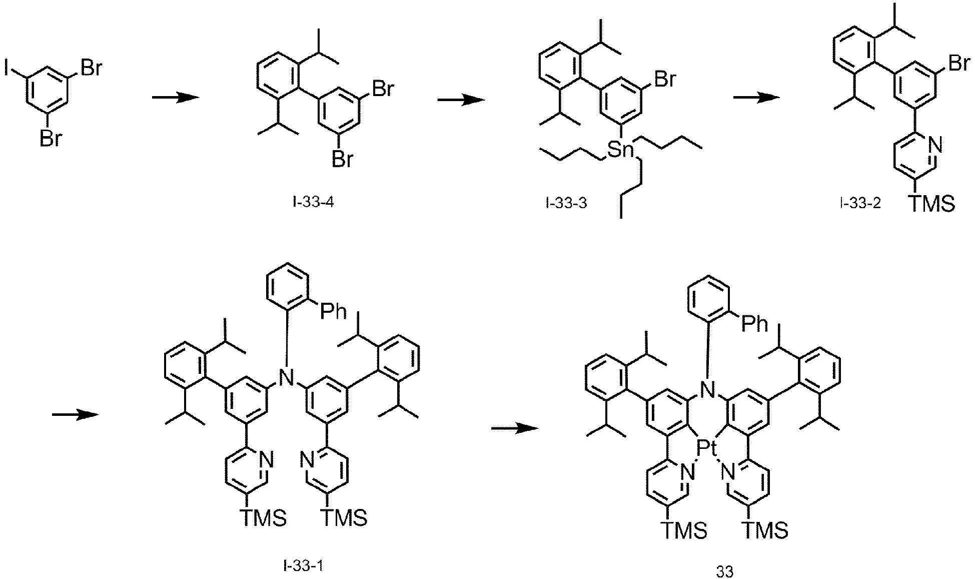

### Synthesis of Intermediate I-33-4

9.1 g (25.3 mmol) of 1,3-dibromo-5-iodobenzene, 200 ml of 1,4-dioxane, and 100 ml of distilled water were added to a reactor. 5.2 g (25.3 mmol) of 2,6-diisopropylphenyl boronic acid, 1.5 g (1.3 mmol) of Pd(PPh₃)₄, and 7.8 g (45.5 mmol) of Ba(OH)₂ were added thereto, and the mixture was heated at a temperature of 80°C for 18 hours. Once the reaction was completed, the mixture was concentrated under reduced pressure, and the residue was dissolved in 200 ml of dichloromethane, and filtered through diatomite. The organic layer obtained therefrom was dried by using magnesium sulfate, distilled under reduced pressure, and purified by liquid chromatography, to obtain 8.1 g (20.5 mmol, yield of 81%) of Intermediate I-33-4.
LC-MS m/z = 394 (M+H)⁺

### 2) Synthesis of Intermediate I-33-3

6.0 g (15.1 mmol) of Intermediate I-33-4 was dissolved in 150 ml of diethyl ether. Then, at a temperature of -78°C, 6.6 ml of n-BuLi (2.5 M solution in hexane) was slowly added thereto, and the mixture was stirred for about 1 hour. Then, tri-n-butyltin chloride was slowly added dropwise thereto and the mixture was stirred for about 2 hours. The mixture was slowly then slowly warmed to room temperature and stirred for about 18 hours. Once the reaction was completed, the mixture was extracted using 80 ml of distilled water and 100 ml of ethyl acetate. The organic layer obtained therefrom was dried using magnesium sulfate and distilled under reduced pressure to obtain Intermediate I-33-3. The obtained Intermediate I-33-3 was used for the following reaction without any further purification.

### 3) Synthesis of Intermediate I-33-2

11.8 g (19.5 mmol) of Intermediate I-33-3, 4.5 g (19.5 mmol) of 2-bromo-5-(trimethylsilyl)pyridine were added to a reactor. Then, 150 ml of toluene was added thereto. Then, 1.0 g (1.0 mmol) of Pd(PPh₃)₄ and 2.3 g (40.0 mmol) of KF were added thereto, and the mixture was heated at a temperature of 120°C for 12 hours. Once the reaction was completed, the mixture was extracted using 100 ml of ethyl acetate, and a saturated NH₄Cl aqueous solution. The organic layer obtained therefrom was dried by using magnesium sulfate, and distilled under reduced pressure, and the residue was purified by liquid chromatography to obtain 6.2 g (13.3 mmol, yield of 68%) of Intermediate I-33-2.
LC-MS m/z = 466 (M+H)⁺

### 4) Synthesis of Intermediate I-33-1

Intermediate I-33-1 (yield of 65%) was synthesized in the same manner as Intermediate I-29-1 in Synthesis Example 28, except that Intermediate I-33-2 was used instead of Intermediate I-29-2. The obtained compound was confirmed by LC-MS.
LC-MS m/z = 940 (M+H)⁺

### 5) Synthesis of Compound 33

Compound 33 (yield of 30%) was synthesized in the same manner as Compound 28 in Synthesis Example 27, except that Intermediate I-33-1 was used instead of Intermediate I-28-1. The obtained compound was confirmed by LCMS and ¹H NMR.
LC-MS m/z = 1133 (M+H)⁺
¹H NMR (300 MHz, CD₂Cl₂) δ = 8.66(s, 2H), 7.75(d, 2H), 7.61 (br s, 2H), 7.45-7.39 (m, 3H), 7.32-7.24(m, 12H), 7.14-7.09(m, 7H), 6.84-6.83(m, 2H), 2.68(br s, 4H), 1.06(d, 12H), 0.94(d, 12H), 0.30(s, 18H).

### Synthesis Example 33: Synthesis of Compound 34

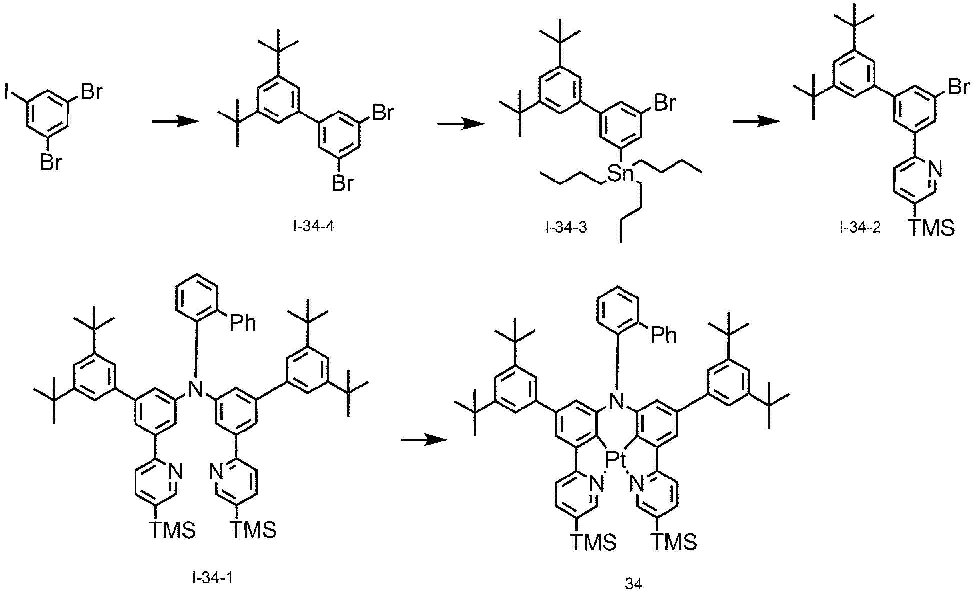

### Synthesis of Intermediate I-34-4

Intermediate I-34-4 was synthesized in the same manner as Intermediate I-33-4 in Synthesis Example 32, except that 3,5-di-tert-butylphenyl boronic acid was used instead of 2,6-diisopropylphenyl boronic acid.

### 2) Synthesis of Intermediate I-34-3

Intermediate I-34-3 was synthesized in the same manner as Intermediate I-33-3 in Synthesis Example 32, except that Intermediate I-34-4 was used instead of Intermediate I-33-4.

### 3) Synthesis of Intermediate I-34-2

Intermediate I-34-2 was synthesized in the same manner as Intermediate I-33-2 in Synthesis Example 32, except that Intermediate I-34-3 was used instead of Intermediate I-33-3.

### 4) Synthesis of Intermediate I-34-1

Intermediate I-34-1 was synthesized in the same manner as Intermediate I-29-1 in Synthesis Example 28, except that Intermediate I-34-2 was used instead of Intermediate I-29-2.

### 5) Synthesis of Compound 34

Compound 34 (yield of 25%) was synthesized in the same manner as Compound 28 in Synthesis Example 27, except that Intermediate I-34-1 was used instead of Intermediate I-28-1. The obtained compound was confirmed by LC-MS.
LC-MS m/z = 1189 (M+H)⁺

### Synthesis Example 34: Synthesis of Compound 35

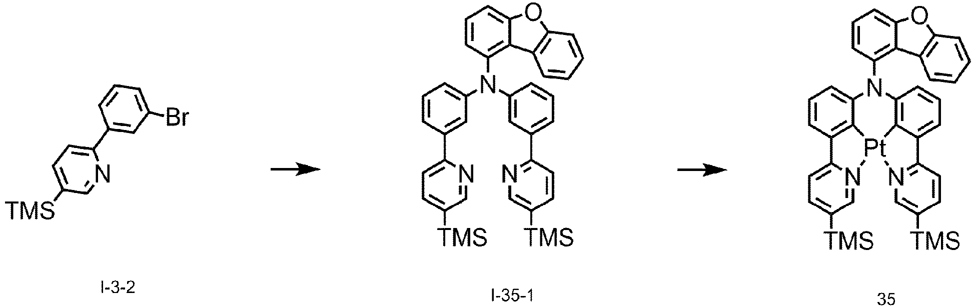

### Synthesis of Intermediate I-35-1

Intermediate I-35-1 (yield of 70%) was synthesized in the same manner as Intermediate I-8-1 in Synthesis Example 8, except that dibenzo[b,d]furan-1-amine was used instead of 3-aminobiphenyl. The obtained compound was confirmed by LC-MS.
LC-MS m/z = 634 (M+H)⁺

### 2) Synthesis of Compound 35

Compound 35 (yield of 30%) was synthesized in the same manner as Compound 8 in Synthesis Example 8, except that Intermediate I-35-1 was used instead of Intermediate I-8-1. The obtained compound was confirmed by LCMS and ¹H NMR.
LC-MS m/z = 827 (M+H)⁺
¹H NMR (300 MHz, CDCl₃) δ = 8.76(br s, 2H), 7.98(d, 1H), 7.83-7.79(m, 4H), 7.70-7.68(m, 2H), 7.56-7.50(m, 3H), 7.34-7.22 (m, 6H), 6.98 (br s, 1H), 0.28(s, 18H).

### Synthesis Example 35: Synthesis of Compound 36

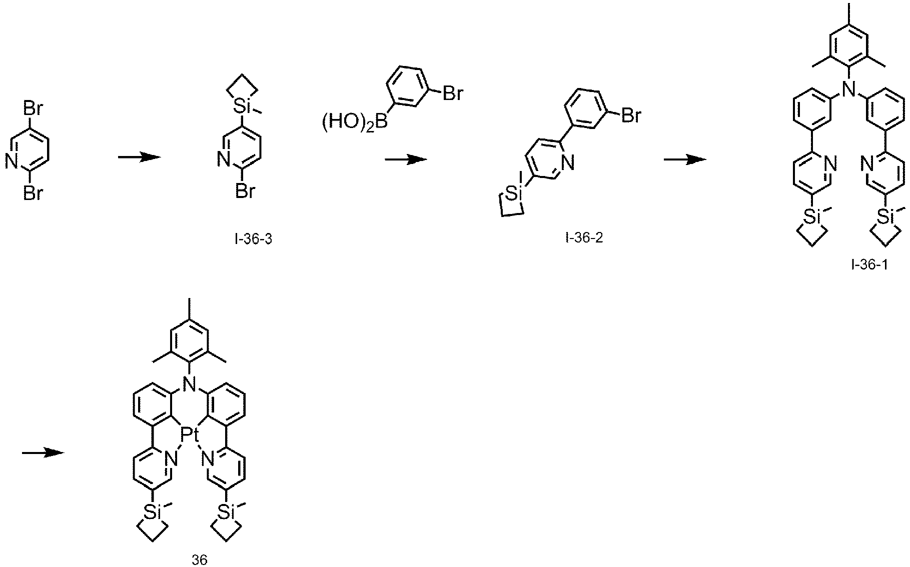

### Synthesis of Intermediate I-36-3

Intermediate I-36-3 (yield of 70%) was synthesized in the same manner as Intermediate I-2-3 in Synthesis Example 3, except that 1-chloro-1-methylsiletane was used instead of chlorotrimethylsilane. The obtained compound was confirmed by LC-MS.
LC-MS m/z = 242 (M+H)⁺

### 2) Synthesis of Intermediate I-36-2

Intermediate I-36-2 (yield of 80%) was synthesized in the same manner as Intermediate I-2-2 in Synthesis Example 3, except that Intermediate I-36-3 was used instead of Intermediate I-2-3. The obtained compound was confirmed by LC-MS.
LC-MS m/z = 318 (M+H)⁺

### 3) Synthesis of Intermediate I-36-1

Intermediate I-36-1 (yield of 62%) was synthesized in the same manner as Intermediate I-2-1 in Synthesis Example 3, except that Intermediate I-36-2 was used instead of Intermediate I-2-2. The obtained compound was confirmed by LC-MS.
LC-MS m/z = 610 (M+H)⁺

### 4) Synthesis of Compound 36

Compound 36 (yield of 25%) was synthesized in the same manner as Compound 3 in Synthesis Example 1, except that Intermediate I-36-1 was used instead of Intermediate I-3-1. The obtained compound was confirmed by LCMS and 1H NMR.
LC-MS m/z = 803 (M+H)+

### Synthesis Example 36: Synthesis of Compound 37

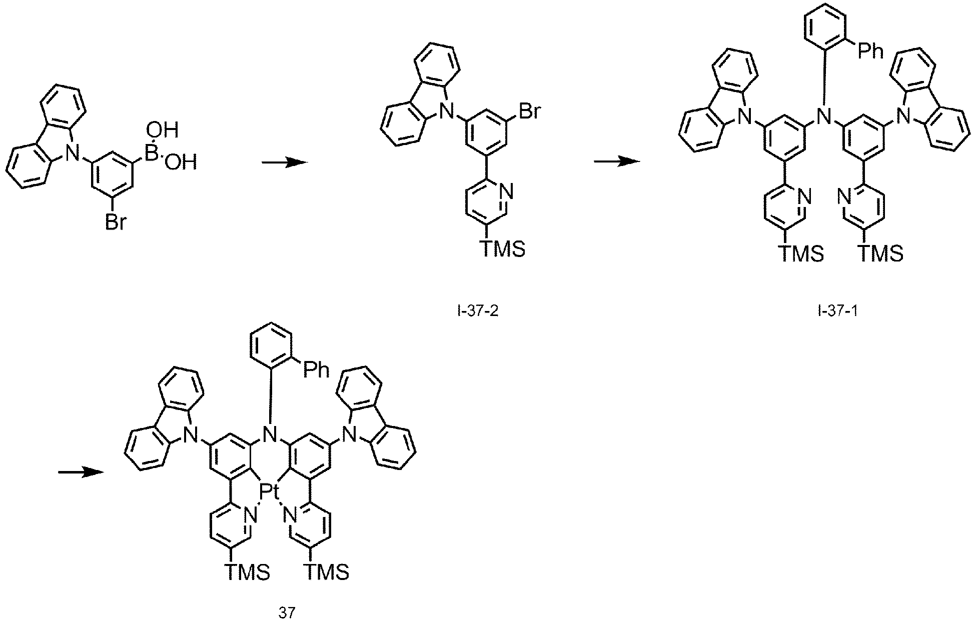

### 1) Synthesis of Intermediate I-37-2

Intermediate I-37-2 (yield of 75%) was synthesized in the same manner as Intermediate I-2-2 in Synthesis Example 3, except that (3-bromo-5-(9H-carbazole-9-yl)phenyl)boronic acid was used instead of Intermediate I-2-3. The obtained compound was confirmed by LC-MS.
LC-MS m/z = 471 (M+H)⁺

### 2) Synthesis of Intermediate I-37-1

Intermediate I-37-1 (yield of 55%) was synthesized in the same manner as Intermediate I-2-1 in Synthesis Example 3, except that Intermediate I-37-2 was used instead of Intermediate I-2-2. The obtained compound was confirmed by LC-MS.
LC-MS m/z = 950 (M+H)⁺

### 3) Synthesis of Compound 37

Compound 37 (yield of 20%) was synthesized in the same manner as Compound 3 in Synthesis Example 1, except that Intermediate I-37-1 was used instead of Intermediate I-2-1. The obtained compound was confirmed by LCMS and ¹H NMR.
LC-MS m/z = 1143 (M+H)⁺

### Example 1

An ITO/Ag/ITO (7nm/100nm/7nm (70Å/1,000Å/70Å)) substrate (anode) was cut to a size of 50 mm x 50 mm x 0.5 mm (mm = millimeter), sonicated by using iso-propyl alcohol and distilled water, each for 5 minutes, washed by exposure to ultraviolet rays for 30 minutes, and then to ozone. The resultant substrate was mounted on a deposition apparatus.

2-TNATA was vacuum-deposited on the substrate to form a hole injection layer having a thickness of 60 nm (600 Å), and then, 4,4'-bis[N-(1-naphthyl)-N-phenylamino]biphenyl (NPB) was vacuum-deposited on the hole injection layer to form a hole transport layer having a thickness of 100 nm (1,000 Å).

CBP(host) and Compound 17(dopant) were co-deposited at a weight ratio of 91:9 on the hole transport layer to form an emission layer having a thickness of 25 nm (250 Å).

BCP was vacuum-deposited on the emission layer to form a hole blocking layer having a thickness of 5 nm (50 Å). Alq₃ was deposited on the hole blocking layer to form an electron transport layer having a thickness of 35 nm (350 Å), and LiF was deposited on the electron transport layer to form an electron injection layer having a thickness of 1 nm (10 Å).

Mg and Ag were co-deposited at a weight ratio of 90:10 on the electron injection layer to form a cathode having a thickness of 12 nm (120 Å), thereby completing manufacture of an organic light-emitting device.

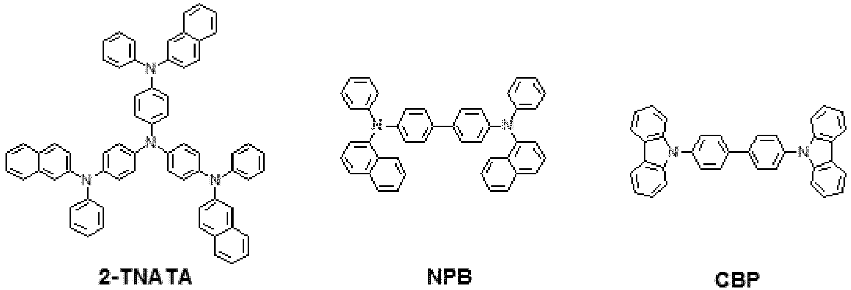

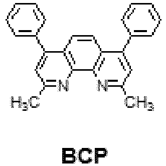

### Example 2

An organic light-emitting device was manufactured in the same manner as in Example 1, except that, in forming the emission layer, Compound 24 was used instead of Compound 17.

### Example 3

An organic light-emitting device was manufactured in the same manner as in Example 1, except that, in forming the emission layer, Compound 25 was used instead of Compound 17.

### Example 4

An ITO/Ag/ITO(7nm/100nm/7nm (70Å/1,000Å/70Å)) substrate (anode) was cut to a size of 50 mm x 50 mm x 0.5 mm, sonicated by using iso-propyl alcohol and distilled water, each for 5 minutes, washed by exposure to ultraviolet rays for 30 minutes, and then to ozone. The resultant substrate was mounted on a deposition apparatus.

2-TNATA was vacuum-deposited on the substrate to form a hole injection layer having a thickness of 60 nm (600 Å), 4,4'-bis[N-(1-naphthyl)-N-phenylamino]biphenyl (NPB) was vacuum-deposited on the hole injection layer to form a hole transport layer having a thickness of 135 nm (1,350 Å).

CBP(host) and Compound 3 (dopant) were co-deposited at a weight ratio of 94:6 on the hole transport layer to form an emission layer having a thickness of 40 nm (400 Å).

BCP was vacuum-deposited on the emission layer to form a hole blocking layer having a thickness of 5 nm (50 Å). Alq₃ was deposited on the hole blocking layer to form an electron transport layer having a thickness of 35 nm (350 Å), and LiF was deposited on the electron transport layer to form an electron injection layer having a thickness of 1 nm (10 Å).

Mg and Ag were co-deposited at a weight ratio of 90:10 on the electron injection layer to form a cathode having a thickness of 12 nm (120 Å), thereby completing manufacture of an organic light-emitting device.

### Example 5

An organic light-emitting device was manufactured in the same manner as in Example 4, except that, in forming the emission layer, Compound 7 was used instead of Compound 3.

### Example 6

An organic light-emitting device was manufactured in the same manner as in Example 4, except that, in forming the emission layer, Compound 11 was used instead of Compound 3.

### Example 7

An organic light-emitting device was manufactured in the same manner as in Example 4, except that, in forming the emission layer, Compound 13 was used instead of Compound 3.

### Example 8

An organic light-emitting device was manufactured in the same manner as in Example 4, except that, in forming the emission layer, Compound 28 was used instead of Compound 3.

### Example 9

An organic light-emitting device was manufactured in the same manner as in Example 4, except that, in forming the emission layer, Compound 29 was used instead of Compound 3.

### Comparative Example 1

An organic light-emitting device was manufactured in the same manner as in Example 1, except that, in forming the emission layer, Compound A was used instead of Compound 17:

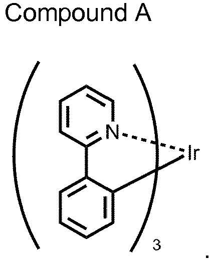

### Comparative Example 2

An organic light-emitting device was manufactured in the same manner as in Example 1, except that, in forming the emission layer, Compound B was used instead of Compound 17:

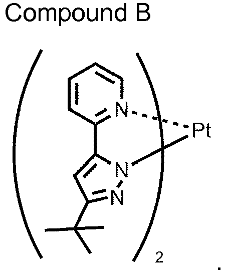

### Comparative Example 3

An organic light-emitting device was manufactured in the same manner as in Example 4, except that, in forming the emission layer, Compound C was used instead of Compound 3:

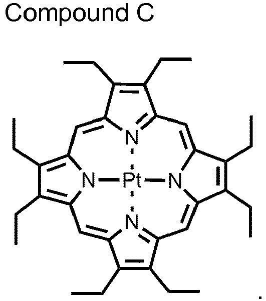

### Comparative Example 4

An organic light-emitting device was manufactured in the same manner as in Example 4, except that, in forming the emission layer, Compound D was used instead of Compound 3:

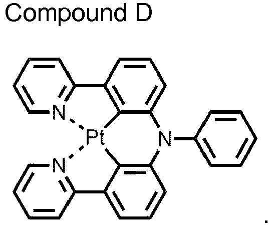

### Comparative Example 4

An organic light-emitting device was manufactured in the same manner as in Example 4, except that, in forming the emission layer, Compound E was used instead of Compound 3:

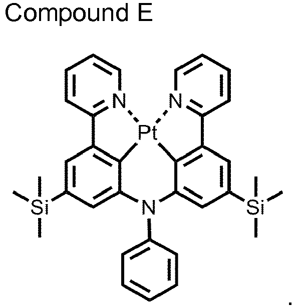

Evaluation Example 1: Evaluation on characteristics of organic light-emitting devices.

The driving voltage, current density, luminance, efficiency, emission color, CIE color coordinate, and lifespan (LT₉₇) of each of the organic light-emitting devices manufactured according to Examples 1 to 9 and Comparative Examples 1 to 5 were evaluated. Evaluation results are shown in Table 1. LT₉₇ refers to a lifetime, and LT₉₇ indicates a period of time that elapses until the luminance is reduced to 97% of the initial luminance:

**Table 1**

| | Dopant | Driving voltage (V) | Current density (mA/cm²) | Luminance (cd/m²) | Efficiency (cd/A) | Emission color | CIE color coordinate (x, y) | LT₉₇ (hr) |
|---|---|---|---|---|---|---|---|---|
| Example 1 | Compound 17 | 5.6 | 10 | 5,540 | 55.4 | Green | 0.27, 0.72 | 90 |
| Example 2 | Compound 24 | 5.6 | 10 | 5,864 | 58.6 | Green | 0.24, 0.70 | 95 |
| Example 3 | Compound 25 | 5.5 | 10 | 6,296 | 62.9 | Green | 0.26, 0.71 | 98 |
| Example 4 | Compound 3 | 5.5 | 10 | 3,010 | 30.1 | Red | 0.66, 0.34 | 1600 |
| Example 5 | Compound 7 | 5.3 | 10 | 3,227 | 32.3 | Red | 0.65, 0.35 | 1800 |
| Example 6 | Compound 11 | 5.5 | 10 | 3,570 | 35.7 | Red | 0.64,0.32 | 1200 |
| Example 7 | Compound 13 | 5.6 | 10 | 3,387 | 33.8 | Red | 0.63, 0.34 | 1000 |
| Example 8 | Compound 28 | 5.3 | 10 | 3,608 | 36.1 | Red | 0.64, 0.34 | 1000 |
| Example 9 | Compound 29 | 5.3 | 10 | 3,485 | 34.9 | Red | 0.65, 0.33 | 1300 |
| Comparative Example 1 | Compound A | 6.8 | 10 | 4,766 | 47.7 | Green | 0.27, 0.70 | 61 |
| Comparative Example 2 | Compound B | 6.0 | 10 | 5,237 | 52.3 | Green | 0.25, 0.73 | 82 |
| Comparative Example 3 | Compound C | 7.3 | 10 | 2,212 | 22.1 | Red | 0.67, 0.32 | 80 |
| Comparative Example 4 | Compound D | 5.7 | 10 | 2,530 | 25.3 | Red | 0.63, 0.33 | 210 |
| Comparative Example 5 | Compound E | 5.9 | 10 | 1,213 | 12.1 | Red | 0.62, 0.32 | 375 |

Referring to Table 1, the driving voltage of each of the organic light-emitting devices of Examples 1 to 3 is about 0.5 to 1.2 volts (V) lower than that of each of the organic light-emitting devices of Comparative Examples 1 and 2. In addition, the organic light-emitting devices of Examples 1 to 3 have higher efficiency and a longer lifespan and better I-V-L characteristics than those of Comparative Examples 1 and 2. In addition, the organic light-emitting devices of Examples 1 to 3 have a higher level of luminance than the organic light-emitting devices of Comparative Examples 1 to 2.

The organic light-emitting devices of Examples 4 to 9 have higher efficiency and longer lifespan and better I-V-L characteristics than those of Comparative Examples 3 to 5. In addition, the organic light-emitting devices of Examples 4 to 9 have a higher level of luminance and a longer lifespan than those of Comparative Examples 3 to 5.

In detail, as in Example 1, when the organometallic compound represented by one of Formulae 1-1 to 1-3 was used as a green phosphorescent dopant, compared to Comparative Example 1, the driving voltage was increased by 1.2 V or more, the efficiency was increased to 110%, and the lifespan was increased to 150%. In the case of Example 3, compared to Comparative Example 2, the driving voltage was improved by 0.5 V or more, the efficiency was increased to 120%, and the lifespan was increased to 120%.

As in Examples 4 to 9, when the organometallic compound represented by one of Formulae 1-1 to 1-3 was used as a red phosphorescent dopant, compared to Comparative Example 3, the driving voltage was increased by about 2.0 V, the efficiency was increased to 140%, and the lifespan was increased to 1,000% or more.

The organometallic compounds according to embodiments have excellent electric characteristics and thermal stability. Accordingly, an organic light-emitting device including the organometallic compound may have excellent driving voltage, current density, efficiency, power, color purity, and lifespan characteristics.

## Claims

1. An organometallic compound represented by by one of Formulae 1-1 to 1-3: 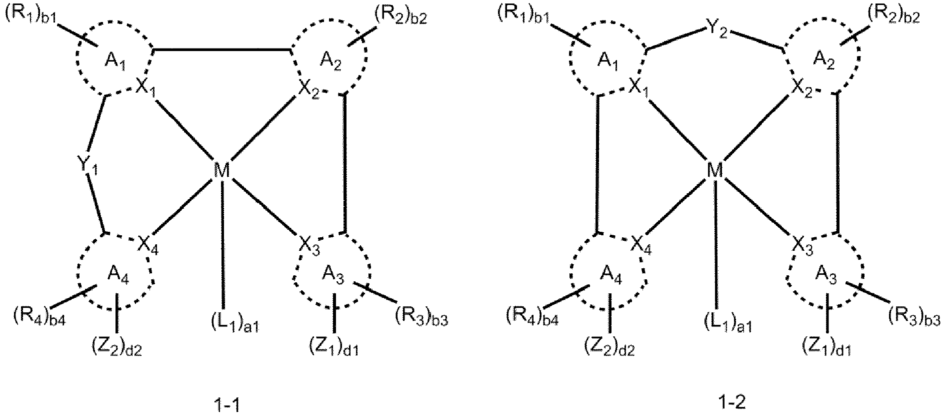 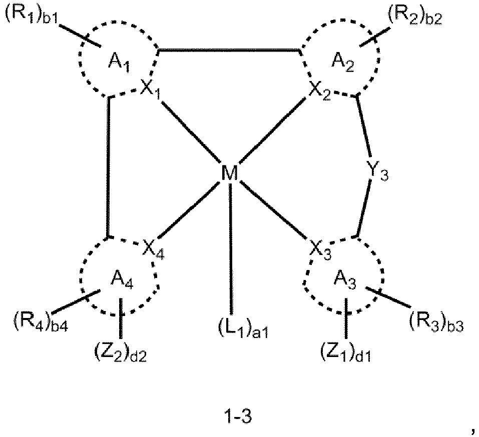 wherein, in Formulae 1-1 to 1-3,
Y₁ to Y₃ are each independently a divalent linking group;
M is selected from a Period 1 transition metal, a Period 2 transition metal, and a Period 3 transition metal, preferably selected from iridium (Ir), platinum (Pt), osmium (Os), ruthenium (Ru), rhodium (Rh), palladium (Pd), copper (Cu), silver (Ag), gold (Au), titanium (Ti), zirconium (Zr), hafnium (Hf), europium (Eu), terbium (Tb), and thulium (Tm) and more preferably selected from Ir, Pt, and Os;
A₁ to A₄ are each independently selected from a benzene group, a naphthalene group, a pyridine group, a pyrimidine group, a pyrazine group, a quinoline group, an isoquinoline group, a dibenzofuran group, and a dibenzothiophene group; and
at least one selected from A₃ and A₄ is selected from a pyridine group, a pyrimidine group, a pyrazine group, a quinoline group, and an isoquinoline group.
X₁ to X₄ are each independently selected from a carbon atom (C) and a nitrogen atom (N), provided that at least one selected from X₃ and X₄ is N;
Z₁ and Z₂ are each independently represented by one of Formulae 2-21 to 2-34: 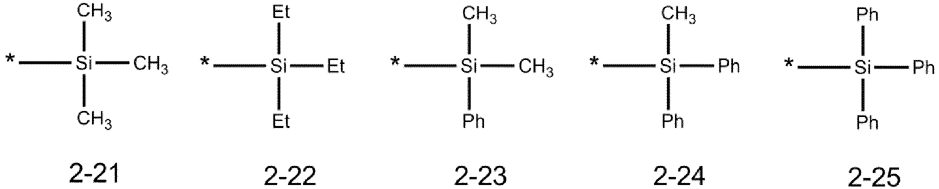 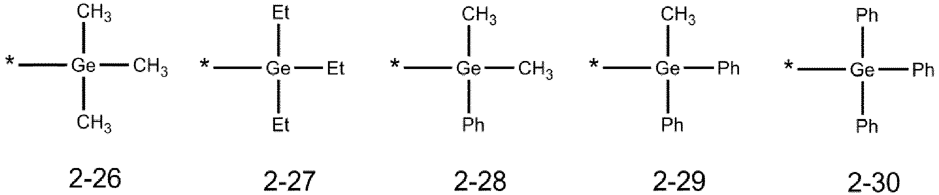 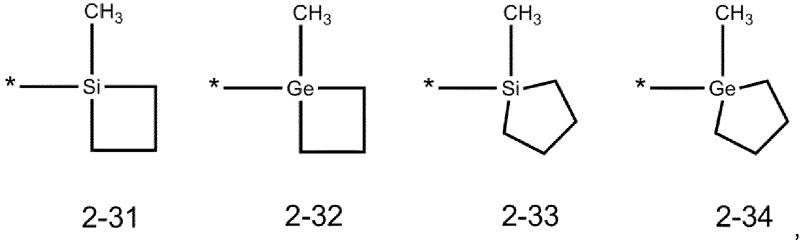
wherein, in Formulae 2-21 to 2-34,
Et refers to an ethyl group;
Ph refers to a phenyl group; and
* indicates a binding site to a neighboring atom;
d1 and d2 are each independently selected from 0, 1, 2, 3, and 4;
when d1 is 2 or more, groups Z₁ are identical to or different from each other; when d2 is 2 or more, groups Z₂ are identical to or different from each other;
when X₃ is N, d1 is selected from 1, 2, 3, and 4; or when X₄ is N, d2 is selected from 1, 2, 3, and 4;
R₁ to R₄ are each independently selected from hydrogen, deuterium, a methyl group, an ethyl group, an n-propyl group, an iso-propyl group, an n-butyl group, an isobutyl group, a sec-butyl group, a tert-butyl group, an n-pentyl group, an iso-pentyl group, a sec-pentyl group, and a tert-pentyl group;
a phenyl group and a carbazolyl group; and
a phenyl group, a naphthyl group, and a carbazolyl group, each substituted with at least one selected from a C₁-C₂₀ alkyl group and a phenyl group;
b1 to b4 are each independently selected from 1, 2, 3, and 4;
L₁ is selected from a monodentate ligand and a bidentate ligand;
a1 is selected from 0, 1, and 2; and
* indicates a binding site to a neighboring atom.

2. The organometallic compound of claim 1 wherein
the divalent linking group is represented by one selected from *-O-*', *-S-*' and one of Formulae 9-1 to 9-70: 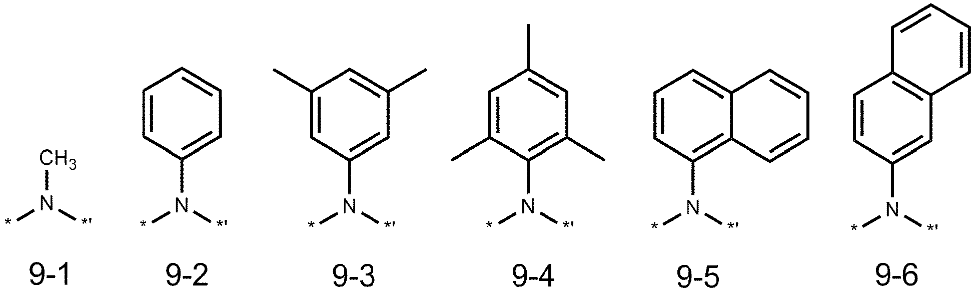 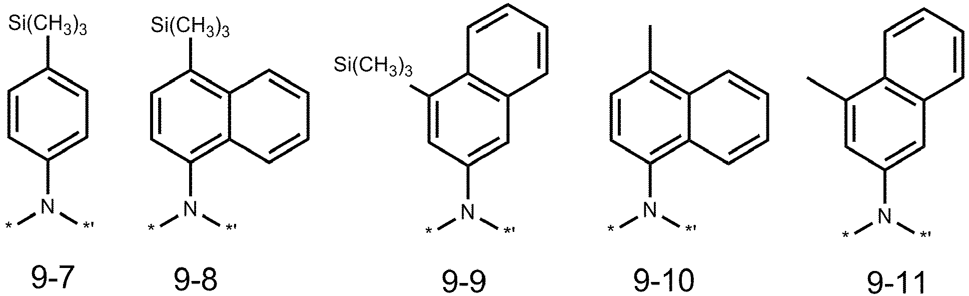 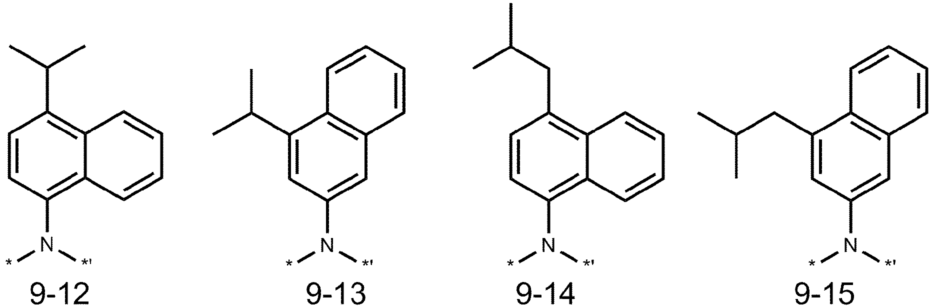 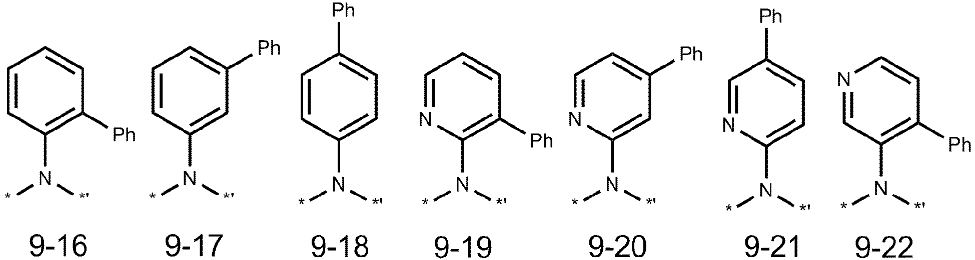 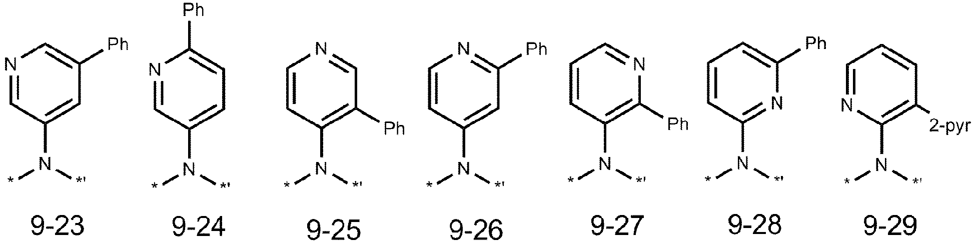 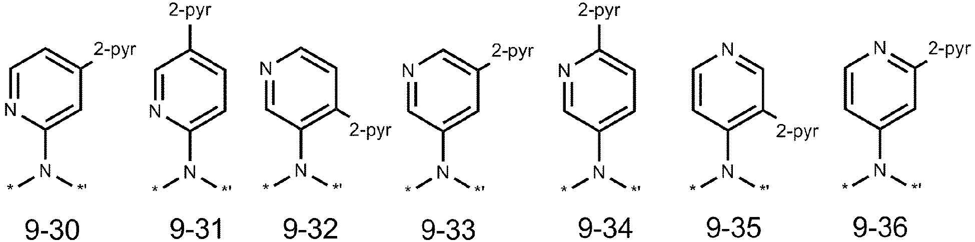 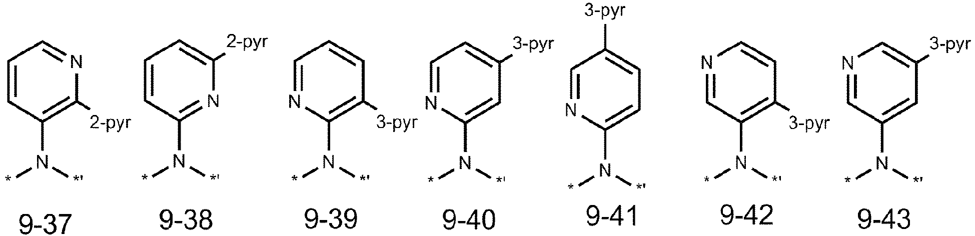 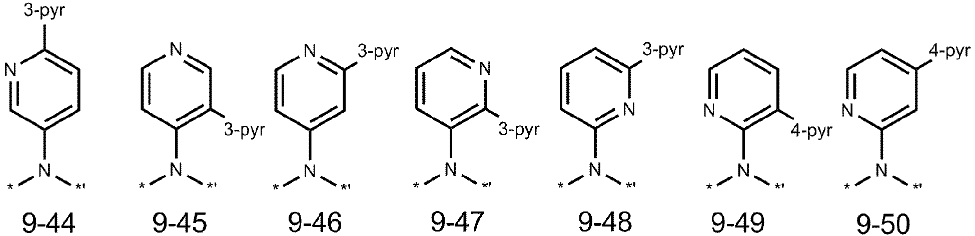 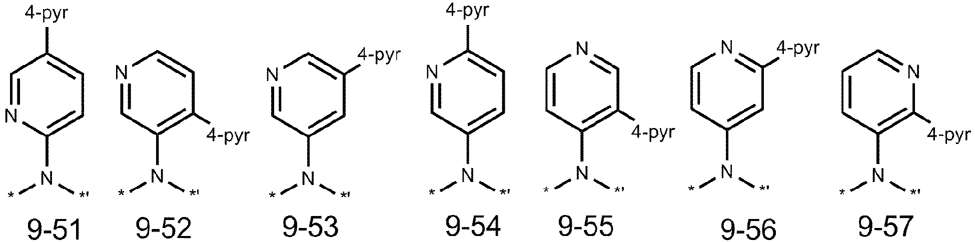 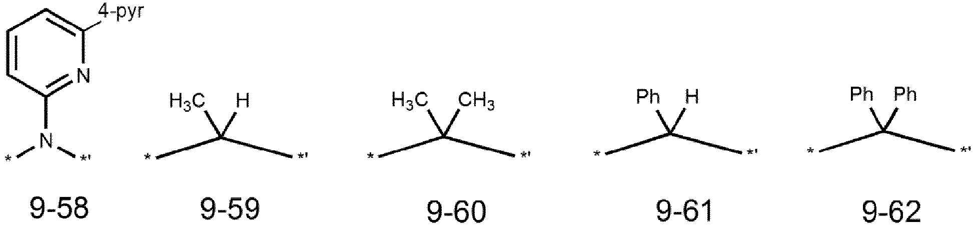 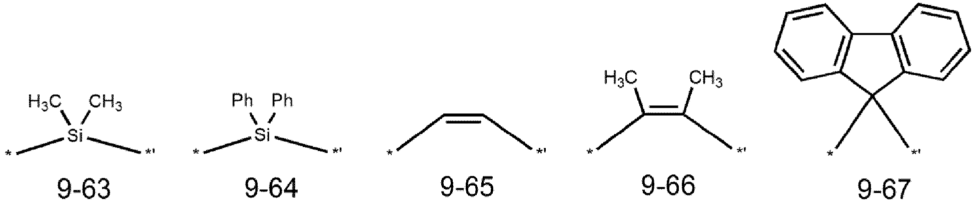 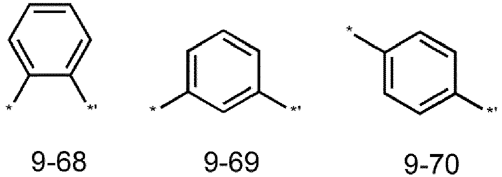 wherein, in Formulae 9-1 to 9-70,
Ph refers to a phenyl group;
2-pyr refers to a 2-pyridinyl group, 3-pyr refers to a 3-pyridinyl group, and 4-pyr refers to a 4-pyridinyl group; and
* and *' each independently indicate a binding site to a neighboring atom.

3. The organometallic compound of any of claims 1 to 2, wherein
d1 and d2 are each independently selected from 0, 1, and 2; and
at least one selected from d1 and d2 is selected from 1 and 2.

4. The organometallic compound of claim 1, wherein
the organometallic compound represented by by one of Formulae 1-1 to 1-3 is selected from Compounds 1 to 18 and 20 to 37: 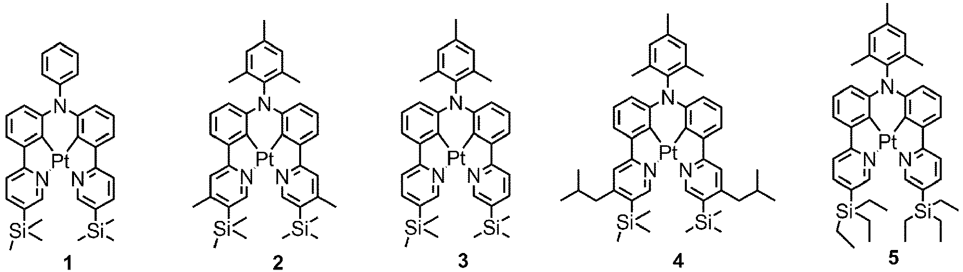 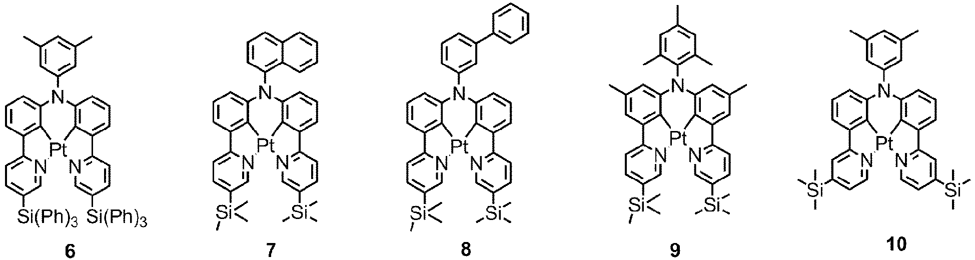 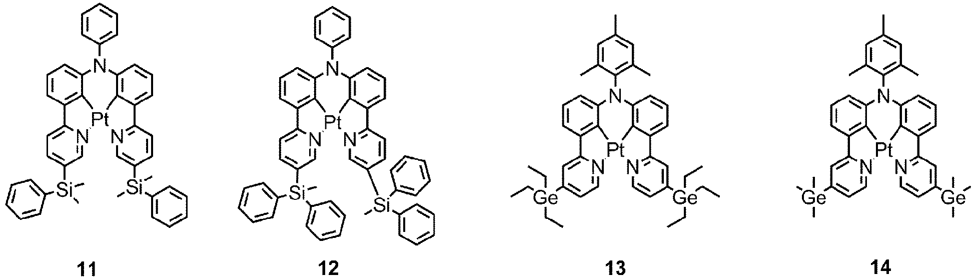 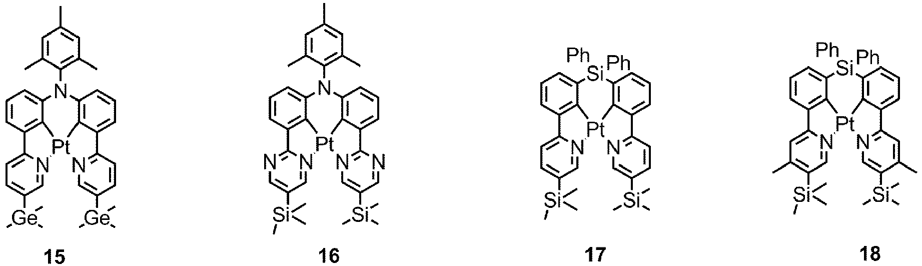 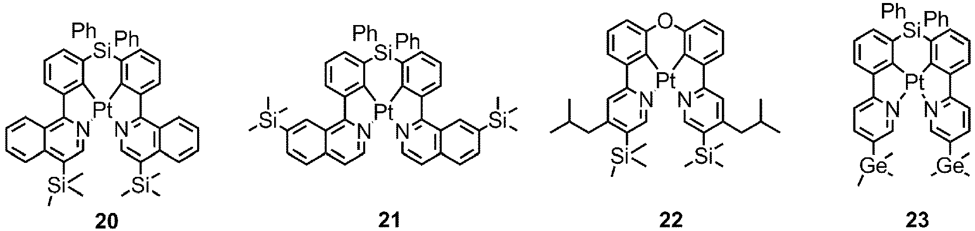 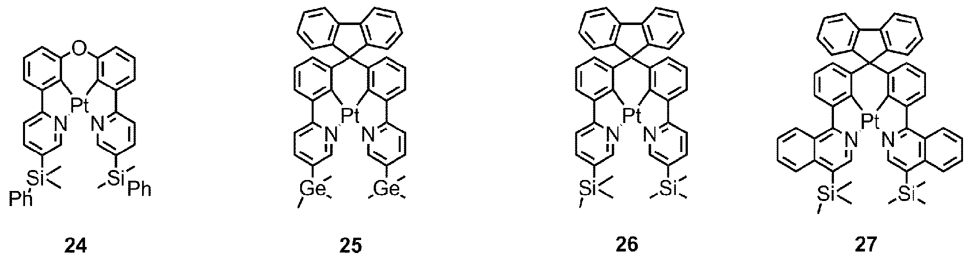 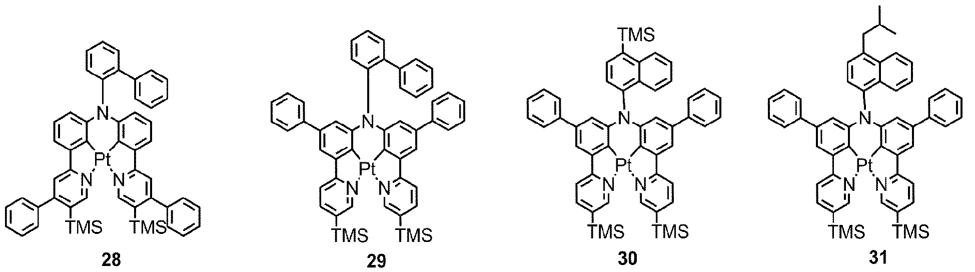 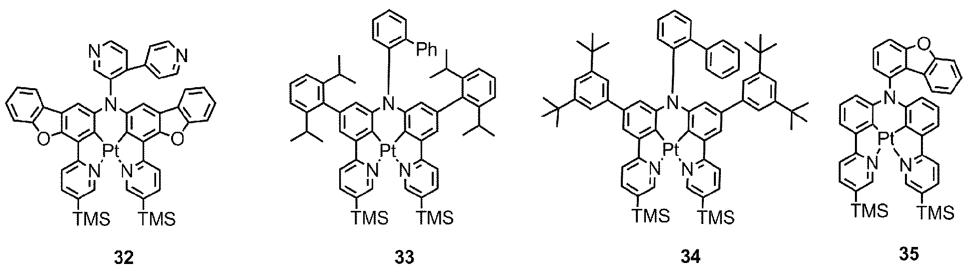 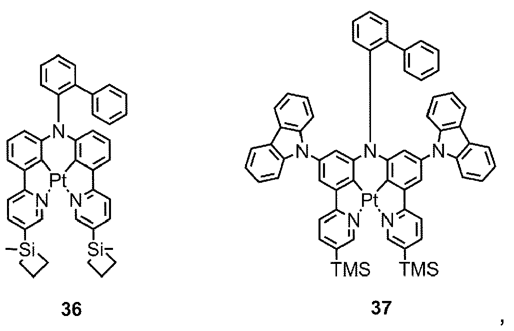
wherein, in Compounds 1 to 18 and 20 to 37,
TMS refers to a trimethylsilyl group.

5. An organic light-emitting device comprising
a first electrode;
a second electrode; and
an organic layer disposed between the first electrode and the second electrode,
wherein the organic layer comprises an emission layer and at least one organometallic compound of any of claims 1 to 4.

6. The organic light-emitting device of claim 5, wherein
the emission layer comprises the organometallic compound.

## Patentansprüche

1. Organometallverbindung, dargestellt durch eine der Formeln 1-1 bis 1-3: 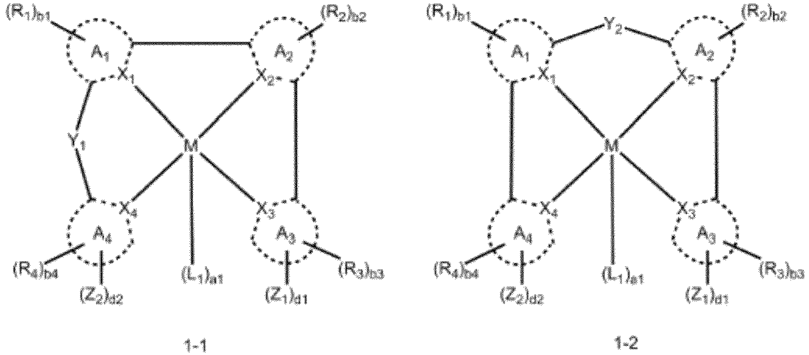 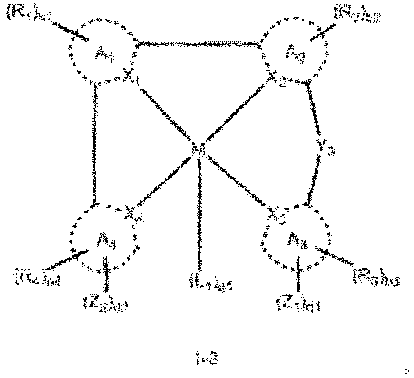 wobei in den Formeln 1-1 bis 1-3
Y₁ bis Y₃ jeweils unabhängig eine zweiwertige Verbindungsgruppe sind;
M aus einem Übergangsmetall der ersten Periode, einem Übergangsmetall von zweiten Periode und einem Übergangsmetall der dritten Periode ausgewählt ist, vorzugsweise aus Iridium (Ir), Platin (Pt), Osmium (Os), Ruthenium (Ru), Rhodium (Rh), Palladium (Pd), Kupfer (Cu), Silber (Ag), Gold (Au), Titan (Ti), Zirkonium (Zr), Hafnium (Hf), Europium (Eu), Terbium (Tb) und Thulium (Tm) ausgewählt ist und besonders bevorzugt aus Ir, Pt und Os ausgewählt ist;
A₁ bis A₄ jeweils unabhängig aus einer Benzolgruppe, einer Naphthalingruppe, einer Pyridingruppe, einer Pyrimidingruppe, einer Pyrazingruppe, einer Chinolingruppe, einer Isochinolingruppe, einer Dibenzofurangruppe und einer Dibenzothiophengruppe ausgewählt sind;
und mindestens eines, ausgewählt aus A₃ und A₄, aus einer Pyridingruppe, einer Pyrimidingruppe, einer Pyrazingruppe, einer Chinolingruppe und einer Isochinolingruppe ausgewählt ist,
X₁ bis X₄ jeweils unabhängig aus einem Kohlenstoffatom (C) und einem Stickstoffatom (N) ausgewählt sind, mit der Maßgabe, dass mindestens eines, ausgewählt aus X₃ und X₄, N ist;
Z₁ und Z₂ jeweils unabhängig durch eine der Formeln 2-21 bis 2-34 dargestellt sind: 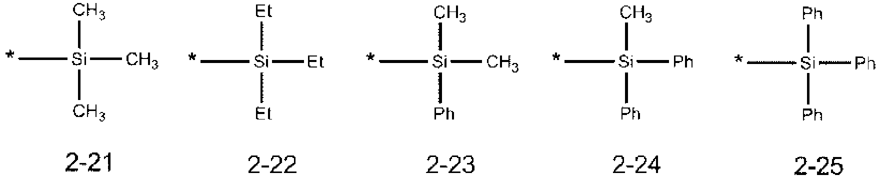 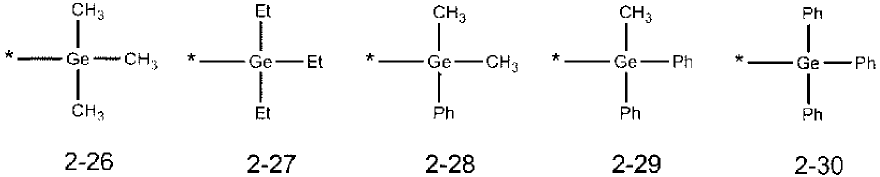 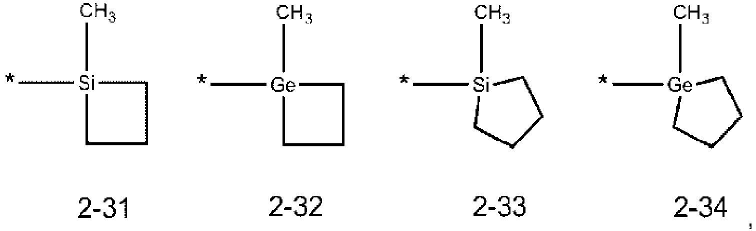
wobei in den Formeln 2-21 bis 2-34
Et sich auf eine Ethylgruppe bezieht;
Ph sich auf eine Phenylgruppe bezieht; und
* eine Bindungsstelle an ein benachbartes Atom angibt;
d1 und d2 jeweils unabhängig aus 0, 1, 2, 3 und 4 ausgewählt sind;
wenn d1 2 oder größer ist, die Gruppen Z₁ miteinander identisch oder voneinander verschieden sind; wenn d2 2 oder größer ist, die Gruppen Z₂ miteinander identisch oder voneinander verschieden sind;
wenn X₃ N ist, d1 aus 1, 2, 3 und 4 ausgewählt ist; oder wenn X₄ N ist, d2 aus 1, 2, 3 und 4 ausgewählt ist;
R₁ bis R₄ jeweils unabhängig aus Wasserstoff, Deuterium, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, eine Isopentylgruppe, eine sec-Pentylgruppe und eine tert-Pentylgruppe ausgewählt sind;
eine Phenylgruppe und eine Carbazolylgruppe;
und eine Phenylgruppe, eine Naphthylgruppe und eine Carbazolylgruppe, die jeweils mit mindestens einer aus einer C₁- bis C₂₀-Alkylgruppe und einer Phenylgruppe ausgewählten Gruppe substituiert sind;
b1 bis b4 jeweils unabhängig aus 1, 2, 3 und 4 ausgewählt sind;
L₁ aus einem monodentaten Liganden und einem bidentaten Liganden ausgewählt ist;
a1 aus 0, 1 und 2 ausgewählt ist; und
* eine Bindungsstelle an ein benachbartes Atom angibt.

2. Organometallverbindung nach Anspruch 1, wobei die zweiwertige Verbindungsgruppe durch eines, ausgewählt aus *-O-*', *-S-*' und einer der Formeln 9-1 bis 9-70 dargestellt ist: 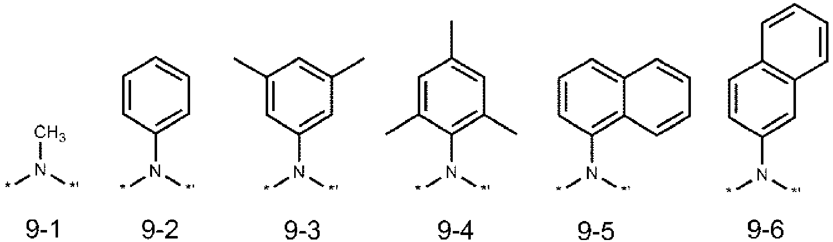 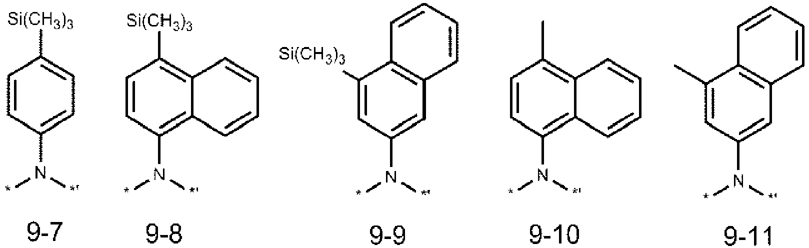 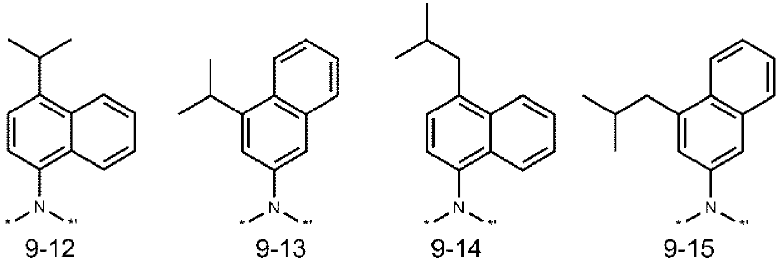 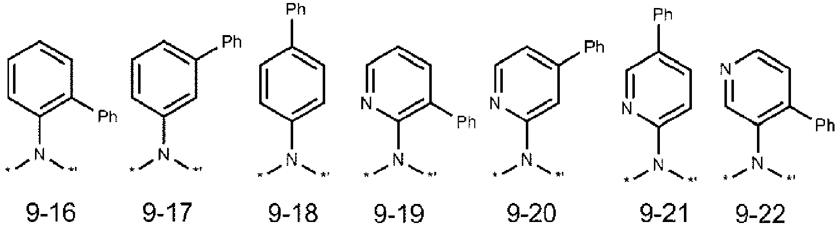 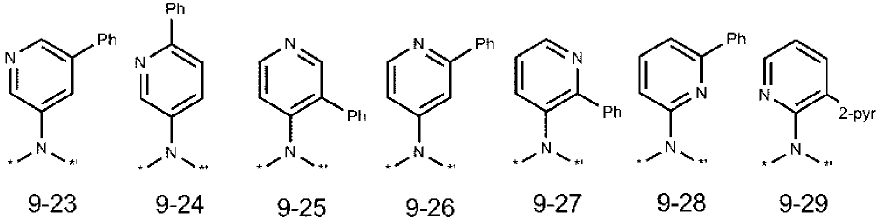 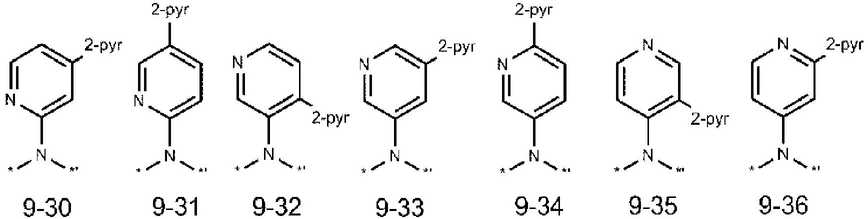 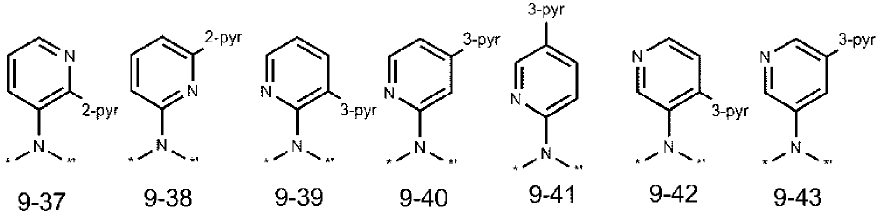 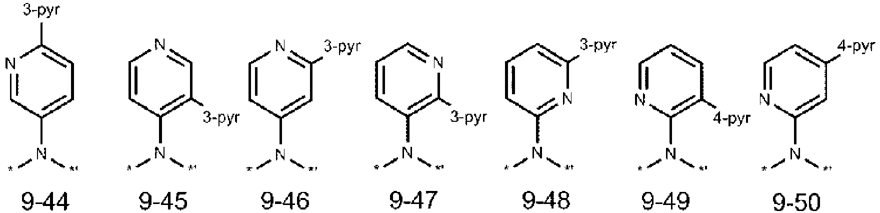 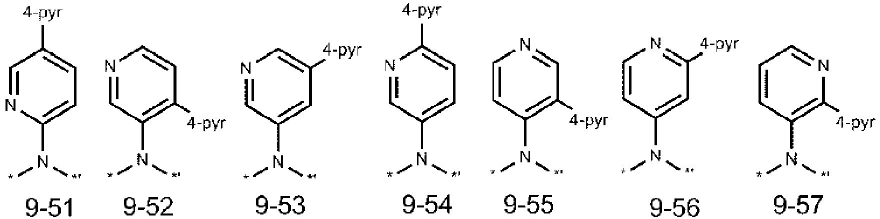 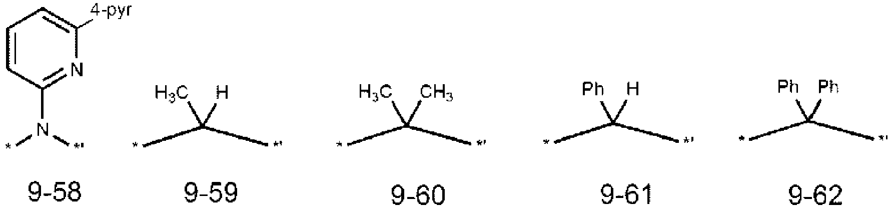 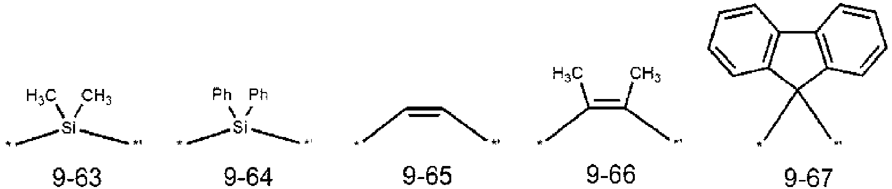 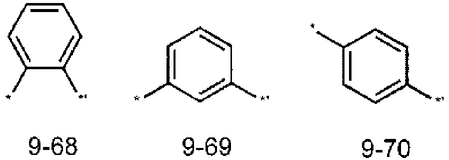 wobei in den Formeln 9-1 bis 9-70
Ph sich auf eine Phenylgruppe bezieht;
2-Pyr sich auf eine 2-Pyridinylgruppe bezieht, 3-Pyr sich auf eine 3-Pyridinylgruppe bezieht und 4-Pyr sich auf eine 4-Pyridinylgruppe bezieht; und
* und *' unabhängig eine Bindungsstelle an ein benachbartes Atom angeben.

3. Organometallverbindung nach einem der Ansprüche 1 bis 2, wobei d1 und d2 jeweils unabhängig aus 0, 1 und 2 ausgewählt sind;
und mindestens eines, ausgewählt aus d1 und d2, aus 1 und 2 ausgewählt ist.

4. Organometallverbindung nach Anspruch 1, wobei die durch eine der Formeln 1-1 bis 1-3 dargestellte Organometallverbindung aus den Verbindungen 1 bis 18 und 20 bis 37 ausgewählt ist: 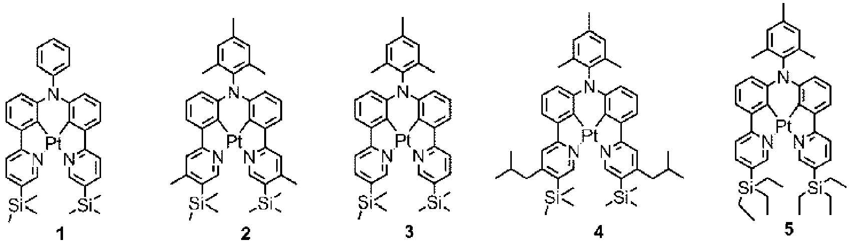 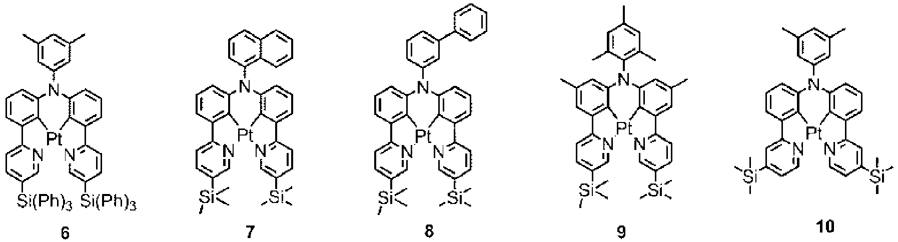 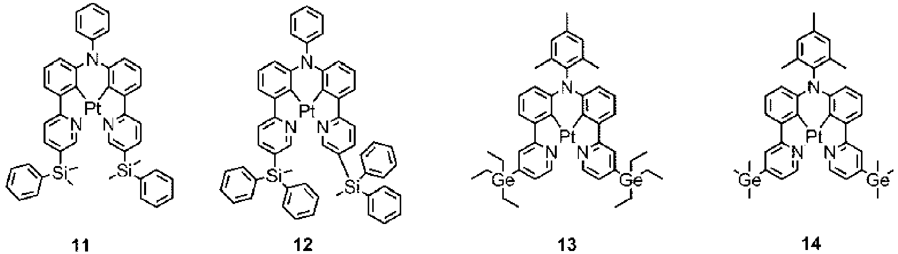 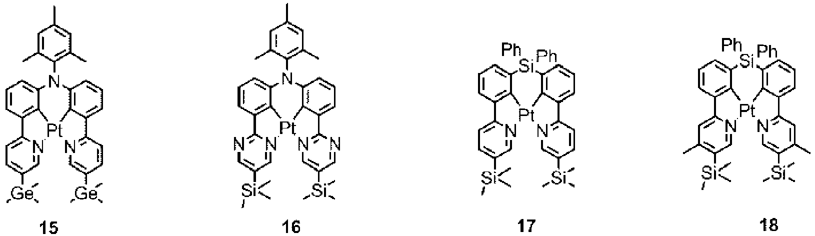 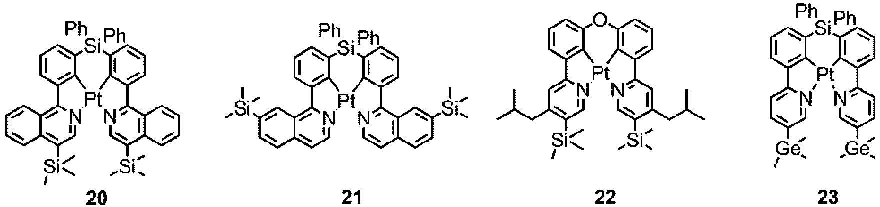 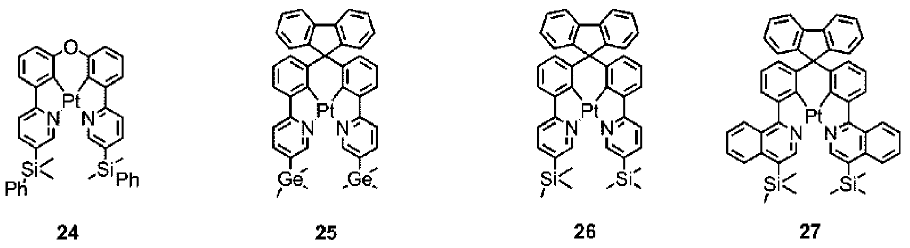 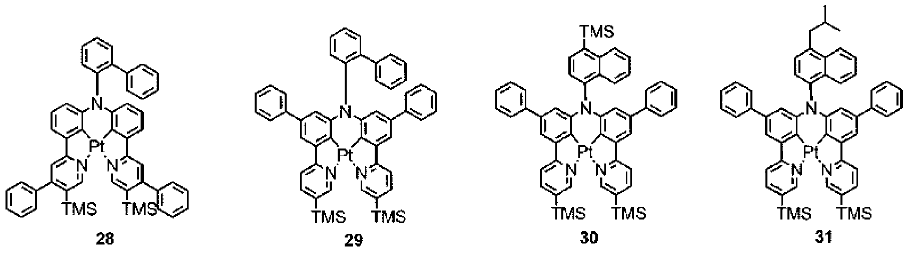 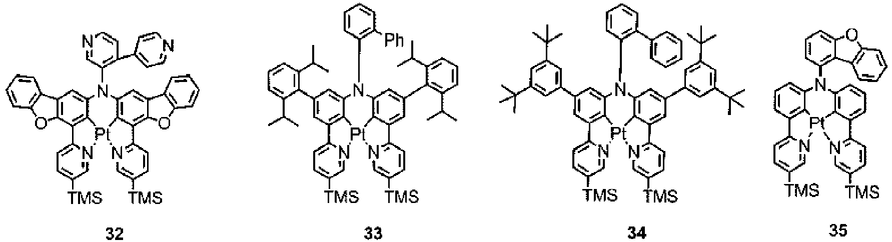 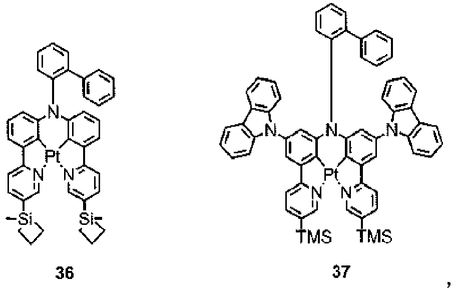 wobei sich in den Verbindungen 1 bis 18 und 20 bis 37 TMS auf eine Trimethylsilylgruppe bezieht.

5. Organische lichtemittierende Vorrichtung, umfassend
eine erste Elektrode;
eine zweite Elektrode;
und eine organische Schicht, die zwischen der ersten Elektrode und der zweiten Elektrode angeordnet ist, wobei die organische Schicht eine Emissionsschicht und mindestens eine Organometallverbindung nach einem der Ansprüche 1 bis 4 umfasst.

6. Organische lichtemittierende Vorrichtung nach Anspruch 5, wobei die Emissionsschicht die Organometallverbindung umfasst.

## Revendications

1. Composé organométallique représenté par l'une des formules 1-1 à 1-3 : 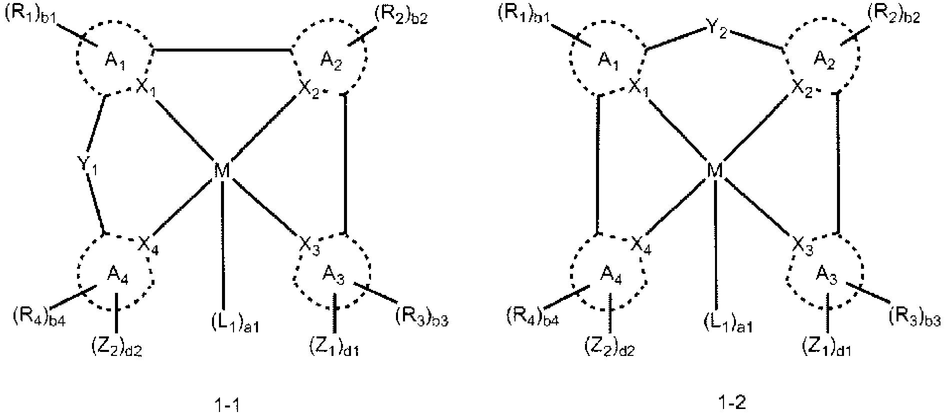 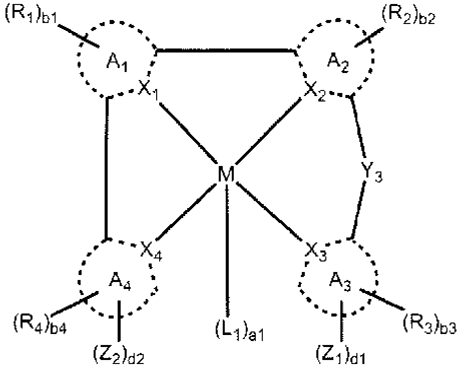 dans lequel, dans les formules 1-1 à 1-3,
Y₁ à Y₃ sont chacun indépendamment un groupe de liaison divalent ;
M est sélectionné parmi un métal de transition du groupe 1, un métal de transition du groupe 2 et un métal de transition du groupe 3, sélectionné de préférence parmi l'iridium (Ir), le platine (Pt), l'osmium (Os), le ruthénium (Ru), le rhodium (Rh), le palladium (Pd), le cuivre (Cu), l'argent (Ag), l'or (Au), le titane (Ti), le zirconium (Zr), le hafnium (Hf), l'europium (Eu), le terbium (Tb) et le thulium (Tm) et plus préférablement sélectionné parmi l'Ir, le Pt et l'Os ;
A₁ à A₄ sont chacun indépendamment sélectionnés parmi un groupe benzène, un groupe naphtalène, un groupe pyridine, un groupe pyrimidine, un groupe pyrazine, un groupe quinoléine, un groupe isoquinoléine, un groupe dibenzofuranne et un groupe dibenzothiophène ;
et au moins un sélectionné de A₃ et de A₄ est sélectionné parmi un groupe pyridine, un groupe pyrimidine, un groupe pyrazine, un groupe quinoléine et un groupe isoquinoléine,
X₁ à X₄ sont chacun indépendamment sélectionnés parmi un atome de carbone (C) et un atome d'azote (N), à condition qu'au moins un sélectionné de X₃ et de X₄ est un atome N ;
Z₁ et Z₂ sont chacun indépendamment représentés par l'une des formules 2-21 à 2-34 : 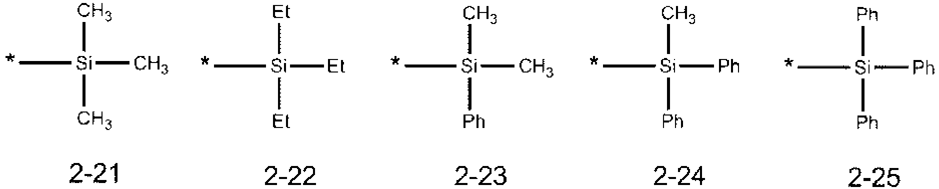 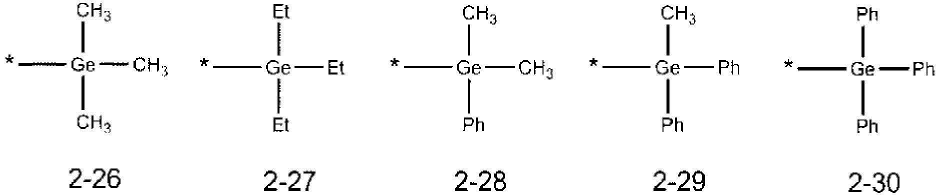 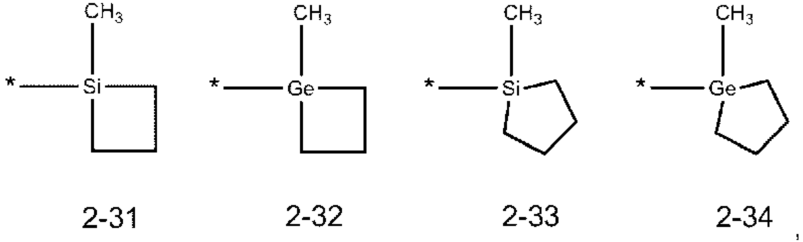
dans lequel, dans les formules 2-21 à 2-34,
Et fait référence à un groupe éthyle ;
Ph fait référence à un groupe phényle ; et
* indique un site de liaison à un atome voisin ;
d1 et d2 sont chacun indépendamment sélectionnés parmi 0, 1, 2, 3 et 4 ;
quand d1 vaut 2 ou plus, les groupes Z₁ sont identiques ou différents l'un de l'autre ; quand d2 vaut 2 ou plus, les groupes Z₂ sont identiques ou différents l'un de l'autre ;
quand X₃ est un atome N, d1 est sélectionné parmi 1, 2, 3 et 4 ; ou quand X₄ est un atome N, d2 est sélectionné parmi 1, 2, 3 et 4 ;
R₁ à R₄ sont chacun indépendamment sélectionnés parmi un atome d'hydrogène, un deutérium, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle et un groupe tert-pentyle ;
un groupe phényle et un groupe carbazolyle ;
et un groupe phényle, un groupe naphtyle et un groupe carbazolyle, chacun substitué par au moins un sélectionné parmi un groupe alkyle de C₁ à C₂₀ et un groupe phényle ;
b1 à b4 sont chacun indépendamment sélectionnés parmi 1, 2, 3 et 4 ;
L₁ est sélectionné parmi un ligand monodentate et un ligand bidentate ;
a1 est sélectionné parmi 0, 1 et 2 ; et
* indique un site de liaison à un atome voisin.

2. Composé organométallique selon la revendication 1, dans lequel le groupe de liaison divalent est représenté par un sélectionné parmi *-O-*', *-S-*' et l'une des formules 9-1 à 9-70 : 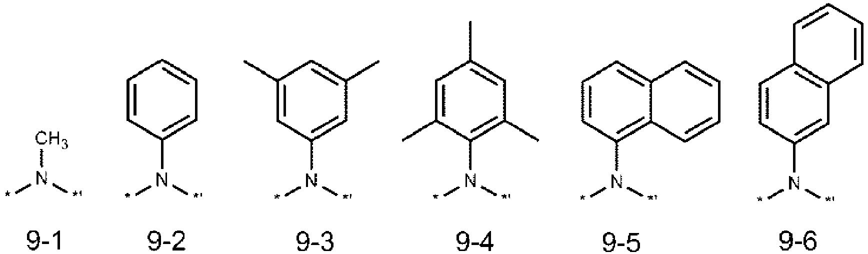 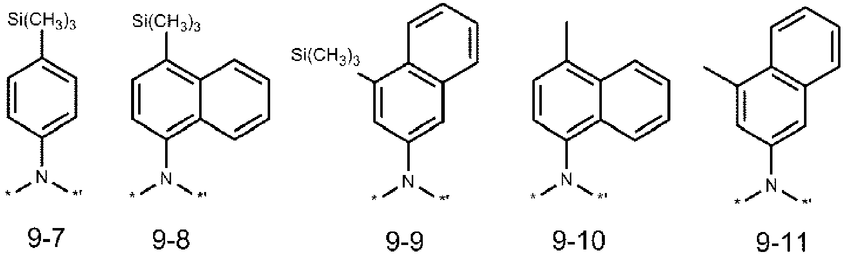 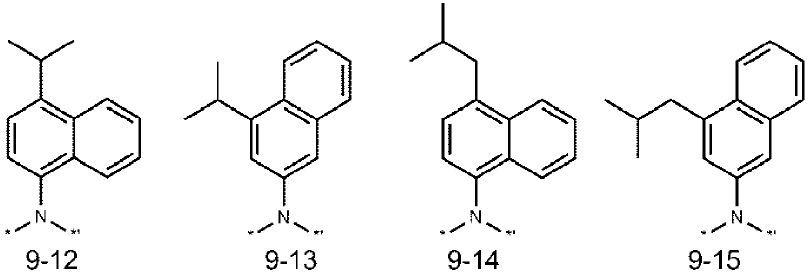 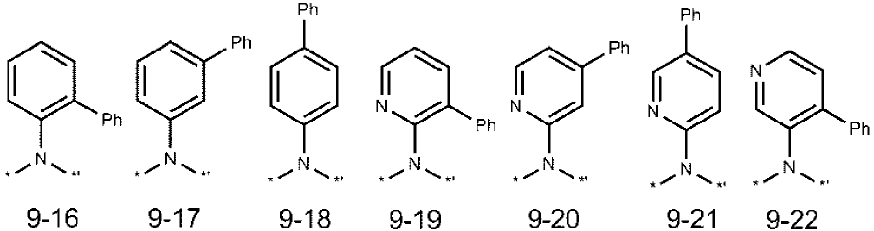 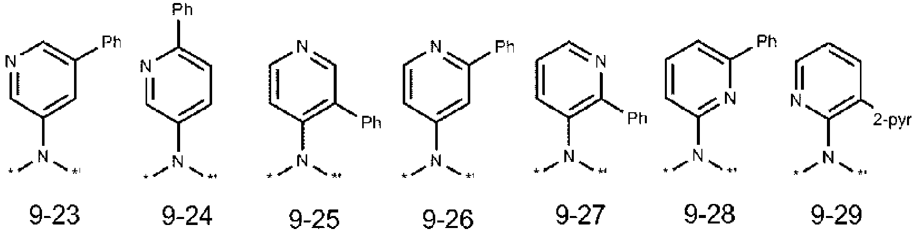 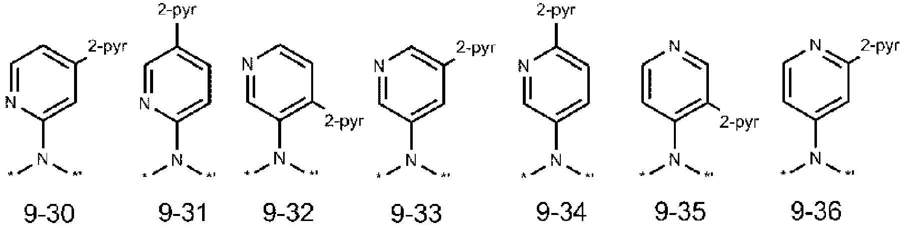 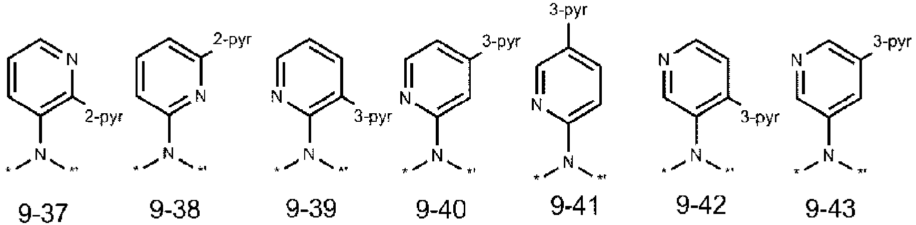 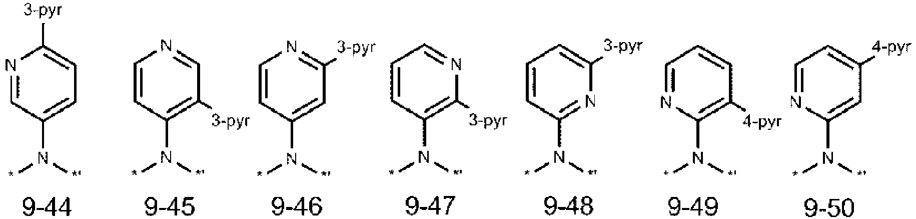 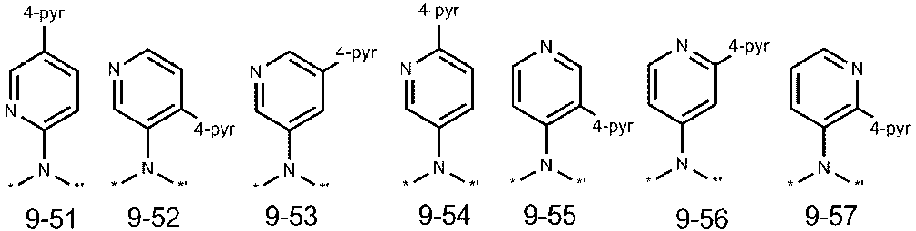 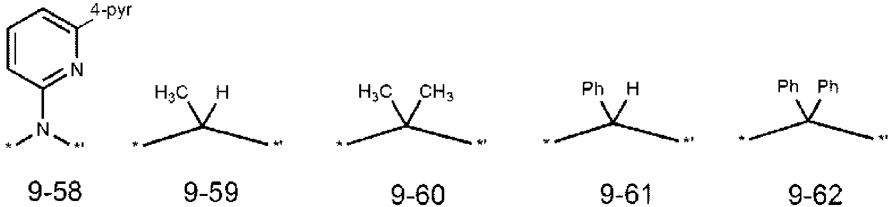 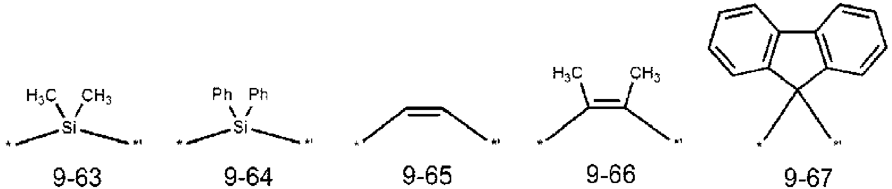 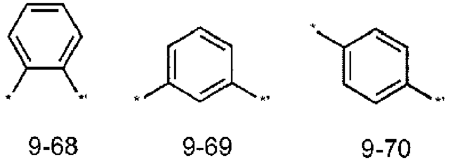 dans lequel, dans les formules 9-1 à 9-70,
Ph fait référence à un groupe phényle ;
2-pyr fait référence à un groupe 2-pyridinyle, 3-pyr fait référence à un groupe 3-pyridinyle et 4-pyr fait référence à un groupe 4-pyridinyle ; et
* et *' indiquent chacun indépendamment un site de liaison à un atome voisin.

3. Composé organométallique selon l'une quelconque des revendications 1 et 2, dans lequel d1 et d2 sont chacun indépendamment sélectionnés parmi 0, 1 et 2 ;
et au moins un sélectionné de d1 et d2 est sélectionné parmi 1 et 2.

4. Composé organométallique selon la revendication 1, dans lequel le composé organométallique représenté par l'une des formules 1-1 à 1-3 est sélectionné parmi les composés 1 à 18 et 20 à 37 : 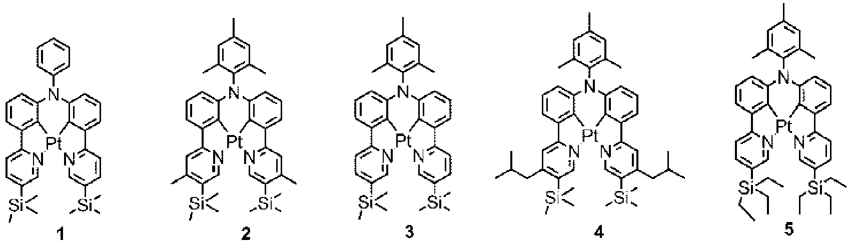 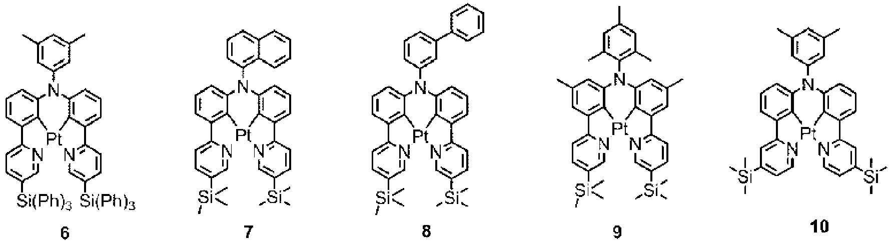 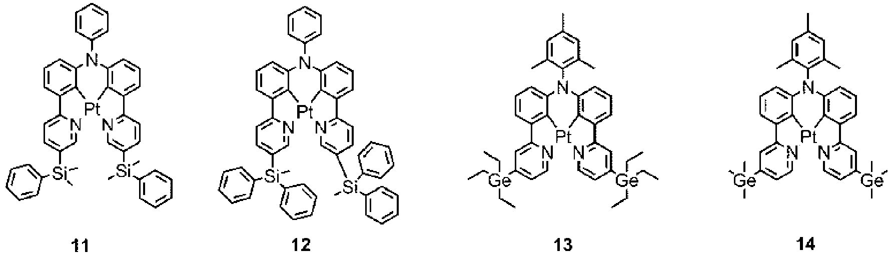 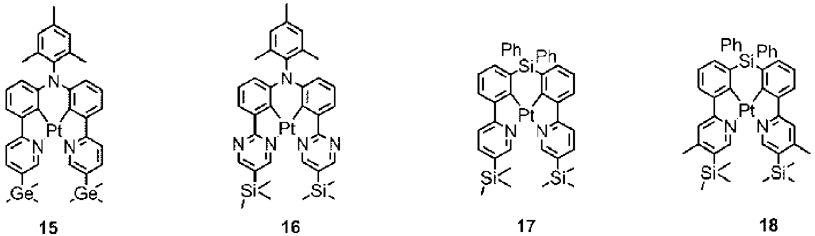 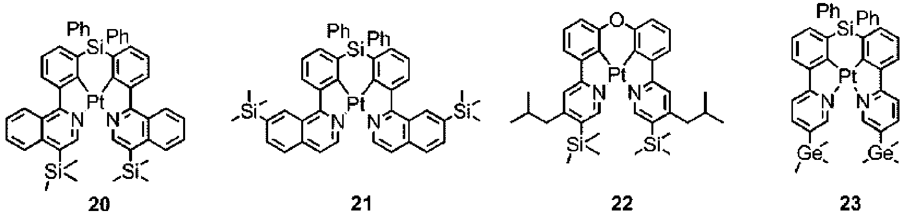 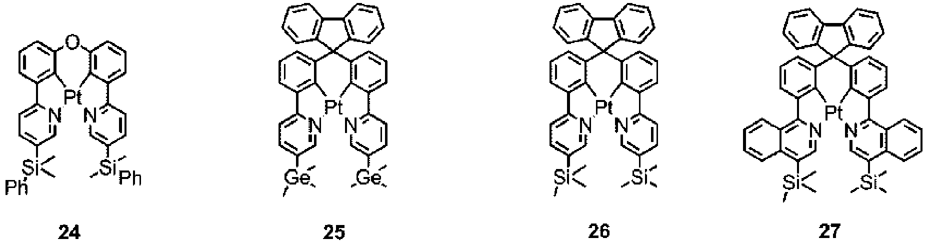 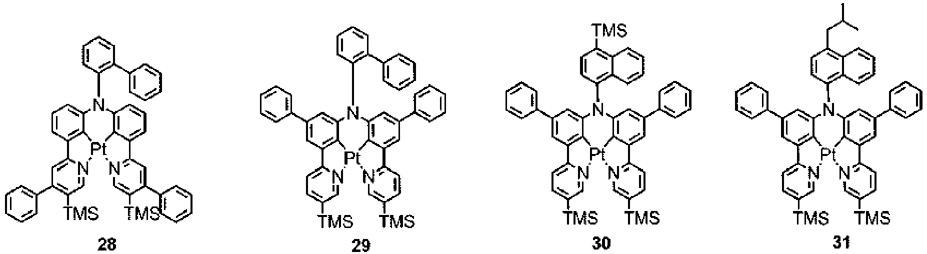 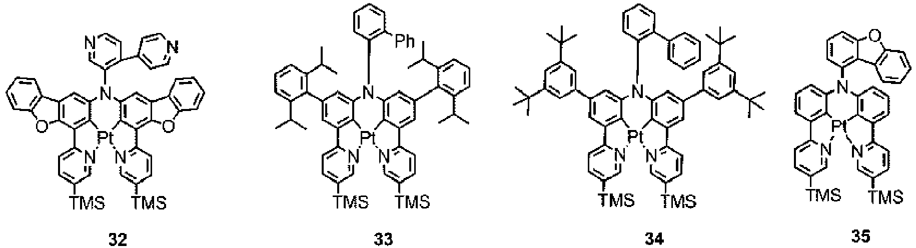 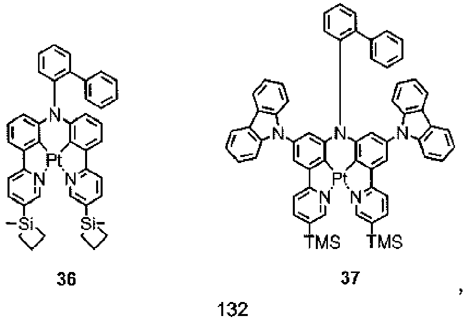 dans lequel, dans les composés 1 à 18 et 20 à 37, TMS fait référence à un groupe triméthylsilyle.

5. Dispositif électroluminescent organique comprenant une première électrode ; une seconde électrode ;
et une couche organique placée entre la première électrode et la seconde électrode, dans lequel la couche organique comprend une couche d'émission et au moins un composé organométallique selon l'une quelconque des revendications 1 à 4.

6. Dispositif électroluminescent organique selon la revendication 5, dans lequel la couche d'émission comprend le composé organométallique.
